(19) Europäisches Patentamt European Patent Office Office européen des brevets

(11) **EP 4 199 396 A1**

(12) **EUROPEAN PATENT APPLICATION**
published in accordance with Art. 153(4) EPC

(43) Date of publication:
**21.06.2023 Bulletin 2023/25**

(21) Application number: **21868427.2**

(22) Date of filing: **30.08.2021**

(51) International Patent Classification (IPC):
**H04L 1/00** (2006.01)

(52) Cooperative Patent Classification (CPC):
**H04L 1/00**

(86) International application number:
**PCT/CN2021/115206**

(87) International publication number:
**WO 2022/057599 (24.03.2022 Gazette 2022/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.09.2020 RU 2020130551**

(71) Applicant: **Huawei Technologies Co., Ltd.
Shenzhen, Guangdong 518129 (CN)**

(72) Inventors:
• **TROFIMIUK, Grigorii
  Boxitogorsk 190121 (RU)**

• **KARAKCHIEVA, Ludmila
  Petersburg 190121 (RU)**
• **TRIFONOV, Peter
  Petersburg 190121 (RU)**
• **GU, Jiaqi
  Shenzhen, Guangdong 518129 (CN)**
• **LI, Bin
  Shenzhen, Guangdong 518129 (CN)**

(74) Representative: **MERH-IP Matias Erny Reichl
Hoffmann
Patentanwälte PartG mbB
Paul-Heyse-Strasse 29
80336 München (DE)**

(54) **METHOD AND APPARATUS FOR ENCODING POLAR CODE, AND METHOD AND APPARATUS FOR DECODING POLAR CODE**

(57) This application provides a method and an apparatus for encoding a polar code, and a method and an apparatus for decoding a polar code, to reduce decoding complexity and improve a decoding speed. The encoding method includes: obtaining information bits; adjusting an original kernel matrix to construct one or more kernel matrices, and selecting an appropriate target kernel matrix from the one or more kernel matrices; and performing polar encoding on the information bits based on the target kernel matrix. According to the encoding method, when the kernel matrix is constructed or selected, performance and decoding complexity are comprehensively considered, so that decoding complexity can be reduced by selecting the appropriate kernel matrix used during encoding. The decoding method includes: obtaining a to-be-decoded sequence; and decoding the to-be-decoded sequence based on a plurality of trellises, where intermediate results obtained in different decoding stages may be reused. For example, in a $(t+i)^{th}$ stage of decoding, an intermediate result obtained in a $t^{th}$ stage of decoding is reused. According to the decoding method, decoding complexity is greatly reduced.

FIG. 13

## Description

This application claims priority to Patent Application No. 2020130551, filed with the Russian Patent Office on September 17, 2020 and entitled "METHOD AND APPARATUS FOR ENCODING POLAR CODE, AND METHOD AND APPARATUS FOR DECODING POLAR CODE", which is incorporated herein by reference in its entirety.

## TECHNICAL FIELD

This application relates to the field of channel coding, and more specifically, to a method and an apparatus for encoding a polar code, and a method and an apparatus for decoding a polar code.

## BACKGROUND

A polar code (polar code) has been strictly proved to be a channel encoding scheme that reaches a channel capacity, and has features such as high performance, low complexity, and a flexible matching manner. Currently, the polar code is determined by the 3rd Generation Partnership Project (3rd generation partnership project, 3GPP) as a control channel encoding scheme in some communication scenarios of the 5th generation (5th generation, 5G).

An original polar code is based on a kernel matrix $F_2 = \begin{pmatrix} 1 & 0 \\ 1 & 1 \end{pmatrix}$, and an n-time Kronecker index $F_2^{\otimes m}$ of the kernel matrix corresponds to a linear code whose code length is $N=2^m$. As for a high-dimensional kernel matrix, researchers have proved that a polarization speed when some well-designed high-dimensional kernel matrices are used to encode the polar code is higher, in other words, decoding performance is better. However, the high-dimensional kernel matrix causes high decoding complexity, and how to reduce decoding complexity is an urgent problem to be resolved.

This application provides a method and an apparatus for encoding a polar code, and a method and an apparatus for decoding a polar code, to reduce decoding complexity.

According to a first aspect, an encoding method is provided. The method may be performed by an encoder device, or may be performed by a chip, a chip system, or a circuit set in the encoder device. This is not limited in this application.

The method may include: obtaining information bits; determining a target kernel matrix, where the target kernel matrix is obtained by adjusting an original kernel matrix; and performing polar encoding on the information bits based on the target kernel matrix.

For example, the obtaining information bits may include internally generating information bits, or may include receiving information bits from outside.

Based on the foregoing technical solution, when the polar encoding is performed, a plurality of kernel matrices may be constructed based on the original kernel matrix, and an appropriate target kernel matrix is selected for encoding based on the constructed kernel matrices and an actual communication status. In this manner, when the kernel matrix is constructed or selected, performance and decoding complexity are comprehensively considered, so that decoding complexity can be reduced by selecting the appropriate kernel matrix used during encoding.

With reference to the first aspect, in some implementations of the first aspect, a dimension of the target kernel matrix is less than a dimension of the original kernel matrix

Based on the foregoing technical solution, a plurality of kernel matrices whose dimensions are small are constructed based on a kernel matrix whose dimension is known. Encoding is performed based on the kernel matrix whose dimension is small, so that lower decoding complexity can be provided while the same performance is ensured.

With reference to the first aspect, in some implementations of the first aspect, the target kernel matrix is obtained by adjusting a partial distance of the original kernel matrix

For example, the target kernel matrix is obtained by adjusting a partial distance profile (PDP) of the original kernel matrix

For example, when the partial distance of the original kernel matrix is adjusted, the adjustment may be performed based on partial distance close to that of an Arikan matrix

With reference to the first aspect, in some implementations of the first aspect, the target kernel matrix is obtained by adjusting the partial distance of the original kernel matrix according to a depth-first search algorithm.

With reference to the first aspect, in some implementations of the first aspect, when processing is performed according to the depth-first search algorithm, one or more of the following constraints are used for processing:

a candidate line set M meets: $M[i] = \left\{ v_0^{l-1} \in F_2^l \mid wt\left(v_0^{l-1}\right) = D_i \right\}$; or

when the $i^{th}$ line is selected from the bottom in the candidate line set M, a Hamming weight of a selected line v is greater than or equal to $D_i$; or selecting the line v from the candidate line set M and performing partial distance calculation on the line v and a constructed line, where if

$$c \in C_{\overline{K}}^{(\varphi+1)} \oplus \overline{K}[\varphi]$$

, and $wt(c)<D_\varphi$, the line v is directly discarded, and a new line from the candidate line set M is selected; or

a line that belongs to a same coset is not selected again, where

$i$ indicates a line number, $i \in [0,l\text{-}1]$, $wt(v)$ and $wt(c)$ both indicate the Hamming weight, $\overline{K}$ indicates a currently constructed kernel matrix $\overline{K}$, $\overline{K}[\varphi]$ indicates the $\varphi_{th}$ line of the kernel matrix $\overline{K}$, $D_i$ and $D_\varphi$ both indicate the partial distance; $C_{\overline{K}}^{(\varphi+1)}$ indicates a code corresponding to the kernel matrix $\overline{K}$, and $\oplus$ indicates a logical operation.

For example, the currently constructed kernel matrix $\overline{K}$ may indicate that the kernel $\overline{K}$ is being constructed, or the kernel $\overline{K}$ been constructed may indicate that the kernel $\overline{K}$ is constructed.

Based on the foregoing technical solution, a constraint condition about a candidate line and/or a selected line may be designed, so as to accelerate convergence speed, thereby further reducing calculation amount.

With reference to the first aspect, in some implementations of the first aspect, the original kernel matrix is a kernel matrix $K_{24}$ whose dimension is (24×24), and the $K_{24}$ is:

$$
\begin{array}{cccccccccccccccccccccccc}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 1 & 0 & 0 & 0 & 1 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 \\
\end{array}
$$

With reference to the first aspect, in some implementations of the first aspect, the target kernel matrix is any one of the following:

$$
K_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 1 & 0 & 0 & 0 & 1 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 0 & 1 & 0 & 0 & 0 & 0 & 0 & 1 & 0 & 1 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 1 & 1 & 0 & 0 & 0 & 0 & 0 & 0 \\
1 & 1 & 0 & 0 & 0 & 0 & 0 & 1 & 1 & 0 & 0 & 1 & 0 & 1 & 0 & 1 & 0 & 1 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 1 & 1 & 0 & 0 & 1 & 1 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 1 & 1 & 1 & 1 & 1 & 1 & 1 & 1
\end{pmatrix};
$$

or

$$
K'_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 1 & 0 & 0 & 0 & 1 & 0 & 0 & 0 & 1 & 0 & 0 & 0 & 1 & 0 & 0 & 0 \\
1 & 0 & 1 & 0 & 1 & 1 & 0 & 0 & 0 & 0 & 0 & 0 & 0 & 0 & 0 & 0 & 0 & 0 & 0 & 0 \\
0 & 0 & 0 & 0 & 1 & 1 & 0 & 0 & 1 & 0 & 1 & 0 & 1 & 0 & 1 & 0 & 0 & 0 & 0 & 0 \\
1 & 0 & 1 & 0 & 1 & 1 & 0 & 0 & 0 & 0 & 0 & 1 & 0 & 1 & 0 & 1 & 0 & 1 & 0 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix};
$$

or

$$K''_{20} = \begin{pmatrix}
1&0&0&0&0&0&0&0&0&0&0&0&0&0&0&0&0&0&0&0\\
1&0&0&0&0&0&1&0&0&0&0&0&0&0&0&0&0&0&0&0\\
1&0&0&0&0&1&0&0&0&0&0&0&0&0&0&0&0&0&0&0\\
1&0&0&1&0&0&0&0&0&0&0&0&0&0&0&0&0&0&0&0\\
1&0&1&0&0&0&0&0&0&0&0&0&0&0&0&0&0&0&0&0\\
1&1&0&0&0&0&0&0&0&0&0&0&0&0&0&0&0&0&0&0\\
1&0&0&1&0&1&0&0&0&0&0&0&1&0&0&0&0&0&0&0\\
1&1&0&0&0&1&0&0&0&0&0&0&0&0&0&1&0&0&0&0\\
0&0&0&1&0&1&1&1&0&0&0&0&0&0&0&0&0&0&0&0\\
1&1&1&0&1&0&0&0&0&0&0&0&0&0&0&0&0&0&0&0\\
1&0&1&1&1&0&0&1&0&0&1&0&0&0&0&0&0&0&0&0\\
1&1&0&1&1&0&1&0&1&0&0&0&0&0&0&0&0&0&0&0\\
1&0&1&1&0&1&0&0&1&0&0&0&1&0&0&0&1&0&1&0\\
0&1&1&0&1&1&0&0&1&0&1&0&0&0&0&0&1&1&0&0\\
1&0&1&0&1&0&1&0&1&0&1&0&1&0&1&0&0&0&0&0\\
0&0&1&1&1&1&1&1&1&0&0&0&0&0&0&0&0&0&0&0\\
1&1&0&0&1&1&0&0&1&1&0&0&1&1&0&0&0&0&0&0\\
1&1&1&1&0&0&0&0&1&1&1&1&0&0&0&0&0&0&0&0\\
1&1&1&1&1&1&1&1&0&0&0&0&0&0&0&0&1&1&1&1\\
1&1&1&1&1&1&1&1&1&1&1&1&1&1&1&1&0&0&0&0
\end{pmatrix};$$

or

$$K_{21} = \begin{pmatrix}
1&0&0&0&0&0&0&0&0&0&0&0&0&0&0&0&0&0&0&0&0&0\\
1&0&0&0&0&0&0&1&0&0&0&0&0&0&0&0&0&0&0&0&0&0\\
1&0&1&0&0&0&0&0&0&0&0&0&0&0&0&0&0&0&0&0&0&0\\
1&1&0&0&0&0&0&0&0&0&0&0&0&0&0&0&0&0&0&0&0&0\\
1&0&0&0&0&1&0&0&0&0&0&0&0&0&0&0&0&0&0&0&0&0\\
0&1&0&1&0&0&0&0&0&0&0&0&0&0&0&0&0&0&0&0&0&0\\
1&1&1&0&1&0&0&0&0&0&0&0&0&0&0&0&0&0&0&0&0&0\\
0&0&1&1&1&0&1&0&0&0&0&0&0&0&0&0&0&0&0&0&0&0\\
0&1&0&0&1&0&0&1&0&1&0&0&0&0&0&0&0&0&0&0&0&0\\
0&0&0&1&0&1&1&1&0&0&0&0&0&0&0&0&0&0&0&0&0&0\\
1&0&1&0&1&0&1&0&0&0&1&0&0&0&1&0&0&0&0&0&0&0\\
1&1&1&0&0&0&0&1&1&0&0&0&1&0&0&0&0&0&0&0&0&0\\
1&0&1&1&0&0&1&1&0&0&0&1&0&0&0&0&0&0&0&0&0&0\\
1&0&0&1&0&0&0&0&1&1&0&1&1&0&0&0&0&0&0&0&0&0\\
1&0&1&0&0&0&1&0&1&0&1&1&1&0&0&0&1&0&0&0&0&0\\
1&0&1&0&1&0&0&1&0&1&0&1&0&1&0&1&0&0&0&0&0&0\\
1&1&0&1&0&1&0&1&1&1&1&0&0&0&0&0&0&0&0&0&0&0\\
1&1&1&0&0&1&1&0&0&1&1&0&0&1&1&0&0&0&0&0&1&0\\
1&1&1&1&0&0&0&0&1&1&1&1&0&0&0&0&0&1&0&0&0&0\\
1&1&1&1&1&1&1&1&0&0&0&0&0&0&0&0&0&0&1&1&1&0\\
1&1&1&1&1&1&1&1&1&1&1&1&1&1&1&1&1&1&0&0&0&0
\end{pmatrix};$$

or

$$K'_{21}=\begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 1 & 0 & 0 & 1 & 0 & 0 & 0 & 0 & 0 & 0 & 0 & 0 & 0 & 0 & 0 & 0 & 0 \\
0 & 0 & 1 & 1 & 1 & 0 & 0 & 0 & 1 & 0 & 0 & 0 & 0 & 0 & 0 & 0 & 0 & 0 & 0 & 0 & 0 \\
0 & 0 & 1 & 0 & 0 & 1 & 1 & 1 & 0 & 0 & 0 & 0 & 0 & 0 & 0 & 0 & 0 & 0 & 0 & 0 & 0 \\
0 & 1 & 1 & 0 & 1 & 0 & 1 & 1 & 0 & 0 & 0 & 0 & 0 & 1 & 0 & 0 & 0 & 0 & 0 & 0 & 0 \\
1 & 0 & 0 & 0 & 0 & 0 & 0 & 1 & 1 & 1 & 0 & 0 & 0 & 0 & 0 & 0 & 0 & 0 & 0 & 0 & 0 \\
0 & 1 & 1 & 1 & 0 & 1 & 1 & 0 & 0 & 0 & 0 & 0 & 1 & 0 & 0 & 0 & 0 & 0 & 0 & 0 & 0 \\
0 & 1 & 0 & 0 & 0 & 1 & 1 & 1 & 0 & 1 & 0 & 0 & 0 & 1 & 0 & 0 & 0 & 0 & 0 & 0 & 0 \\
1 & 0 & 1 & 1 & 0 & 1 & 0 & 1 & 0 & 0 & 1 & 0 & 0 & 0 & 0 & 0 & 0 & 0 & 0 & 0 & 0 \\
1 & 1 & 0 & 0 & 1 & 1 & 0 & 0 & 1 & 0 & 0 & 0 & 1 & 0 & 1 & 0 & 1 & 0 & 0 & 0 & 0 \\
1 & 0 & 1 & 1 & 0 & 1 & 0 & 0 & 1 & 0 & 1 & 0 & 1 & 1 & 0 & 0 & 1 & 0 & 1 & 0 & 0 \\
0 & 0 & 0 & 0 & 0 & 1 & 1 & 0 & 1 & 1 & 0 & 0 & 1 & 1 & 1 & 1 & 0 & 0 & 0 & 0 & 0 \\
1 & 1 & 0 & 0 & 0 & 1 & 1 & 0 & 1 & 1 & 1 & 1 & 0 & 0 & 0 & 0 & 0 & 0 & 0 & 0 & 0 \\
1 & 1 & 1 & 1 & 1 & 0 & 0 & 0 & 1 & 1 & 0 & 0 & 0 & 0 & 0 & 0 & 0 & 0 & 0 & 0 & 1 \\
1 & 1 & 1 & 1 & 1 & 1 & 1 & 0 & 0 & 0 & 0 & 0 & 0 & 0 & 0 & 0 & 0 & 1 & 1 & 0 \\
1 & 1 & 1 & 1 & 1 & 1 & 1 & 1 & 1 & 1 & 1 & 1 & 1 & 1 & 1 & 1 & 1 & 0 & 0 & 0
\end{pmatrix};$$

or

$$K_{24}=\begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 1 & 0 & 0 & 0 & 1 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 1 & 0 & 0 & 1 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 1 & 0 & 1 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix};$$

or

$$K'_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 1 & 0 & 1 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix} ;$$

or

$$K''_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
0 & 1 & 1 & 1 & 0 & 0 & 1 & 0 & 1 & 0 & 0 & 0 & 1 & 0 & 0 & 0 & 1 & 0 & 1 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 0 & 1 & 1 & 0 & 1 & 0 & 1 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix} ;$$

or

$$K_{25} = \begin{pmatrix}
1&0&0&0&0&0&0&0&0&0&0&0&0&0&0&0&0&0&0&0&0&0&0&0&0\\
1&0&0&0&0&0&1&0&0&0&0&0&0&0&0&0&0&0&0&0&0&0&0&0&0\\
1&0&0&1&0&0&0&0&0&0&0&0&0&0&0&0&0&0&0&0&0&0&0&0&0\\
1&1&0&0&0&0&0&0&0&0&0&0&0&0&0&0&0&0&0&0&0&0&0&0&0\\
0&1&0&0&0&1&0&0&0&0&0&0&0&0&0&0&0&0&0&0&0&0&0&0&0\\
0&1&1&0&0&0&0&0&0&0&0&0&0&0&0&0&0&0&0&0&0&0&0&0&0\\
0&0&1&0&1&0&0&1&0&0&0&0&1&0&0&0&0&0&0&0&0&0&0&0&0\\
1&0&1&0&1&0&0&0&0&0&1&0&0&0&0&0&0&0&0&0&0&0&0&0&0\\
0&0&0&1&1&0&0&0&0&0&0&1&1&0&0&0&0&0&0&0&0&0&0&0&0\\
1&1&0&0&0&1&1&0&0&0&0&0&0&0&0&0&0&0&0&0&0&0&0&0&0\\
1&1&1&1&0&0&0&0&0&0&0&0&0&0&0&0&0&0&0&0&0&0&0&0&0\\
0&1&0&1&0&0&1&0&0&0&0&1&0&0&1&1&0&0&0&0&0&0&0&0&0\\
0&0&0&0&0&1&1&1&0&0&0&1&0&1&0&0&1&0&0&0&0&0&0&0&0\\
1&0&0&0&1&1&1&1&0&1&0&0&0&0&0&0&0&0&0&0&0&0&0&0&0\\
1&1&1&0&1&0&0&1&1&0&0&0&0&0&0&0&0&0&0&0&0&0&0&0&0\\
0&1&0&1&0&0&1&1&0&1&0&1&0&0&0&1&0&0&0&0&1&0&0&0&0\\
0&0&1&0&1&1&0&1&1&1&0&0&1&0&1&0&0&0&0&1&0&0&0&0&0\\
1&1&1&1&1&1&0&0&0&1&0&0&0&0&0&0&0&0&0&0&0&0&0&0&0\\
1&1&0&0&1&0&1&0&1&1&0&1&1&0&0&0&1&0&0&0&0&0&0&0&0\\
1&0&1&1&0&1&1&1&1&0&1&0&0&0&0&0&1&0&0&0&0&0&0&0&0\\
1&1&0&1&0&1&0&1&0&1&0&1&0&1&0&1&0&0&0&1&0&1&0&1&0\\
1&1&1&0&0&1&1&0&0&1&1&0&0&1&1&0&0&0&1&0&0&1&1&0&0\\
1&1&1&1&0&0&0&0&1&1&1&0&0&0&0&1&1&1&0&0&0&0&0&0&0\\
1&1&1&1&1&1&1&1&0&0&0&0&0&0&0&0&0&1&1&1&1&1&1&1&0\\
1&1&1&1&1&1&1&1&1&1&1&0&0&0&0&0&0&0&1&1&1&1&1&1&1
\end{pmatrix}$$

or

$$K'_{25} = \begin{pmatrix}
1&0&0&0&0&0&0&0&0&0&0&0&0&0&0&0&0&0&0&0&0&0&0&0&0\\
1&0&0&1&0&0&0&0&0&0&0&0&0&0&0&0&0&0&0&0&0&0&0&0&0\\
1&1&0&0&0&0&0&0&0&0&0&0&0&0&0&0&0&0&0&0&0&0&0&0&0\\
1&0&1&0&0&0&0&0&0&0&0&0&0&0&0&0&0&0&0&0&0&0&0&0&0\\
1&0&0&0&0&0&0&1&0&0&0&0&0&0&0&0&0&0&0&0&0&0&0&0&0\\
1&0&0&0&0&0&0&0&0&1&0&0&0&0&0&0&0&0&0&0&0&0&0&0&0\\
0&0&1&0&1&0&0&0&1&1&0&0&0&0&0&0&0&0&0&0&0&0&0&0&0\\
1&1&0&0&0&0&0&1&0&0&0&0&0&0&1&0&0&0&0&0&0&0&0&0&0\\
1&0&1&0&0&0&0&1&0&0&1&0&0&0&0&0&0&0&0&0&0&0&0&0&0\\
1&0&0&0&0&0&0&1&0&1&0&0&0&0&0&0&0&0&0&0&1&0&0&0&0\\
0&1&1&0&1&0&1&0&0&0&0&0&0&0&0&0&0&0&0&0&0&0&0&0&0\\
1&1&0&0&1&1&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0\\
0&0&0&1&1&1&1&0&1&0&1&0&0&0&0&1&0&0&0&0&0&0&0&0&1\\
0&1&1&0&1&1&0&0&0&0&1&0&1&0&0&0&1&0&0&1&0&0&0&0&0\\
1&1&0&1&1&0&0&0&1&0&0&0&1&0&0&0&1&0&1&0&0&0&0&0&0\\
0&1&1&0&1&0&1&0&1&1&0&0&0&0&0&0&1&1&0&0&0&0&0&0&0\\
1&0&1&0&1&0&1&0&1&0&1&0&1&0&1&0&0&0&0&0&0&0&0&0&0\\
0&0&1&1&1&1&0&0&1&1&0&0&1&1&0&0&0&0&0&0&0&0&0&0&0\\
1&1&0&0&1&0&0&1&1&1&1&0&0&0&0&0&0&0&0&0&0&0&0&0&0\\
1&1&1&1&1&1&1&0&0&0&0&0&0&0&0&0&0&0&0&0&0&0&0&0&0\\
1&1&0&0&1&1&0&0&1&1&0&0&1&1&0&0&1&1&0&0&1&1&0&0&0\\
1&1&1&0&0&0&1&1&1&0&0&0&0&1&1&1&0&0&0&0&0&0&0&0&0\\
1&1&1&1&1&1&1&0&0&0&0&0&0&0&1&1&1&1&1&1&1&0&0&0&0\\
1&1&1&1&1&1&1&1&1&1&1&1&1&1&1&0&0&0&0&0&0&0&0&0&0
\end{pmatrix}$$

;

or

$$K_{28} = \begin{pmatrix}
1&0&0&0&0&0&0&0&0&0&0&0&0&0&0&0&0&0&0&0&0&0&0&0&0&0&0&0\\
1&0&0&0&0&0&0&0&0&0&0&0&0&0&0&0&1&0&0&0&0&0&0&0&0&0&0&0\\
1&0&0&0&0&0&0&1&0&0&0&0&0&0&0&0&0&0&0&0&0&0&0&0&0&0&0&0\\
1&0&0&0&0&0&0&1&0&0&0&0&0&0&1&0&0&0&1&0&0&0&0&0&0&0&0&0\\
1&0&0&1&0&0&0&0&0&0&0&0&0&0&0&0&0&0&0&0&0&0&0&0&0&0&0&0\\
1&0&0&1&0&0&0&0&0&0&0&0&0&0&0&1&0&1&0&0&0&0&0&0&0&0&0&0\\
1&0&1&0&0&0&0&0&0&0&0&0&0&0&0&0&0&0&0&0&0&0&0&0&0&0&0&0\\
0&0&0&0&0&0&0&1&0&1&0&0&0&0&0&0&0&0&1&0&1&0&0&0&0&0&0&0\\
1&0&0&1&0&0&0&0&0&1&0&1&0&0&0&0&0&0&1&0&1&0&0&0&0&0&0&0\\
1&0&0&1&0&0&0&1&0&0&0&1&0&0&0&1&0&1&0&1&0&0&0&1&0&0&0&0\\
1&1&0&0&0&0&0&0&0&0&0&0&0&0&0&0&0&0&0&0&0&0&0&0&0&0&0&0\\
1&1&0&0&0&0&0&0&0&0&0&0&0&0&1&1&0&0&0&0&0&0&0&0&0&0&0&0\\
0&1&1&0&0&0&0&1&0&1&0&0&0&0&1&1&0&0&0&0&0&0&0&0&0&0&0&0\\
1&0&1&0&1&0&1&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0\\
1&1&0&0&0&0&0&1&1&0&0&0&0&0&1&1&0&0&1&1&0&0&0&0&0&0&0&0\\
1&1&0&0&0&0&0&0&1&1&0&1&0&1&0&1&1&0&0&0&1&1&0&1&0&1&0&0\\
1&1&0&0&1&1&0&0&0&0&0&0&0&0&0&0&0&0&0&0&0&0&0&0&0&0&0&0\\
1&1&0&0&1&1&0&0&0&0&0&0&0&0&1&1&1&1&0&0&0&0&0&0&0&0&0&0\\
0&1&1&0&0&1&1&0&1&0&1&0&1&0&1&0&1&1&1&1&0&0&0&0&0&0&0&0\\
1&1&1&0&0&0&0&0&0&0&0&0&0&0&0&0&0&0&0&0&0&0&0&0&0&0&0&0\\
0&0&0&0&0&0&0&1&1&1&1&0&0&0&0&0&0&0&1&1&1&1&0&0&0&0&0&0\\
1&1&0&0&1&1&0&0&0&0&1&1&1&1&0&0&0&0&0&0&1&1&1&1&0&0&0&0\\
1&1&0&0&1&1&0&0&1&1&0&0&1&1&0&0&1&1&1&1&1&1&0&0&1&1&0&0\\
1&1&1&1&0&0&0&0&1&1&1&1&0&0&0&0&0&0&0&0&0&0&0&0&0&0&0&0\\
1&1&1&1&1&1&1&1&0&0&0&0&0&0&0&0&0&0&0&0&0&0&0&0&0&0&0&0\\
0&0&0&0&0&0&0&1&1&1&1&1&1&1&1&0&0&0&1&1&1&1&1&1&1&1&0&0\\
1&1&1&1&1&1&1&1&1&1&1&1&1&1&1&1&0&0&0&0&0&0&0&0&0&0&0&0
\end{pmatrix};$$

or

$$K_{32} = \begin{pmatrix}
1&0&0&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&1&0&0&0&0&0&0&0&0&0&0&0&0&0&0&0&0\\
1&0&0&0&0&0&0&1&0&0&0&0&0&0&0&0&0&0&0&0&0&0&0&0&0&0&0&0&0&0&0&0\\
1&0&0&0&0&0&0&1&0&0&0&0&0&1&0&0&0&0&0&0&1&0&0&0&0&0&0&0&0&0&0&0\\
1&0&0&1&0&0&0&0&0&0&0&0&0&0&0&0&0&0&0&0&0&0&0&0&0&0&0&0&0&0&0&0\\
1&0&0&1&0&0&0&0&0&0&0&0&0&0&1&0&0&0&1&0&0&0&0&0&0&0&0&0&0&0&0&0\\
1&0&1&0&0&0&0&0&0&0&0&0&0&0&0&0&0&0&0&0&0&0&0&0&0&0&0&0&0&0&0&0\\
1&0&1&0&0&0&0&0&0&0&0&0&0&0&1&0&1&0&0&0&0&0&0&0&0&0&0&0&0&0&0&0\\
0&0&1&0&1&0&0&0&1&0&0&0&1&0&0&0&1&0&1&0&0&0&0&0&0&0&0&0&0&0&0&0\\
1&0&0&0&1&0&0&0&1&0&0&0&1&0&0&0&1&0&0&0&1&0&0&0&1&0&0&0&1&0&0&0\\
1&1&0&0&0&0&0&0&0&0&0&0&0&0&0&0&0&0&0&0&0&0&0&0&0&0&0&0&0&0&0&0\\
1&1&0&0&0&0&0&0&0&0&0&0&0&0&1&1&0&0&0&0&0&0&0&0&0&0&0&0&0&0&0&0\\
0&1&1&0&0&0&0&1&0&1&0&0&0&0&1&1&0&0&0&0&0&0&0&0&0&0&0&0&0&0&0&0\\
1&0&1&0&0&0&0&0&1&0&1&0&0&0&0&0&1&0&1&0&0&0&0&0&1&0&1&0&0&0&0&0\\
1&0&1&0&1&0&1&0&0&0&0&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0&0&0&0&0\\
1&1&0&0&0&0&0&1&1&0&0&0&0&0&1&1&0&0&0&0&0&0&1&1&0&0&0&0&0&0&0&0\\
0&1&1&0&1&0&1&0&1&1&0&0&0&0&0&1&1&0&1&0&1&0&1&1&0&0&0&0&0&0&0&0\\
1&1&0&0&1&1&0&0&0&0&0&0&0&0&0&0&0&0&0&0&0&0&0&0&0&0&0&0&0&0&0&0\\
1&1&0&0&1&1&0&0&0&0&0&0&0&0&1&1&0&0&1&1&0&0&0&0&0&0&0&0&0&0&0&0\\
0&1&1&0&0&1&1&0&1&0&1&0&1&0&1&1&0&0&1&1&0&0&0&0&0&0&0&0&0&0&0&0\\
1&0&1&0&1&0&1&0&1&0&1&0&1&0&1&0&1&0&1&0&1&0&1&0&1&0&1&0&1&0&1&0\\
1&1&1&1&0&0&0&0&0&0&0&0&0&0&0&0&0&0&0&0&0&0&0&0&0&0&0&0&0&0&0&0\\
1&1&1&1&0&0&0&0&0&0&0&0&0&0&1&1&1&1&0&0&0&0&0&0&0&0&0&0&0&0&0&0\\
0&0&1&1&1&1&0&0&1&1&0&0&1&1&0&0&1&1&1&1&0&0&0&0&0&0&0&0&0&0&0&0\\
1&1&0&0&1&1&0&0&1&1&0&0&1&1&0&0&1&1&0&0&1&1&0&0&1&1&0&0&1&1&0&0\\
1&1&1&1&0&0&0&0&1&1&1&1&0&0&0&0&0&0&0&0&0&0&0&0&0&0&0&0&0&0&0&0\\
1&1&1&1&0&0&0&0&1&1&1&1&0&0&0&0&1&1&1&1&0&0&0&0&1&1&1&1&0&0&0&0\\
1&1&1&1&1&1&1&1&0&0&0&0&0&0&0&0&0&0&0&0&0&0&0&0&0&0&0&0&0&0&0&0\\
1&1&1&1&1&1&1&1&0&0&0&0&0&0&0&0&1&1&1&1&1&1&1&1&0&0&0&0&0&0&0&0\\
1&1&1&1&1&1&1&1&1&1&1&1&1&1&1&1&0&0&0&0&0&0&0&0&0&0&0&0&0&0&0&0\\
1&1&1&1&1&1&1&1&1&1&1&1&1&1&1&1&1&1&1&1&1&1&1&1&1&1&1&1&1&1&1&1
\end{pmatrix}$$

According to a second aspect, a decoding method is provided. The method may be performed by a decoder device, or may be performed by a chip, a chip system, or a circuit set in the decoder device. This is not limited in this application.

The method may include: obtaining a to-be-decoded sequence; and decoding the to-be-decoded sequence based on a plurality of trellises, and reusing an intermediate result obtained from decoding performed based on a first trellis in the plurality of trellises when decoding is performed based on a second trellis in the plurality of trellises, where the first trellis is used for a $t^{th}$ stage of decoding the to-be-decoded sequence, the second trellis is used for a $(t+i)^{th}$ stage of decoding the to-be-decoded sequence, t is an integer greater than 0 or equal to 0, and i is an integer greater than 1 or equal to 1.

For example, the obtaining the to-be-decoded sequence may represent receiving the to-be-decoded sequence from outside.

For example, the first trellis corresponds to the $t^{th}$ stage of decoding. In other words, in the $t^{th}$ stage of decoding, decoding is performed based on the first trellis; or when decoding is performed on an information bit of the to-be-decoded sequence, decoding is performed based on the first trellis. For example, the second trellis corresponds to the $(t+i)^{th}$ stage of decoding. In other words, in the $(t+i)^{th}$ stage of decoding, decoding is performed based on the second trellis; or when decoding is performed on another information bit of the to-be-decoded sequence, decoding is performed based on the second trellis.

For example, the intermediate result obtained through decoding performed based on the first trellis indicates a result obtained through processing based on the first trellis or a result obtained at the $t^{th}$ stage of decoding. The intermediate result may include, for example, a decoding path obtained through decoding performed based on the first trellis and a corresponding path measure value.

For example, a plurality of combinations are obtained after all possible paths in a trellis of a smaller level are spliced, and an optimal path and a path value of a trellis of a larger level are obtained by selecting a path with a largest score in these possible combinations.

Based on the foregoing technical solution, when the to-be-decoded sequence is decoded according to a decoding algorithm based on the trellis, intermediate results obtained in different decoding stages may be reused. In other words, when calculation is performed on different trellises, some calculation steps may be the same. Therefore, reusing may be performed for a plurality of times, so that decoding complexity is greatly reduced, and decoding speed is improved.

With reference to the second aspect, in some implementations of the second aspect, each of the plurality of trellises is split into a plurality of sub-trellises.

Based on the foregoing technical solution, when the to-be-decoded sequence is decoded according to a decoding algorithm based on the trellis, the trellis may be first split, and decoding based on a complete trellis is split into decoding based on a sub-trellis (sub-trellis), thereby reducing decoding complexity.

With reference to the second aspect, in some implementations of the second aspect, locations of split points of the plurality of sub-trellises are related to decoding complexity.

In other words, the location of the split point at which the trellis is split is related to decoding complexity.

Based on the foregoing technical solution, an appropriate location of the split point may be selected based on an actual situation. The location of the split point may affect decoding complexity. Therefore, some split points may be selected, to reduce decoding complexity.

With reference to the second aspect, in some implementations of the second aspect, the method further includes: determining, based on a correlation between the first trellis and the second trellis, whether to reuse the intermediate result obtained through decoding performed based on the first trellis when decoding is performed based on the second trellis.

For example, the correlation between the first trellis and the second trellis may indicate whether the first trellis is the same as or similar to the second trellis; or may indicate whether a plurality of sub-trellises corresponding to the first trellis are the same as or similar to a plurality of sub-trellises corresponding to the second trellis; or may indicate whether a same calculation step exists when the processing is performed based on the first trellis and the second trellis.

Based on the foregoing technical solution, whether the intermediate results obtained in different decoding stages can be reused may be determined based on the correlation between the trellises, for example, whether the first trellis is the same as or similar to the second trellis.

With reference to the second aspect, in some implementations of the second aspect, the decoding method further includes: determining, based on the following information, whether to reuse the intermediate result obtained through decoding performed based on the first trellis when decoding is performed based on the second trellis: a code obtained by performing a shortening operation on a linear code C in the $(t+i)^{th}$ stage of decoding and a code obtained by performing the shortening operation on the linear code C in the $t^{th}$ stage of decoding; and/or a code obtained by performing a puncturing operation on the linear code C in the $(t+i)^{th}$ stage of decoding and a code obtained by performing the puncturing operation on the linear code C in the $t^{th}$ stage of decoding.

Based on the foregoing technical solution, whether the intermediate results obtained in different decoding stages can be reused may be determined by comparing the code obtained by performing the shortening operation on the linear code C in different decoding stages and/or the code obtained by performing the puncturing operation on the linear code C in different decoding stages.

With reference to the second aspect, in some implementations of the second aspect, if $s_{x,y}(C^{(t+i)}) = s_{x,y}(C^{(t)})$, and $p_{x,y}(C^{(t+i)}) \subset p_{x,y}(C^{(t)})$, reusing the intermediate result obtained through decoding performed based on the first trellis when decoding is performed based on the second trellis; or if $s_{x,y}(C^{(t+i)}) \subset s_{x,y}(C^{(t)})$, reusing the intermediate result obtained through decoding performed based on the first trellis when decoding is performed based on the second trellis, where $s_{x,y}(C^{(t+i)})$ indicates a code obtained by performing the shortening operation on the linear code C at a location except $x \leq z < y$ in the $(t+i)^{th}$ stage of decoding, $s_{x,y}(C^{(t)})$ indicates a code obtained by performing the shortening operation on the linear code C at the location except $x \leq z < y$ in the $t^{th}$ stage of decoding, $p_{x,y}(C^{(t+i)})$ indicates a code obtained by performing the puncturing operation on the linear code C at the location except $x \leq z < y$ in the $(t+i)^{th}$ stage of decoding, and $p_{x,y}(C^{(t)})$ indicates a code obtained by performing the puncturing operation on the linear code C at the location except $x \leq z < y$ in the $t^{th}$ stage of decoding.

Based on the foregoing technical solution, whether the intermediate results obtained in different decoding stages can be reused may be determined based on the foregoing conditions.

With reference to the second aspect, in some implementations of the second aspect, the reusing the intermediate result obtained through decoding performed based on the first trellis when decoding is performed based on the second trellis includes: when processing is performed based on the second trellis in the $(t+i)^{th}$ stage of decoding, directly using the intermediate result obtained through decoding performed based on the first trellis as an intermediate result obtained through decoding performed based on the second trellis; or when processing is performed based on the second trellis in the $(t+i)^{th}$ stage of decoding, performing processing based on a result of a maximization operation in a process of the first trellis.

With reference to the second aspect, in some implementations of the second aspect, decoding is polar decoding.

In other words, the to-be-decoded sequence is an obtained to-be-decoded sequence after the polar encoding.

Based on the foregoing technical solution, when the encoding is performed by using a high-dimensional kernel matrix and decoding is performed according to a conventional trellis algorithm, decoding complexity of a polar code decoder is high. In this embodiment of this application, decoding complexity can be reduced by performing the decoding on the sub-trellis. In addition, compared with a conventional solution in which encoding is performed by using an Arikan kernel and decoding is performed by using an SCL, lower decoding complexity can be provided while the same performance is ensured in this solution.

According to a third aspect, this application provides an encoding apparatus. The encoding apparatus has a function of implementing the method in any one of the first aspect and the possible implementations of the first aspect. The function may be implemented by hardware, or may be implemented by hardware executing corresponding software. The hardware or the software includes one or more units corresponding to the foregoing function.

In a possible design, when some or all of the functions are implemented by hardware, the encoding apparatus includes: an input interface circuit, configured to obtain information bits; a logic circuit, configured to perform the encoding method in the first aspect to perform polar encoding on the information bits; and an output interface circuit, configured to output an encoded sequence.

Optionally, the encoding apparatus may be a chip or an integrated circuit.

In a possible design, when some or all of the functions are implemented by software, the encoding apparatus includes: a memory, configured to store a computer program; and a processor, configured to execute the computer program stored in the memory, where when the computer program is executed, the encoding apparatus may implement the encoding method according to the first aspect.

Optionally, the memory may be a physically independent unit, or may be integrated with the processor.

In a possible design, when some or all of the functions are implemented by using software, the encoding apparatus includes only a processor. The memory configured to store the program is located outside the encoding apparatus. The processor is connected to the memory by using a circuit/wire, and is configured to read and run the program stored in the memory, to perform the encoding method in the first aspect.

During specific implementation, the encoding apparatus may be the chip or the integrated circuit.

According to a fourth aspect, this application provides a decoding apparatus. The decoding apparatus has a function of implementing the method in any one of the second aspect and the possible implementations of the second aspect. The function may be implemented by hardware, or may be implemented by hardware executing corresponding software. The hardware or the software includes one or more units corresponding to the foregoing function.

In a possible design, when some or all of the functions are implemented by hardware, the decoding apparatus includes: an input interface circuit, configured to obtain a to-be-decoded sequence; a logic circuit, configured to perform the decoding method in the second aspect to decode the to-be-decoded sequence to obtain a decoding result; and an output interface circuit, configured to output the decoding result.

Optionally, the decoding apparatus may be a chip or an integrated circuit.

In a possible design, when some or all of the functions are implemented by software, the decoding apparatus includes: a memory, configured to store a computer program; and a processor, configured to execute the computer program stored in the memory, where when the computer program is executed, the decoding apparatus may implement the decoding method according to the second aspect.

Optionally, the memory may be a physically independent unit, or may be integrated with the processor.

In a possible design, when some or all of the functions are implemented by using software, the decoding apparatus includes only a processor. The memory configured to store the program is located outside the decoding apparatus. The processor is connected to the memory by using a circuit/wire, and is configured to read and run the program stored in the memory, to perform the decoding method in the second aspect.

During specific implementation, the decoding apparatus may be the chip or the integrated circuit.

According to a fifth aspect, this application provides a network device, including a transceiver, a processor, and a memory. The processor is configured to control the transceiver to receive and send a signal, the memory is configured to store a computer program, and the processor is configured to invoke and run the computer program stored in the memory, so that the network device performs the method in any possible implementation of the first aspect.

Specifically, when the network device serves as a transmit end of information and/or data, the network device performs the encoding method in the first aspect to encode sent information bits.

According to a sixth aspect, this application provides a network device, including a transceiver, a processor, and a memory. The processor is configured to control the transceiver to receive and send a signal, the memory is configured to store a computer program, and the processor is configured to invoke and run the computer program stored in the memory, so that the network device performs the method in any possible implementation of the second aspect.

Specifically, when the network device serves as a receive end of information and/or data, the network device performs the decoding method in the second aspect, to decode a to-be-decoded sequence received from a transmit end.

According to a seventh aspect, this application provides a terminal device, including a transceiver, a processor, and a memory. The processor is configured to control the transceiver to receive and send a signal, the memory is configured to store a computer program, and the processor is configured to invoke and run the computer program stored in the memory, so that the terminal device performs the method in any possible implementation of the first aspect.

Specifically, when the terminal device serves as a transmit end of information and/or data, the terminal device performs the encoding method in the first aspect to encode sent information bits.

According to an eighth aspect, this application provides a terminal device, including a transceiver, a processor, and a memory. The processor is configured to control the transceiver to receive and send a signal, the memory is configured to store a computer program, and the processor is configured to invoke and run the computer program stored in the memory, so that the terminal device performs the method in any possible implementation of the second aspect.

Specifically, when the terminal device serves as a receive end of information and/or data, the terminal device performs the decoding method in the second aspect, to decode a to-be-decoded sequence received from a transmit end.

According to a ninth aspect, this application provides a computer-readable storage medium. The computer-readable storage medium stores instructions, and when the instructions are run on a computer, the computer is enabled to perform the method in any one of the possible implementations of the first aspect or the second aspect.

According to a tenth aspect, this application provides a computer program product, where the computer program product includes a computer program code, and when the computer program code is run on a computer, the computer is enabled to perform the method in any one of the possible implementations of the first aspect or the second aspect.

According to an eleventh aspect, this application provides a chip, including a logic circuit and a communication interface, where the communication interface is configured to receive to-be-processed data and/or information, and transmit the to-be-processed data and/or information to the logic circuit, the logic circuit is configured to perform encoding, and the communication interface is further configured to output the processed data/information.

Specifically, the chip may be a chip set at a transmit end, and the to-be-processed data and/or information may be information bits. The chip obtains information bits by using the communication interface, and transmits the information bits to the logic circuit. The logic circuit encodes the information bits by using the encoding method described in the first aspect. The chip outputs an encoded polar code by using the communication interface.

Optionally, the communication interface may include an input interface and an output interface. The input interface is configured to obtain the information bits, and the output interface is configured to output the encoded polar code.

Optionally, the chip may be a chip set at a transmit end. The logic circuit is configured to generate the information bits, and encode the information bits by using the encoding method described in the first aspect. The chip outputs the encoded polar code by using the communication interface.

Optionally, the communication interface may include an input output interface. The input output interface is configured to output the encoded polar code.

According to a twelfth aspect, this application provides a chip, including a logic circuit and a communication interface, where the communication interface is configured to receive to-be-processed data and/or information, and transmit the to-be-processed data and/or information to the logic circuit, the logic circuit is configured to perform decoding, and the communication interface is further configured to output the processed data/information.

Specifically, the chip may be a chip configured in a receive end, and the to-be-processed data and/or information may be a to-be-decoded sequence. The chip receives the to-be-decoded sequence by using the communication interface, and transmits the to-be-decoded sequence to the logic circuit. The logic circuit decodes the to-be-decoded sequence by using the decoding method described in the second aspect. The chip outputs a decoding result by using the communication interface.

Optionally, the communication interface may include an input interface and an output interface. The input interface is configured to receive the to-be-decoded sequence, and the output interface is configured to output the decoding result.

Optionally, the chip may be a chip configured at a receive end. The logic circuit is configured to obtain the to-be-decoded sequence, and decode the to-be-decoded sequence by using the decoding method described in the second aspect. The chip outputs the decoding result by using the communication interface.

Optionally, the communication interface may include an input output interface. The input output interface is configured to output the decoding result.

According to a thirteenth aspect, this application provides a communication system, including an encoder device and a decoder device.

## BRIEF DESCRIPTION OF DRAWINGS

FIG. 1 is a schematic diagram of a wireless communication system applicable to an embodiment of this application;

FIG. 2 is a basic flowchart of performing communication by using a wireless technology;

FIG. 3 is a schematic diagram of encoding a polar code;

FIG. 4 is a possible schematic diagram of a trellis representation;

FIG. 5 is a possible schematic diagram of an extended trellis of an Arikan kernel matrix;

FIG. 6 is a comparison of decoding performance and complexity of a (4096, 2048) polar subcode when different polar kernels are used on an encoding side;

FIG. 7 shows a kernel matrix $K_{16}$;

FIG. 8 shows a kernel matrix $K'_{16}$;

FIG. 9 is a comparison of decoding performance and complexity of a (1024, 512) polar subcode when different polar kernels are used on an encoding side;

FIG. 10 shows a kernel matrix $K_{32}$;

FIG. 11 shows a kernel matrix $K'_{32}$;

FIG. 12 is a possible schematic diagram of decoding performed based on a trellis according to a Viterbi algorithm;

FIG. 13 is a schematic block diagram of a decoding method according to an embodiment of this application;

FIG. 14 is a schematic block diagram of an encoding method according to an embodiment of this application;

FIG. 15 to FIG. 18 are schematic diagrams of constructing a kernel whose dimension is 20×20 based on a kernel $K_{24}$;

FIG. 19 is a schematic diagram of a constructed kernel matrix whose dimension is 20×20;

FIG. 20 to FIG. 22 are schematic diagrams of a kernel matrix whose dimension is 20;

FIG. 23 and FIG. 24 are schematic diagrams of a kernel matrix whose dimension is 21;

FIG. 25 to FIG. 27 are schematic diagrams of a kernel matrix whose dimension is 24;

FIG. 28 and FIG. 29 are schematic diagrams of a kernel matrix whose dimension is 25;

FIG. 30 is a schematic diagram of a kernel matrix whose dimension is 28;

FIG. 31 is a schematic diagram of a general trellis and a splitting trellis of an (8, 4) code;

FIG. 32 to FIG. 34 are schematic diagrams of a process of decoding an (8, 4) Hamming code by using a method of separating a trellis;

FIG. 35 to FIG. 37 are schematic diagrams of a kernel processing on an Arikan matrix with two iterations;

FIG. 38 is a schematic diagram of a kernel matrix $K_1$;

FIG. 39 is a recursive trellis diagram applicable to an embodiment of this application;

FIG. 40 and FIG. 41 are schematic diagrams of a comparison of performance and complexity of a (1024, 512) polar subcode by using a kernel $K_{32}$, a kernel $K'_{32}$, and an Arikan kernel;

FIG. 42 and FIG. 43 are schematic diagrams of a comparison between a polar code and a 5G LDPC code in terms of performance and complexity;

FIG. 44 is a schematic block diagram of an apparatus according to this application;

FIG. 45 is a schematic diagram of a structure of an apparatus according to this application; and

FIG. 46 is still another schematic diagram of a structure of an apparatus according to this application.

**DESCRIPTION OF EMBODIMENTS**

The following describes technical solutions of this application with reference to the accompanying drawings.

The technical solutions in embodiments of this application may be applied to various wireless communication systems. For example, the wireless communication system may include but is not limited to a wireless local area network (wireless local access network, WLAN) system, a narrow band-internet of things (narrow band-internet of things, NB-IoT) system, a 5th generation (5th generation, 5G) system, a new radio (new radio, NR) system, a long term evolution (long term evolution, LTE) system, or a communication system after 5G. The technical solutions in embodiments of this application may be further applied to device to device (device to device, D2D) communication, machine to machine (machine to machine, M2M) communication, machine type communication (machine type communication, MTC), satellite communication, and communication in an Internet of Vehicles system. Communication modes in the Internet of Vehicles system are collectively referred to as V2X (X indicates everything). For example, the V2X communication includes vehicle to vehicle (vehicle to vehicle, V2V) communication, vehicle to infrastructure (vehicle to infrastructure, V2I) communication, vehicle to pedestrian (vehicle to pedestrian, V2P) communication, or vehicle to network (vehicle to network, V2N) communication.

For example, the technical solutions in embodiments of this application may be applied to an application scenario of a 5G mobile communication system, such as enhanced mobile broadband (enhance mobile broadband, eMBB), ultra reliable low latency communication (ultra reliable low latency communication, URLLC), and enhanced massive machine type communication (massive machine type communication, eMTC).

Based on a network device mentioned in this application, the network device may be any device having a wireless transceiver function. The device includes but is not limited to: an evolved NodeB (evolved NodeB, eNB), a Radio Network Controller (Radio Network Controller, RNC), a NodeB (NodeB, NB), a Base Station Controller (Base Station Controller, BSC), a base transceiver station (Base Transceiver Station, BTS), a home base station (for example, a Home evolved NodeB, or a Home NodeB, HNB), a Baseband unit (Baseband Unit, BBU), an Access Point (Access Point, AP) in a Wireless Fidelity (Wireless Fidelity, Wi-Fi) system, a wireless relay node, a wireless backhaul node, a transmission point (transmission point, TP), or a transmission and reception point (transmission and reception point, TRP). Alternatively, the device may be 5G, for example, NR, a gNB in a system, a transmission point (TRP or TP), or one or a group of (including a plurality of antenna panels) antenna panels of a base station in the 5G system, or may be a network node that forms the gNB or the transmission point, for example, the Baseband unit (BBU) or a distributed unit (distributed unit, DU).

In some deployments, the gNB may include a central unit (central unit, CU) and the DU. The gNB may further include an active antenna unit (active antenna unit, AAU for short). The CU implements some functions of the gNB, and the DU implements some functions of the gNB. For example, the CU is responsible for processing a non-real-time protocol and a service, to implement functions of a radio resource control (radio resource control, RRC) layer and a packet data convergence protocol (packet data convergence protocol, PDCP) layer. The DU is responsible for processing a physical layer protocol and a real-time service, and implements functions of a radio link control (radio link control, RLC) layer, a media access control (media access control, MAC) layer, and a physical (physical, PHY) layer. The AAU implements some physical layer processing functions, radio frequency processing, and a function related to the active antenna. Information at the RRC layer is eventually converted into information at the PHY layer, or is converted from information at the PHY layer. Therefore, in this architecture, higher layer signaling such as RRC layer signaling may also be considered as being sent by the DU or sent by the DU and the AAU. It may be understood that the network device may be a device including one or more of a CU node, a DU node, and an AAU node. In addition, the CU may be a network device in a radio access network (radio access network, RAN), or may be a network device in a core network (core network, CN). This is not limited in this application.

The terminal device in this application may also be referred to as user equipment (User Equipment, UE), an access terminal, a subscriber unit, a subscriber station, a mobile station, a remote station, a remote terminal, a mobile device, a user terminal, a terminal, a wireless communication device, a user agent, a user apparatus, or the like. The terminal device in embodiments of this application may be a mobile phone (mobile phone), a Pad (Pad), a computer with a wireless transceiver function, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), or a wireless terminal in transportation security (transportation safety), a wireless terminal in a smart city (smart city), a wearable wireless terminal, a wireless terminal in a smart home (smart home), and the like. Application scenarios are not limited in embodiments of this application.

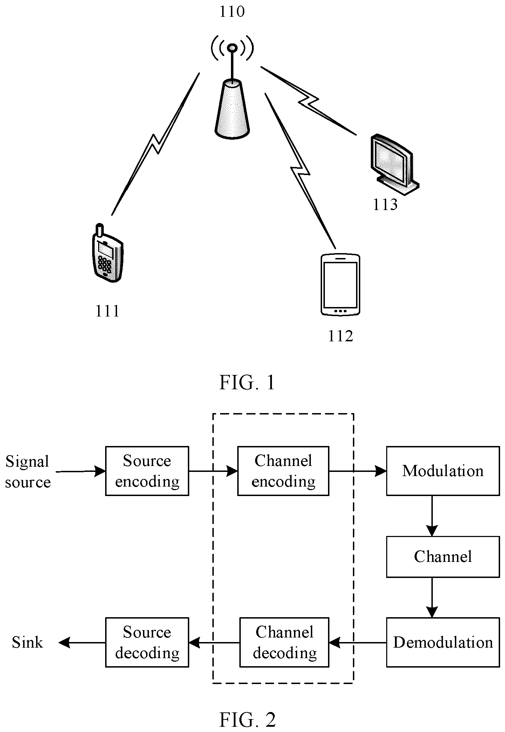

For ease of understanding embodiments of this application, a communication system to which an embodiment of this application is applicable is first described in detail with reference to FIG. 1 and FIG. 2.

FIG. 1 is a schematic diagram of a wireless communication system applicable to an embodiment of this application. As shown in FIG. 1, the wireless communication system may include at least one network device 110 and at least one terminal device (for example, 111, 112, and 113 shown in FIG. 1). The network device 110 performs wireless communication with the terminal device. When the network device 110 sends a signal to the terminal device, the network device 110 is an encoder, and the terminal device is a decoder. When the terminal device sends a signal to the network device 110, the terminal device is an encoder, and the network device is a decoder.

In the wireless communication system shown in FIG. 1, after being encoded by an encoder (encoder), original information is transmitted through a channel, received by a decoder (decoder), and decoded by the decoder to restore the original information.

The encoder may also be referred to as a transmit end (or a sending device), and the decoder may also be referred to as a receive end (or a receiving device) of information or data. The sending device may be a network device, and the receiving device may be a terminal device. Alternatively, the sending device may be a terminal device, and the receiving device may be a network device. Alternatively, the sending device may be a terminal device, and the receiving device may be a terminal device. Alternatively, the sending device may be a network device, and the receiving device may be a network device.

It should be understood that FIG. 1 is merely an example for description, and this application is not limited thereto. For example, embodiments of this application may be further applied to any communication scenario of uplink/downlink control channel coding in a 5G eMBB scenario.

FIG. 2 is a basic flowchart of performing communication by using a wireless technology. A signal source at a transmit end is sent on a channel after signal source encoding, channel encoding, rate matching, and modulation in sequence. After receiving the signal, a receive end sequentially performs demodulation, rate de-matching, channel decoding, and signal source decoding to obtain a sink. The technical solutions provided in embodiments of this application may be applied to a channel encoding module and a channel decoding module shown in a dashed box in FIG. 2.

Channel coding is one of core technologies in the wireless communication field, and performance improvement of channel coding can directly improve network coverage and a user transmission rate. Currently, a polar code (polar code) can be strictly proved to be a channel encoding scheme that reaches a channel capacity, and has features such as high performance, low complexity, and a flexible matching manner. Currently, the polar code is determined by the 3GPP as a control channel coding scheme in a 5G control channel eMBB scenario (uplink/downlink).

For ease of understanding of embodiments of this application, the following first briefly describes several terms in this application.

1. Encoding scheme of a polar code

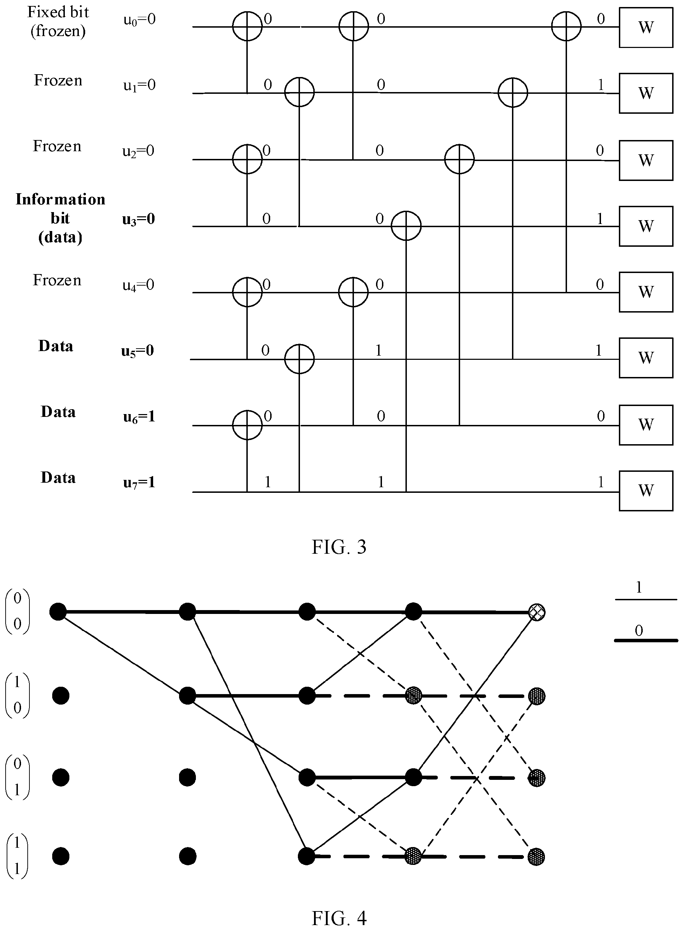

FIG. 3 is a schematic diagram of encoding a polar code. As shown in FIG. 3, a symbol "⊕" indicates binary summation, input of the symbol is at a left side and a lower side, and output of the symbol is at a right side. Each solid line in FIG. 3 indicates 1 bit. $\{u_0, u_1, u_2, u_4\}$ is set as fixed bits (or frozen bits), and polar encoding is performed on a total of four information bits $\{u_3, u_5, u_6, u_7\}$, to obtain eight encoded bits. After encoding, the eight encoded bits are modulated and then sent through a noisy channel.

To-be-encoded bits are sorted based on their respective reliability. Generally, a bit with high reliability is set to an information bit (data), a bit with low reliability is set to a frozen (frozen) bit, and a value of the frozen (frozen) bit is usually set to 0, which is known to both a transmit end and a receive end in actual transmission. As shown in FIG. 3, $u_7, u_6, u_5$, and $u_3$ are four bits with high reliability, and are set as information bits (data). $u_4, u_2, u_1$, and $u_0$ are four bits with low reliability, and are set as frozen (frozen) bits.

2. Linear block code trellis (Trellis) representation

Decoding based on a trellis is a conventional decoding manner of a convolutional code. For a linear block code, decoding may also be performed based on the trellis. Decoding based on the trellis is a maximum likelihood (maximum likelihood, ML)/MAP decoding manner. In this manner of decoding, decoding performance is good, but correspondingly, decoding complexity is very high. Given a linear block code whose check matrix is *H,* all code words need to comply with:

$$0 = cH^T = \sum_{i=0}^{n-1} c_i H^{(i)}.$$

$H^{(i)}$ indicates the $i$th column of the check matrix *H*. A node at the $j$th moment in a trellis diagram is marked as:

$$S^{(j)} = \sum_{i=0}^{j-1} c_i H^{(i)}.$$

FIG. 4 is a possible schematic diagram of trellis representation. Refer to FIG. 4. A basic component unit in trellis representation is a trellis node (for example, nodes 1, 2, ..., and 20 in FIG. 4). For example, trellis representation

$$H = \begin{pmatrix} 1 & 1 & 1 & 0 \\ 0 & 1 & 0 & 1 \end{pmatrix}$$

of a check matrix                    is shown in FIG. 4. For a detailed solution of performing decoding based on the trellis, refer to existing descriptions. This is not limited herein.

3. Channel parameter

A polar code is a constructable channel encoding scheme that can reach a binary input discrete memory less channel capacity.

It is assumed that W: {0,1}→Y is a symmetric binary (binary) discrete memory less channel (discrete memory less channel) (B-DMC), an input letter set of W: {0,1}→Y is x={0,1}, and an output letter set of W: {0,1}→Y is Y When input $x$ and channel output $y$ are given, a channel condition transition probability is expressed as W($y|x$).

A capacity of the B-DM channel (B-DMC) W can be defined as follows:

$$I(W) = \sum_{y \in Y} \sum_{x \in \{0,1\}} \frac{1}{2} W(y \mid x) \log \frac{W(y \mid x)}{\frac{1}{2} W(y \mid 0) + \frac{1}{2} W(y \mid 1)}.$$

A B-DM channel Bhattacharyya parameter may be defined as:

$$Z(W) = \sum_{y \in Y} \sqrt{W(y \mid 0) + \frac{1}{2} W(y \mid 1)}.$$

4. Kernel matrix

In the literature, Arikan infers that polarization is a common phenomenon and is not limited to the given

$G = F_2^{\otimes m}$ , where $F_2 = \begin{pmatrix} 1 & 0 \\ 1 & 1 \end{pmatrix}$ , and "⊗$m$" indicates an m-time Kronecker (Kronecker) product. Korada and so on prove the conclusion and extend it to a high-dimensional kernel matrix, and prove that a condition for polarization of any $l \times l$ matrix is a permutation matrix of any column in the $l \times l$ matrix but not an upper triangular matrix In addition, Korada and so on also prove that when $l \leq 15$, a polarization exponent $\beta$ of any kernel matrix cannot exceed 1/2. In a case of a same code length, a larger polarization exponent $\beta$ indicates a lower decoding error probability of a corresponding polar code, and corresponding decoding performance is better. However, a main problem of the high-dimensional kernel matrix polar code is that its decoding algorithm is complex, which is one of bottlenecks in high-dimensional kernel matrix research.

5. Polarization exponent (polarization exponent)

Several theorems are briefly described for the polarization exponent. For details, refer to descriptions in the conventional technology. This is not limited herein.

Theorem 1: Given a B-DM channel W (that is, B-DWC W), for $F_2$ and any $\beta < \frac{1}{2}$, the following can be obtained:

$$\liminf_{m \to \infty} P\left(Z_m \leq 2^{-n^\beta}\right) = \liminf_{m \to \infty} P\left(Z_m \leq 2^{-2^{m\beta}}\right) = I(W).$$

Correspondingly, if $I(W) < 1$, for any $\beta > \frac{1}{2}$, the following may be obtained:

$$\liminf_{m\to\infty} P\left(Z_m \ge 2^{-n^{\beta}}\right) = \liminf_{m\to\infty} P\left(Z_m \ge 2^{-2^{m\beta}}\right) = 1$$

$\beta$ is referred to as a polarization exponent, and a code length is $n = 2^m$.

Korada and so on extend the above theorem to any high-dimensional kernel matrix. In this case, the code length is $n = l^m$. This is described in the following.

Theorem 2: For any B-DM channel W (that is, B-DWC W), if 0 < I(W) < 1 and the following conditions are met, an $l \times l$-dimensional kernel matrix $K$ has a polarization exponent E($K$). The conditions are:

(1) For any $\beta < E(K)$:

$$\liminf_{m\to\infty} P(Z_m \le 2^{-l^{m\beta}}) = I(W)$$
;

and
(2) For any $\beta > E(K)$:

$$\liminf_{m\to\infty} P(Z_m \ge 2^{-l^{m\beta}}) = 1$$
.

Here, E($K$) indicates the polarization exponent. For the arikan kernel, the polarization exponent of the arikan kernel is 1/2.

Given the matrix $K$ and the corresponding E($K$), theorem 2 shows that:

(1) When $m$ tends to infinity, if 0 < R < I(W) and $\beta < E(K)$, there is a set A whose size is NR that meets:

$$\sum_{i\in A} Z^{(i)} \le 2^{-n^{\beta}}$$
, where A is an information bit set. Through successive cancellation (successive cancellation, SC) decoding, a bound of a frame error ratio in SC decoding is:

$$P_e(n) \le 2^{-n^{\beta}}$$
.

(2) When $m$ tends to infinity, if R > 0 and $\beta > E(K)$, any set A whose size is NR meets: $\max_{i\in A} Z^{(i)} > 2^{-n^{\beta}}$ , where A is an information bit set, and a bound of a frame error ratio under SC decoding is:

$$P_e(n) \ge 2^{-n^{\beta}}$$
.

It can be learned from the foregoing that the polarization exponent may measure a convergence speed of decoding performance, and a larger polarization exponent indicates a faster convergence speed, so that better decoding performance can be obtained when the code length is short.

6. Scaling exponent (scaling exponent)

Another key feature of a polar kernel is a scaling exponent. It may be understood that the scaling exponent may indicate kernel matrix performance. It should be understood that this embodiment of this application focuses on a function of the scaling exponent. The Chinese expression of the scaling exponent may be a scaling exponent, and the like. This is not limited herein.

For example, given a channel W whose channel capacity is I(W) and an expected error probability $P_e$, it is assumed that a kernel matrix of a polar code corresponding to (N, k) is K. If transmission is expected to be performed at a rate of R=I(W)-Δ, a code length N meets:

$$N = O\left(\frac{1}{\left(I(W)-R\right)^{\mu(K)}}\right) = Q\left(\Delta^{-\mu(K)}\right)$$

.

$\mu(K)$ is the scaling exponent.

It may be understood that the scaling exponent is a parameter related to the channel. For a random code, $\mu$ = 2. For the polar code, when $l \to \infty$, let $K = F_l$, and the following may be obtained:

$$\lim_{l \to \infty} \mu\left(F_l\right) = 2$$

.

On a BEC channel, a scaling exponent of the polar code with an Arikan kernel may be 3.627.

7. Partial distance (partial distance)

In an $l \times l$ matrix $K$, $K[i]$ indicates the $i^{th}$ line of the matrix, and a part distance $D_i(i = 0,\cdots,l-1)$ of the matrix is:

$$D_i \, \Box \, d_H\left(K[i], \langle K[i+1], \cdots, K[l-1]\rangle\right), i = 0,\cdots,l-2$$

$$D_{l-1} \, \Box \, d_H\left(K[l-1], 0\right)$$

.

$d_H(a,b)$ indicates a Hamming distance between a vector a and a vector b, and a vector D may be defined as a partial distance profile (PDP). For any B-DMC W, any $l \times l$ polar matrix $K$, and a partial distance $\left\{D_i\right\}_{i=0}^{l-1}$ thereof, a corresponding polarization exponent $E(K)$ may be expressed as:

$$E(K) = \frac{1}{l}\sum_{i=0}^{l-1}\log_l D_i$$

.

Actually, with $l \to \infty$, an $l \times l$ kernel that makes the polarization exponent infinitely close to 1 can be obtained.

It should be understood that the foregoing theorem is merely a brief description for understanding, and does not limit the protection scope of embodiments of this application. For details, refer to existing descriptions. This is not limited herein.

8. Kernel matrix encoding

For one (n, $k$) polar code (a code length n is: $n = l^m$), given an $l \times l$ kernel matrix K, $G = M^{(m)}K^{\otimes m}$, where $M^{(m)}$ is a digital rotated matrix, a corresponding mapping relationship is $\sum_{i=0}^{m-1} t_i l^i \to \sum_{i=0}^{m-1} t_{m-1-i} l^i$. $t_i \in [l]$, $[l]$ indicates a set {0, 1, ..., $l$-1}, a corresponding code may be represented as $c_0^{n-1} = u_0^{n-1}G$, $u_i, i \in F$ is a frozen bit, $|F| = n-k$, and a remaining bit is an information bit.

9. Kernel processing (Kernel Processing)

During polar code decoding, a posterior probability $W_m^{(j)}(u_0^j \mid y_0^l)$ needs to be calculated. $W_m^{(j)}(u_0^j \mid y_0^l)$

may be obtained through recursion. For simple description, let m=1, and a corresponding task may be referred to as kernel processing. The kernel processing is specifically the following:

$$W_1^{(j)}(u_0^j \mid y_0^l) = \sum_{u_{j+1}^{l-1}} W_1^{(l-1)}(u_0^{l-1} \mid y_0^{l-1}) = \sum_{u_{j+1}^{l-1}} \prod_{i=0}^{l-1} W\left((u_0^{l-1}K)_i \mid y_i\right).$$

The foregoing formula may also be approximately expressed as:

$$\tilde{W}_1^{(j)}(u_0^j \mid y_0^l) = \max_{u_{j+1}^{l-1}} W_1^{(l-1)}(u_0^{l-1} \mid y_0^{l-1}) = \max_{u_{j+1}^{l-1}} \prod_{i=0}^{l-1} W\left((u_0^{l-1}K)_i \mid y_i\right).$$

The probability in the foregoing formula corresponds to a path with a maximum possibility in a decoding number $u_0^j$. A log-likelihood ratio (log-likelihood ratio, LLR) may be approximately expressed as:

$$S_{1j}(u_0^{i-1} \mid y_0^{n-1}) = \max_{u_{i+1}^{l-1}} \ln W_1^{(l-1)}(u(0)^i \mid y_0^{l-1}) - \max_{u_{i+1}^{l-1}} \ln W_1^{(l-1)}(u(1)^i \mid y_0^{l-1}).$$

$$u(a)^i = \left(u_0^{i-1}, a, u_{i+1}^{l-1}\right)$$ . It is assumed that for all $u_j$, $i<j<l$ is of equal probability, and a matrix formed by the last ($l$-$i$+1) lines of the kernel K may generate corresponding codewords. In this case, $S_{1j}$ may be obtained by performing ML decoding on a coset of these codewords, and a coset leader is obtained by multiplying $u_0^{i-1}$ and a matrix formed by the first $i$ lines of the kernel K.

It should be understood that in embodiments of this application, a person skilled in the art should understand the meaning of coset (coset) mentioned for a plurality of times. For example, if G is a set, H is a subset of G, and g is an element of G, gH={gh: all h E H} indicates a left coset of H, and Hg={hg: all h E H} indicates a right coset of H. Details are not described in the following.

10. Extended kernel codes

An ($l$+1, $l$-$i$) code $\overline{\square}^{(i)}$ generated by $K^{(i)}$ is considered, and $K^{(i)}$ can be obtained from $K$ according to the following rules:

(1) The first $l$ columns of $K^{(i)}$ are obtained by obtaining the last ($l$-$i$) lines of K.
(2) The first line in the last column of $K^{(i)}$ is set to 1, and other lines are set to 0.

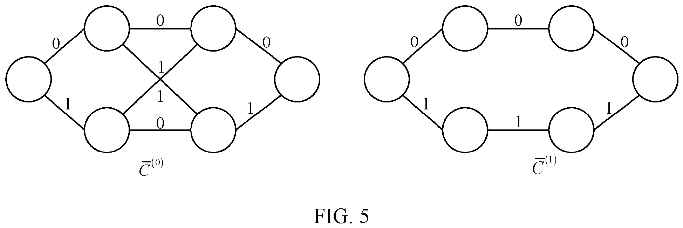

For example, an Arikan kernel is $\begin{pmatrix} 1 & 0 \\ 1 & 1 \end{pmatrix}$, $K^{(0)} = \begin{pmatrix} 1 & 0 & 1 \\ 1 & 1 & 0 \end{pmatrix}$ and $K^{(1)}$ = (1 1 1) may be obtained. A trellis corresponding to the Arikan kernel is shown in FIG. 5.

11. Correlation discrepancy (correlation discrepancy)

When decoding is performed based on a trellis, different paths (which indicates different decoding results) need to be selected and compared. A definition of a path value (a score of c) may be provided in a plurality of manners, for example:

(1) Logarithm of probability. For example, it may be expressed as: $\log W(c|y)$.

(2) Correlation (correlation). For example, it may be expressed as: $\Sigma_i(-1)^{c_i}S(y_i)$. $S(y_i)$ is the $i^{th}$ LLR.

(3) Correlation discrepancy. For example, it may be expressed as: $\Sigma_i \tau(S(y_i), c_i)$.

The correlation discrepancy of $c_0^{l-1}$ and $y_0^{l-1}$ is defined as: $\varepsilon\left(c_0^{l-1}, y_0^{l-1}\right) = \sum_{i=0}^{l-1} \tau\left(c_i, y_i\right)$ .

$$\tau\left(c, y\right) = \begin{cases} -|S(y)|, & (-1)^c \neq sign\, S(y) \\ 0 & otherwise \end{cases}$$

In addition, $S(y) = \log \dfrac{W(0|y)}{W(1|y)}$ , and $S_{1,t}\left(u_0^{t-1} | y_0^{n-1}\right) = \varepsilon\left(c^{(0)}, y_0^{l-1}\right) - \varepsilon\left(c^{(1)}, y_0^{l-1}\right)$ may be ob-

tained. $c^{(ut)} = \left(u_0^t, U\left(u_0^{t-1}, u_t\right)\right)K$ , and $U\left(u_0^{t-1}, u_t\right) = u_{t+1}^{l-1}$ . The solution of the foregoing formula may be equivalent to searching for the most possible codeword when the last bit in the coset of codeword $\overline{\Box}^{(i)}$ is 0 or 1. The searching may be implemented by executing a Viterbi algorithm in a trellis of the codeword $\overline{\Box}^{(i)}$ . Assuming that the last bit of the codeword is erased, the corresponding trellis may be defined as the $i^{th}$ extended trellis (extended Trellis). Generally, complexity of the Viterbi algorithm is $O(2^{\min(i+l,l-i)})$.

In this embodiment of this application, when a polar kernel is selected, kernel processing complexity during decoding is also considered. Sometimes, a kernel with better performance may bring higher decoding complexity. Therefore, comprehensive consideration needs to be further considered during kernel matrix construction or selection.

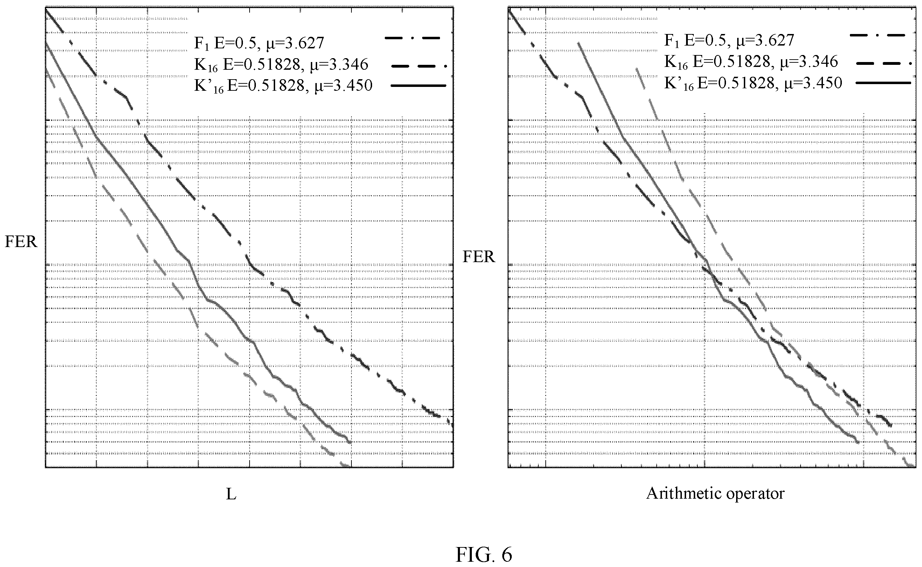

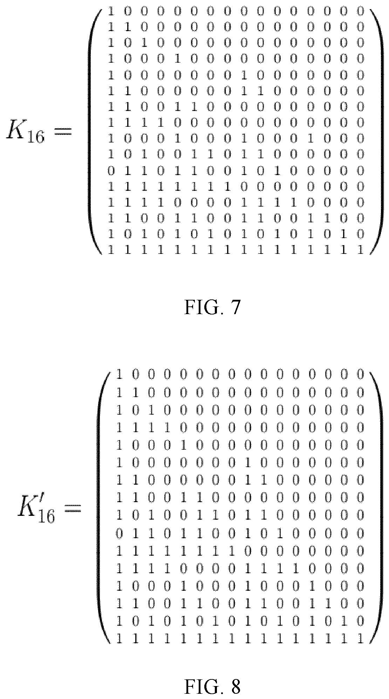

For example, FIG. 6 is a comparison of performance and complexity of a (4096, 2048) polar subcode (polar subcode) when different polar kernels $K_{16}$ and $K_{16}'$ are used on an encoder side and when SCL decoding is used on a decoding side. The kernel $K_{16}$ and the kernel $K_{16}'$ are shown in FIG. 7 and FIG. 8.

It may be learned that: $E\left(K_{16}\right) = E\left(K_{16}'\right) = 0.51828$ ; $\mu\left(K_{16}\right) = 3.346$ and $\mu\left(K_{16}'\right) = 3.45$ ; and

$\phi(K_{16})$ = 472 and $\phi\left(K_{16}'\right) = 183$ . $\phi(K)$ indicates processing complexity of the kernel K. It should be noted that a recursive-based kernel processing algorithm is mainly used as an example for description herein.

It can be learned that using $K_{16}$ can bring better performance than using $K_{16}'$ , but decoding complexity is higher. Therefore, in this case, both performance and complexity need to be considered for selecting a kernel matrix.

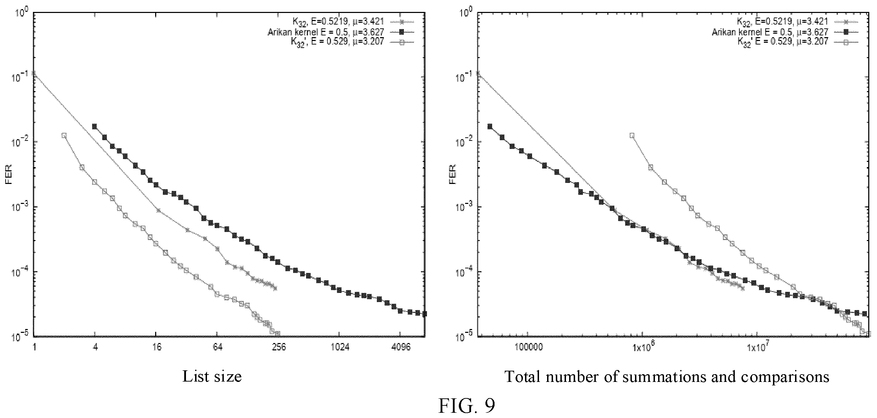

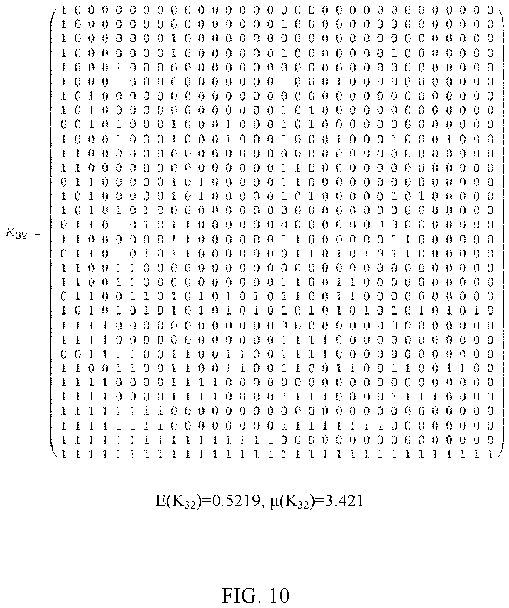

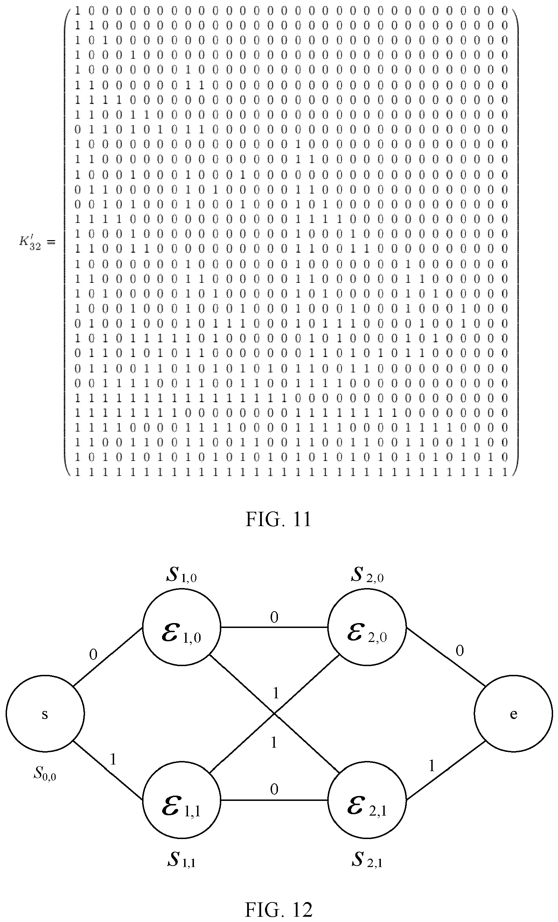

In still another example, FIG. 9 shows a comparison of performance and complexity when a polar subcode (1024, 512) when $K_{32}'$ and polar kernel $K_{32}$ are used on an encoding side and when SCL decoding is used on a decoding side. Kernel $K_{32}$ and $K_{32}'$ are shown in FIG. 10 and FIG. 11.

It may be learned that: $E(K_{32})$ = 0.5219 and $E\left(K_{32}'\right) = 0.529$ ; $\mu(K_{32})$ = 3.421 and $\mu\left(K_{32}'\right) = 3.207$ ;

and $\phi(K_{32})$ = 532 and $\phi\left(K_{32}'\right) = 6770$ . It can be learned that using $K_{32}'$ can bring better performance than using

$K_{32}$, but decoding complexity of using $K'_{32}$ is higher, and decoding complexity of using $K'_{32}$ may be more than 10 times of decoding complexity of using $K_{32}$.

It can be learned from the foregoing that, during encoding, selection of the kernel matrix may affect decoding complexity.

In addition, as mentioned above, the linear block code may be decoded by using a trellis-based method, and the polar code is also a linear block code, and may also be decoded by using such a method. For example, specific decoding steps may be shown as follows:

(1) Let $I(j, s)$ be a set of all states connected, at a moment j-1, to a state s at a moment j.

(2) Set $c_{j-1,s',s}$ to a value on a corresponding connection edge.

(3) Define a node value as $$\varepsilon_{j,s} = \max_{s' \in I(j,s)} \left( \varepsilon_{j-1,s'} - \tau\left( S(y_{i-1}), c_{j-1,s',s} \right) \right), \quad \varepsilon_{0,0} = 0 \quad.$$

(4) LLR may be obtained through calculation according to $$S_1^{(t)}\left( u_0^{t-1}, y_0^{t-1} \right) = \varepsilon_{l,0} - \varepsilon_{l,1} \quad.$$

For example, when the Viterbi algorithm is used for the Arikan kernel, it is known that the Arikan kernel is $\begin{pmatrix} 1 & 0 \\ 1 & 1 \end{pmatrix}$, $K^{(0)} = \begin{pmatrix} 1 & 0 & 1 \\ 1 & 1 & 0 \end{pmatrix}$ may be obtained. A corresponding trellis diagram of the Arikan kernel is shown in FIG. 12. The following can be obtained through calculation:

$$
\begin{aligned}
\varepsilon_{2,0} - \varepsilon_{2,1} &= \max\left( \tau(S_0,0) + \tau(S_1,0), \tau(S_0,1) + \tau(S_1,1) \right) - \\
&\quad \max\left( \tau(S_0,0) + \tau(S_1,1), \tau(S_0,1) + \tau(S_1,0) \right) \\
&= \max\left( \tau(S_0,0) - \tau(S_0,1) + \tau(S_1,0) - \tau(S_1,1), 0 \right) - \\
&\quad \max\left( \tau(S_0,0) - \tau(S_0,1), \tau(S_1,0) - \tau(S_1,1) \right) \\
&= \max(S_0 + S_1, 0) - \max(S_0, S_1) = \mathrm{sgn}(S_0)\,\mathrm{sgn}(S_1)\,\min\left( |S_0|, |S_1| \right) \quad.
\end{aligned}
$$

The foregoing method is an ML/MAP algorithm. When the code length is long, decoding complexity is very high, and it is difficult to be accepted.

In view of this, embodiments of this application propose that improvement may be made on an encoder and/or a decoder, so as to reduce decoding complexity. For example, a required kernel matrix is selected from a plurality of constructed kernel matrices after comprehensive consideration based on an actual situation, so that both the performance and decoding complexity can be considered. For another example, decoding based on trellis code is used, and the trellis diagram is split. A final trellis optimization path is obtained by processing each split result, so that decoding complexity can be reduced.

The following describes in detail embodiments provided in this application with reference to the accompanying drawings.

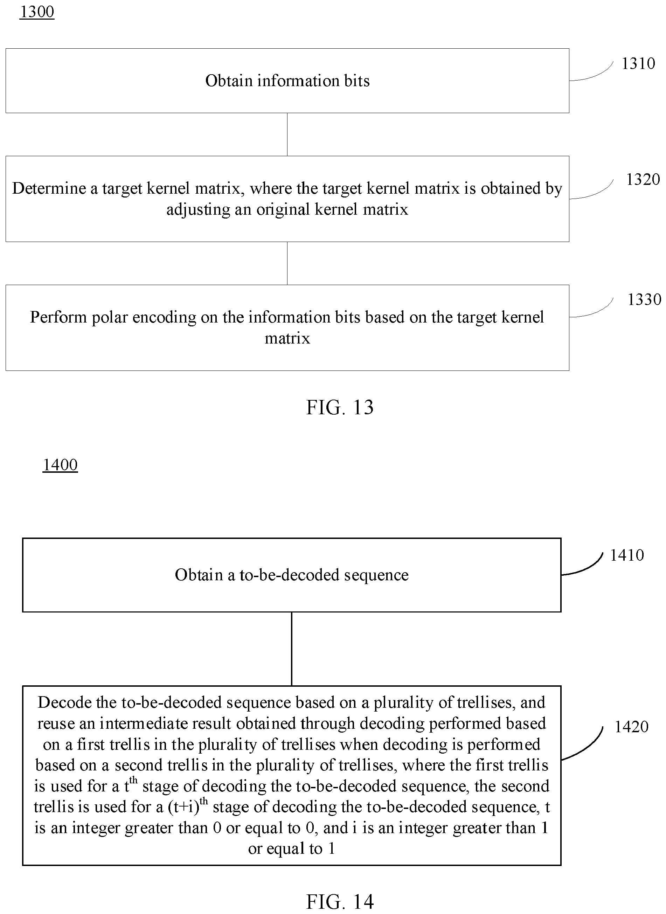

FIG. 13 is a schematic block diagram of an encoding method 1300 according to an embodiment of this application.

1310. Obtain information bits.

In other words, an encoder device obtains to-be-encoded information bits. The information bits may be generated internally, or may be received from outside. This is not limited herein.

1320. Determine a target kernel matrix, where the target kernel matrix is obtained by adjusting an original kernel matrix

In this embodiment of this application, the adjusting an original kernel matrix may include at least the following two solutions.

Solution 1. One or more kernel matrices are obtained by adjusting a PD of the original kernel matrix. One or more kernel matrices are obtained based on Solution 1, and an appropriate target kernel matrix may be selected from

EP 4 199 396 A1

the one or more kernel matrices.

Solution 2. A plurality of kernel matrices whose dimensions are different from a dimension of the original kernel matrix are constructed by adjusting the dimension of the original kernel matrix. One or more kernel matrices are obtained based on Solution 2, and an appropriate target kernel matrix may be selected from the one or more kernel matrices.

It should be understood that, in Solution 2, the adjusting the dimension of the original kernel matrix indicates that the dimension of the kernel matrix is changed by modulating the original kernel matrix. For example, corresponding processing is performed on a line and/or a column of the original kernel matrix, so that a line of the constructed kernel matrix is less than the line of the original kernel matrix, and a column of the constructed kernel matrix is less than the column of the original kernel matrix.

The following describes the preceding two solutions in detail.

1330. Perform polar encoding on the information bits based on the target kernel matrix.

In this embodiment of this application, when the polar encoding is performed, a plurality of kernel matrices may first be constructed, and an appropriate kernel matrix is selected for encoding based on the constructed kernel matrices and an actual communication status. In this manner, when the kernel matrix is constructed or selected, performance and decoding complexity are comprehensively considered, so that decoding complexity can be reduced by selecting the appropriate kernel matrix used during encoding.

For example, in actual communication, one or more kernel matrices are constructed by adjusting the original kernel matrix, and an appropriate target kernel matrix is selected from the one or more kernel matrices. Then, a data vector and a Kronecker product of the corresponding constructed target kernel matrix are multiplied to implement encoding. Then, data is transmitted through a channel after passing through a rate matching module and a modulation module.

A specific solution on the encoder is described in detail in the following.

FIG. 14 is a schematic block diagram of a decoding method 1400 according to an embodiment of this application.

1410. Obtain a to-be-decoded sequence.

1420. Decode the to-be-decoded sequence based on a plurality of trellises, and reuse an intermediate result obtained from decoding performed based on a first trellis in the plurality of trellises when decoding is performed based on a second trellis in the plurality of trellises, where the first trellis is used for a $t^{th}$ stage of decoding the to-be-decoded sequence, the second trellis is used for a $(t+i)^{th}$ stage of decoding the to-be-decoded sequence, t is an integer greater than 0 or equal to 0, and i is an integer greater than 1 or equal to 1.

For example, the first trellis corresponds to the $t^{th}$ decoding stage, and the second trellis corresponds to the $(t+i)^{th}$ decoding stage. In other words, in the $t^{th}$ decoding stage, decoding is performed based on the first trellis, and in the $(t+i)^{th}$ decoding stage, decoding is performed based on the second trellis. For example, in the $t^{th}$ decoding stage, decoding is performed based on the first trellis, and in the $(t+1)^{th}$ decoding stage, decoding is performed based on the second trellis.

In addition, a result obtained through processing in each decoding stage may be denoted as an intermediate result. For example, in the $t^{th}$ decoding stage, when decoding is performed based on the first trellis, an obtained result may be denoted as the intermediate result obtained through decoding performed based on the first trellis. The intermediate result may include, for example, a decoding path obtained through decoding performed in the $t^{th}$ decoding stage and a corresponding path measure value. In the following embodiments, for brevity, a composite branch table (composite branch table, CBT) is used for representation. In other words, content stored in the CBT may include the corresponding path and the corresponding path value during the decoding. Each decoding stage may correspond to one CBT.

In this embodiment of this application, when the to-be-decoded sequence is decoded according to a decoding algorithm based on the trellis, intermediate results obtained in different decoding stages may be reused. In other words, when calculation is performed on different trellises, some calculation steps may be the same. Therefore, reusing may be performed for a plurality of times, so that decoding complexity is greatly reduced, and decoding speed is improved.

It should be understood that in this embodiment of this application, the first trellis and the second trellis are mainly used as examples for description. For each trellis in the plurality of sub-trellises, or in each decoding stage, it may be determined whether an intermediate result of decoding in another decoding stage may be reused in the decoding stage.

Optionally, each of the plurality of trellises is split into a plurality of sub-trellises.

In this embodiment of this application, when the to-be-decoded sequence is decoded according to a decoding algorithm based on the trellis, the trellis may be first split, and the decoding based on a complete trellis is split into decoding based on a sub-trellis (sub-trellis), thereby reducing decoding complexity.

For example, the decoding method provided in this embodiment of this application may also be denoted as recursive trellis decoding or recursive trellis splitting decoding.

For example, in actual communication, after rate de-matching and demodulation are performed, decoding is performed by using the recursive trellis splitting algorithm proposed in this embodiment of this application, so that decoding complexity is low.

A specific solution of the decoder (that is, a recursive trellis splitting algorithm) is described in detail in the following.

The following separately describes the solutions in embodiments of this application from the encoder and the decoder.

Encoding Side

Optionally, in this embodiment of this application, a plurality of kernel matrices may be constructed by using Solution 1 and/or Solution 2. During the kernel matrix construction or selection, the appropriate kernel matrix may be selected for encoding based on an actual situation.

Solution 1. A plurality of kernel matrices are constructed by adjusting a PD of an original kernel matrix.

Solution 2. A plurality of kernel matrices whose dimensions are different from a dimension of the original kernel matrix are constructed by adjusting the dimension of the original kernel matrix.

The two solutions are described in the following.

Solution 1. A plurality of kernel matrices are constructed by adjusting a PD of an original kernel matrix.

Optionally, a plurality of kernel matrices are constructed based on an existing PDP by adjusting the PDP.

Optionally, a given PDP is adjusted, and depth-first search is performed based on the adjusted PDP.

It should be understood that another algorithm similar to the depth-first search algorithm or can implement a same function is applicable to this embodiment of this application. For ease of understanding, the depth-first algorithm is mainly used as an example for description in the following.

In a possible implementation, when the depth-first search is performed, some constraint conditions may be designed to reduce search space and a quantity of search times. The constraint conditions, for example, may be considered from one or more of the following aspects.

Aspect 1. A constraint condition about a candidate line set M is designed. In other words, the candidate line set meeting a specific condition may be limited.

In a possible condition, the candidate line set M needs to meet: $M[i] = \left\{ v_0^{l-1} \in F_2^l \mid wt\left(v_0^{l-1}\right) = D_i \right\}$.

Aspect 2. A constraint condition on a selected line is designed. In other words, the selected line meeting a specific condition may be limited.

A possible condition is that when the $i^{th}$ line is selected from the bottom in the candidate line set M, a Hamming weight of a selected line v is greater than or equal to $D_i$, that is, $wt(v) \geq D_i$.

In another possible condition, the line $v$ from the candidate line set M is selected. If $c \in C_{\overline{K}}^{(\varphi+1)} \oplus \overline{K}[\varphi]$, and $wt(c) < D_\varphi$, there is no need to continue the operation, the line $v$ is directly discarded, and a new line from the candidate line set M is selected. $\oplus$ indicates a logical operation, or an exclusive OR logical operation.

Another possible condition is that a line belongs to a same coset cannot be selected, or a line belongs to a same coset is not selected again.

It should be understood that the foregoing constraint condition listed for the candidate line set M and the selected line is merely an example for description, and are not limited thereto. For example, if another constraint condition for the candidate line set M or the selected line belongs to a variant form of the foregoing constraint condition, it is also applicable to this embodiment of this application.

For understanding, an algorithm procedure applicable to Solution 1 is described in the following. A possible algorithm procedure may include the following steps.

Step 1. Adjust a PDP to obtain one or more new PDPs.

In step 1, a given PDP may be manually adjusted. For example, during adjustment, the PDP may be made as close as possible to a PDP of an Arikan matrix

For example, for a $16 \times 16$ kernel $K_{16}$, the corresponding PDP is [1,2,2,2,2,4,4,4,4,6,6,8,8,8,8,16], $E(K_{16}) = 0.51828$, $\mu(K_{16}) = 3.346$, and $\phi(K_{16}) = 472$.

As described above, in this embodiment of this application, $E(K)$ indicates a polarization exponent. The polarization exponent may be used to measure convergence speed of the decoding performance, and a larger polarization exponent indicates a faster convergence speed, so that better decoding performance can be obtained even when the code length is short. $\mu(K)$ indicates a scaling exponent (scaling exponent), and the scaling exponent may indicate kernel matrix performance. $\phi(K)$ indicates complexity, that is, processing complexity of the kernel K. This is not described in the following.

The PDP is manually adjusted to obtain a PDP of a kernel $K'_{16}$ : $[1,2,2,4,2,2,4,4,6,6,8,8,4,8,8,16]$ ,

$$E\left(K'_{16}\right)=0.51828 \text{ , } \mu\left(K'_{16}\right)=3.45 \text{ , and } \phi\left(K'_{16}\right)=183 \text{ .}$$

For another example, a PDP corresponding to a 32×32 kernel $K'_{32}$ is $[1,2,2,2,2,4,4,4,6,2,4,4,6,6,8,4,8,4,8,8,8,12,12,12,12,$ 12, 16, 16, 16, 16, 16,32], $E\left(K'_{32}\right)=0.529$ ,

$$\mu\left(K'_{32}\right)=3.207 \text{ , and } \phi\left(K'_{32}\right)=6770 \text{ .}$$

The PDP is manually adjusted to obtain a PDP of a kernel $K_{32}$ : $[1,2,2,4,2,4,2,4,6,8,2,4,6,8,4,6,8,12,4,8,12,16,4,8,12,$ 16,8, 16,8, 16, 16,32], $E(K_{32}) = 0.5219$, $\mu(K_{32}) = 3.421$, and $\phi(K_{32})$ = 532.

It should be understood that the foregoing enumerated constructed new PDPs are merely examples for description, and a larger quantity of PDPs may be further constructed.

Step 2. For each new PDP, perform kernel construction method based on depth-first search.

One or more new PDPs may be obtained by manually adjusting the given PDP. On the basis of these new PDPs, kernel matrix construction method in the following based on the depth-first search can be performed for each new PDP.

(1) Select a given PDP: D and a line vector candidate set M (or candidate line set M).

(2) Construct the kernel matrix from the last but one line $\overline{K}[l-1]$. Weight of this line needs to be equal to the last value of D, that is, $D_{l-1} = d_H(\overline{K}[l-1],0)$.

(3) Construct the next line to the last $\overline{K}[l-2]$. This line needs to meet: $D_{l-2} = d_H(\overline{K}[l-2],\langle\overline{K}[l-1]\rangle)$.

(4) Construct the third line from the last $\overline{K}[l-3]$. This line needs to meet:

$$D_{l-3} = d_H\left(\overline{K}[l-3],\left\langle\overline{K}[l-2],\overline{K}[l-1]\right\rangle\right) .$$

(5) Continue the preceding steps. Similarly, the $i^{th}$ line from the last needs to meet:

$$D_{l-i} = d_H\left(\overline{K}[l-i],\left\langle\overline{K}[l-i+1],\ldots,\overline{K}[l-1]\right\rangle\right) .$$

In a process of constructing the kernel matrix, if a line that meets the foregoing conditions cannot be found in the candidate line set M, the process may be rolled back to a previous step, a new line $\overline{K}[l-i+1]$ is found, and then a subsequent process continues.

In the process of constructing the kernel matrix, when any one of the following conditions is met, the algorithm may be stopped or the kernel construction may be stopped: when an appropriate kernel matrix is found; or after lines of all candidate sets are searched while an algorithm that meets the conditions cannot be found to enable the algorithm to be continued.

A plurality of constructed kernel matrices may be obtained by performing the foregoing steps. Next, a best and most appropriate kernel matrix may be selected based on an actual requirement by comparing some parameters of these kernel matrices, such as a polarization exponent (for example, E(K)), a scaling exponent (for example $\mu(K)$,), and decoding complexity (for example $\phi(K)$,) of decoding a codeword encoded based on these kernel matrices. In addition, the algorithm of this method is simple, and the calculation is simple and easy to implement.

Further, one or more of constraint conditions in the following may be further added, for example, the constraint conditions in the foregoing Aspect 1 and Aspect 2, to reduce a quantity of attempts and duration.

Condition 1. Any kernel K may add the $i^{th}$ line to the $j^{th}$ line (j<i) through summation, so that the kernel K is converted into kernel $\overline{K}$ of $D_j = wt(K[i])$. In addition, the candidate line set M may be further set to:

$$M[i] = \left\{v_0^{l-1} \in F_2^l \mid wt\left(v_0^{l-1}\right) = D_i\right\} .$$

Condition 2. When the $i^{th}$ line is selected from the bottom in the candidate line set M, a Hamming weight of a selected line $v$ is greater than or equal to $D_i$, that is, $wt(v) \geq D_i$.

Condition 3: When the line $v$ is selected from the candidate line set M, and partial distance calculation is performed on the line $v$ and the constructed line, if $c \in C_{\overline{K}}^{(\varphi+1)} \oplus \overline{K}[\varphi]$ and $wt(c) < D_{\varphi}$, in this case, no further operation needs to be performed, the current $v$ is directly discarded, and a new line is selected from the candidate line set M.

For example, assuming that a 16x16 kernel $\overline{K}$ is constructed (that is, the currently constructed kernel is a 16x16 kernel $\overline{K}$), the lines that are constructed are as follows:

$$\overline{K}[11]_{=[1111111100000000]}$$

$$\overline{K}[12]_{=[1111000011110000]}$$

$$\overline{K}[13]_{=[1100110011001100]}$$

$$\overline{K}[14]_{=[1010101010101010]}$$

$$\overline{K}[15]_{=[1111111111111111]}$$

It is assumed that a line $\overline{K}[10]$ that meets $d_H(\overline{K}[10], \langle \overline{K}[11], \overline{K}[12], \overline{K}[13], \overline{K}[14], \overline{K}[15] \rangle) = 6$ is expected to be found. In this case, $v=[1111110000000000]$ is first selected from the candidate line set M. It may be found that, $c=v+\overline{K}[11]=[0000001100000000]$, and $wt(c) = 2 < 6$. In this case, there is no need to continue subsequent calculation of $d_H(v, \langle \overline{K}[11], \overline{K}[12], \overline{K}[13], \overline{K}[14], \overline{K}[15] \rangle)$, and the current $v$ is directly discarded.

Condition 4. A line that belongs to a same coset is not selected again.

When a line is selected from the candidate line set M to construct the kernel $\overline{K}$, if the line $v$ is selected, a coset $C_{\overline{K}}^{(\varphi)} \oplus v$ is calculated, that is, $\left\{ c \oplus v \mid c \in C_{\overline{K}}^{(\varphi)} \right\}$. It is assumed that $d_H\left(v, \left\langle C_{\overline{K}}^{(\varphi)} \right\rangle\right)$ is calculated. Next, $d_H\left(v', \left\langle C_{\overline{K}}^{(\varphi)} \right\rangle\right)$ needs to be calculated. If $v' \in C_{\overline{K}}^{(\varphi)} \oplus v$, then $d_H\left(v', \left\langle C_{\overline{K}}^{(\varphi)} \right\rangle\right) = d_H\left(v, \left\langle C_{\overline{K}}^{(\varphi)} \right\rangle\right)$. In other words, the line that belongs to the same coset is not selected again.

It should be understood that the foregoing understood Condition 1 to Condition 4 are merely examples for description, and are not limited thereto. For example, for the candidate line set M, or for the selected line, another constraint condition may be further designed, so that a quantity of attempts and duration may be reduced.

In addition, optionally, in a possible implementation, when the PDP is adjusted, the PDP may be adjusted in a direction in which the PDP is close to the PDP of the Arikan matrix It should be understood that adjusting the PDP in a direction close to the PDP of the arikan matrix is merely a possible adjustment manner. This is not limited herein. For example, a PDP of the constructed best kernel matrix is not necessarily a PDP which is most close to that of the arikan kernel matrix. For another example, when the best and most appropriate kernel matrix is selected, it is not necessary to select the kernel matrix whose PDP is closest to the PDP of the arikan kernel matrix.

The foregoing describes Solution 1 in detail, and a plurality of kernel matrices may be constructed by using Solution 1. Solution 2 is described in the following.

Solution 2. A plurality of kernel matrices whose dimensions are different from a dimension of the original kernel matrix are constructed by adjusting the dimension of the original kernel matrix.

Optionally, a plurality of kernel matrices with small dimensions are constructed based on an existing kernel matrix with a large dimension. Encoding is performed based on the kernel matrix whose dimension is small, so that lower decoding complexity can be provided while the same performance is ensured.

In a possible implementation, the plurality of kernel matrices with small dimensions may be constructed based on the existing kernel matrix with a large dimension by using a shortening (shortening) method. It should be understood that another algorithm that can construct a kernel matrix with a small dimension based on an existing kernel matrix with a dimension, or an algorithm that can implement a same function, is applicable to this embodiment of this application. For ease of understanding, the shortening algorithm is mainly used as an example for description in the following.

For understanding, an algorithm procedure applicable to Solution 2 is described in the following. A possible algorithm procedure may include the following steps.

Step 1. Consider an $l \times l$ kernel, that is, determine an original kernel matrix.

Step 2. Select a column $j \in [l]$.

Step 3. Add the $i^{th}$ line to all lines with 1 in the $j^{th}$ column, where i is a line corresponding to the last 1 in the column.

Step 4. Delete the $i^{th}$ line and the $j^{th}$ column to obtain an $(l\text{-}1) \times (l\text{-}1)$ kernel $K'$. It may be learned that $\phi(K') < \phi(K)$, that is, decoding complexity corresponding to a kernel with a small dimension is lower.

The kernel matrix constructed in the foregoing manner has lower decoding complexity, and the $(l\text{-}t) \times (l\text{-}t)$ kernel may be obtained by repeating the foregoing manner for $t$ times.

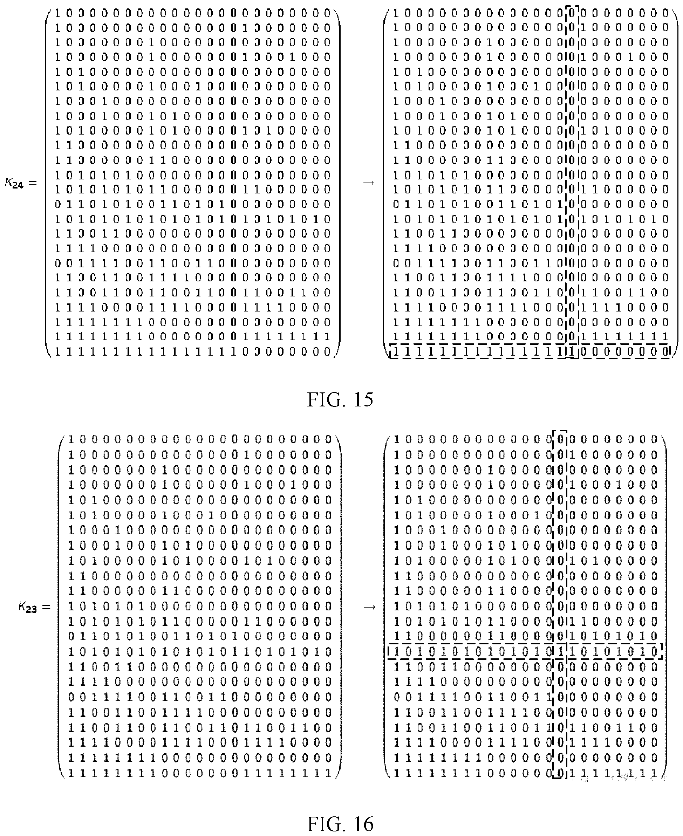

For ease of understanding, the following uses a kernel $K_{24}$ as an example to describe a specific example with reference to FIG. 15 to FIG. 19.

In a possible solution, an original kernel matrix is the kernel $K_{24}$ shown in FIG. 15. For a kernel $K_{24}$ whose dimension is $24 \times 24$, a polarization exponent of the kernel is $E(K_{24}) = 0.502911$, $\mu(K_{24}) = 3.61903$, and $\phi(K_{24}) = 374$. It is assumed that a new kernel whose dimension is $20 \times 20$ needs to be constructed based on the kernel $\overline{K}_{24}$. A specific process may be described in the following. In this embodiment of this application, it is assumed that both a line sequence number and a column sequence start from 0.

(1) Select the 15$^{th}$ column. It can be seen that only the last line (that is, line 23) in this column display a value 1. As shown in FIG. 15, the 15$^{th}$ column and the 23rd line may be deleted to obtain $K_{23}$. As shown in FIG. 15, the 15$^{th}$ column and the 23rd line are framed by using dashed boxes.

(2) Select the 14$^{th}$ column, the 13$^{th}$ line and the 14$^{th}$ line in this column display the value 1. As shown in FIG. 16, the 14$^{th}$ line may be added to the 13$^{th}$ line, so that a result of the 13$^{th}$ line is changed. The 14$^{th}$ column and the 14$^{th}$ line are deleted to obtain $K_{22}$. In FIG. 16, the 14$^{th}$ column and the 14$^{th}$ line are framed by using dashed boxes.

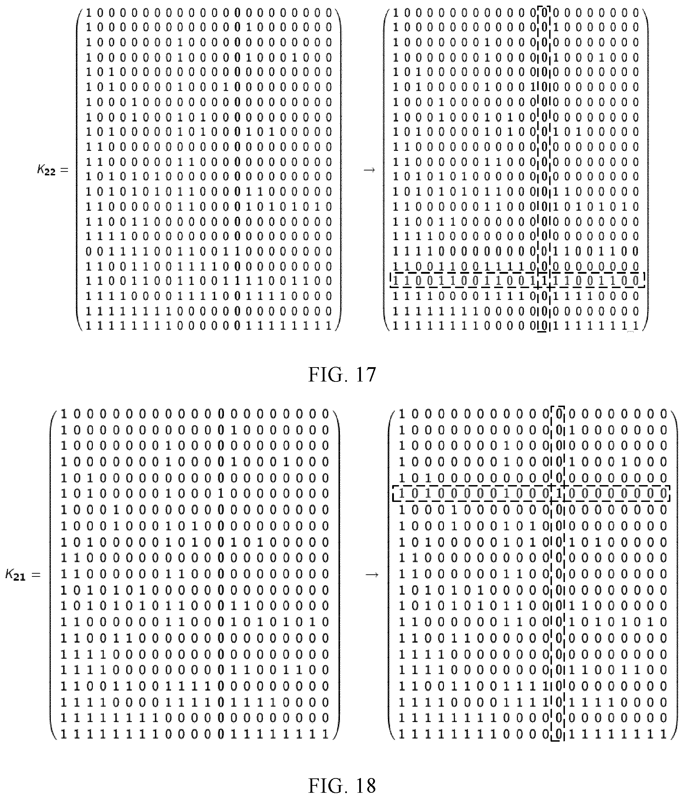

(3) Select the 13$^{th}$ line, the 16$^{th}$ line and the 18$^{th}$ line in this column display the value 1. As shown in FIG. 17, the 18$^{th}$ line may be added to the 16$^{th}$ line, so that a result of the 16$^{th}$ line is changed. The 13$^{th}$ column and the 18$^{th}$ line are deleted to obtain $K_{21}$. In FIG. 17, the 13$^{th}$ column and the 18$^{th}$ line are framed by using dashed boxes.

(4) Select the 12$^{th}$ column, the 5$^{th}$ line in this column displays the value 1. As shown in FIG. 18, the 12$^{th}$ column and the 5$^{th}$ line may be deleted to obtain $K_{20}$. In FIG. 18, the 12$^{th}$ column and the 5$^{th}$ line are framed by using dashed boxes.

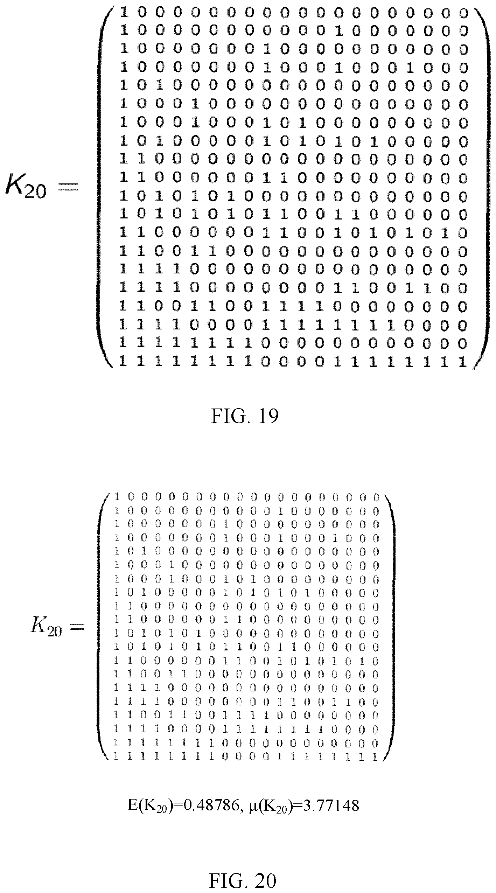

Through the foregoing processing, a kernel matrix $K_{20}$ shown in FIG. 19 may be obtained.

Alternatively, a kernel matrix constructed based on the kernel $K_{24}$ may include one or more of the following: the kernel $K_{23}$ shown in FIG. 16, the kernel $K_{22}$ shown in FIG. 17, the kernel $K_{21}$ shown in FIG. 18, and the kernel $K_{20}$ shown in FIG. 19. In an actual communication process, after comprehensive consideration, for example, performance and complexity, an appropriate kernel matrix may be selected from the foregoing plurality of kernel matrices based on an actual situation.

It should be understood that the foregoing is merely an example for ease of understanding, and an intermediate processing process may also have other variations. This is not limited herein.

When a same decoding algorithm is used, decoding complexity of the kernel matrix obtained by using the foregoing method is lower, for example, $\phi(K_{20}) < \phi(K_{24})$. Based on this, after comprehensive consideration, for example, performance and complexity, the kernel matrix may be selected based on an actual situation.

The foregoing describes the kernel matrix construction method provided in embodiments of this application with reference to Solution 1 and Solution 2. It should be understood that Solution 1 and Solution 2 may be used separately, or may be used in combination. This is not limited herein.

As an example, the following lists forms of several kernel matrices constructed by using this embodiment of this application.

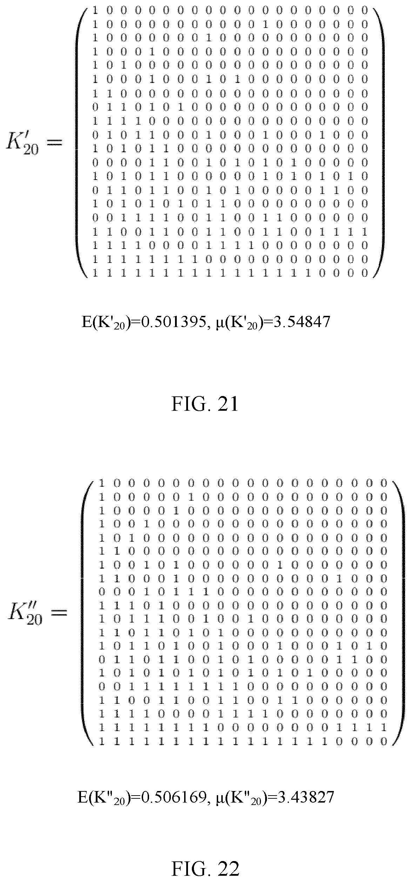

For example, a kernel matrix whose dimension is 20 may be shown in FIG. 20 to FIG. 22.

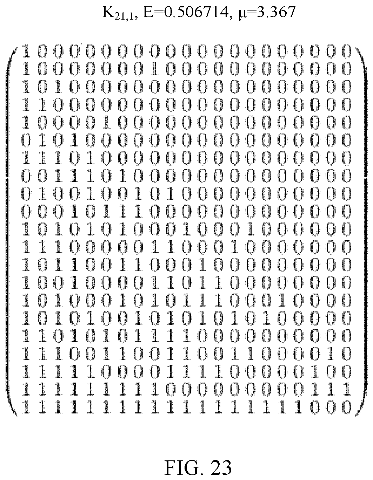

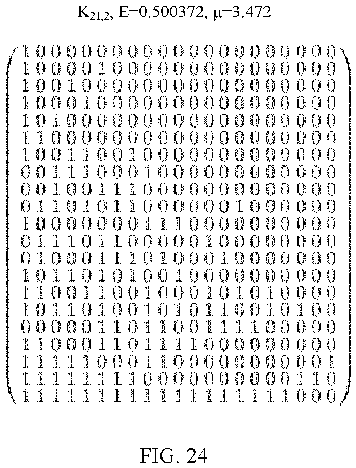

In still another example, a kernel matrix whose dimension is 21 may be shown in FIG. 23 and FIG. 24.

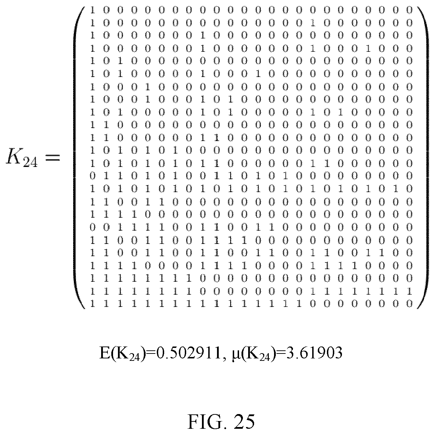

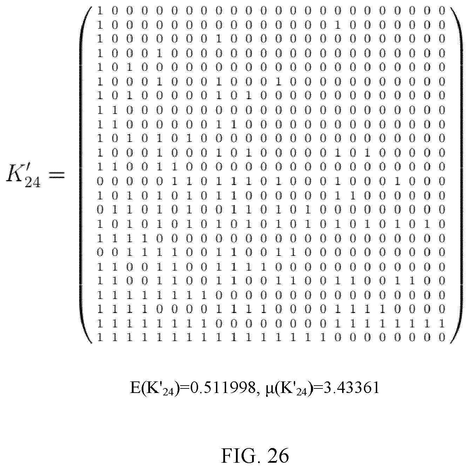

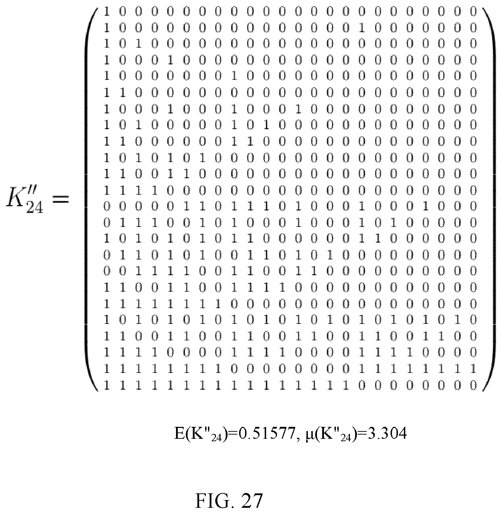

In still another example, a kernel matrix whose dimension is 24 may be shown in FIG. 25 to FIG. 27.

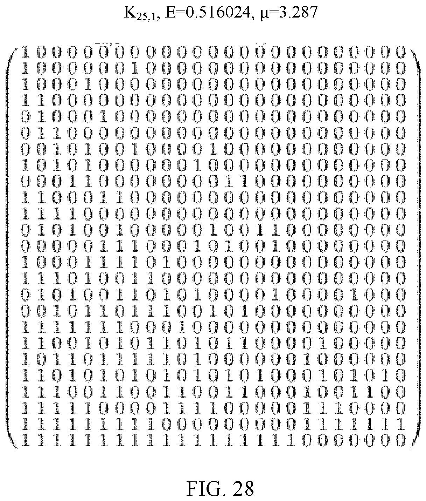

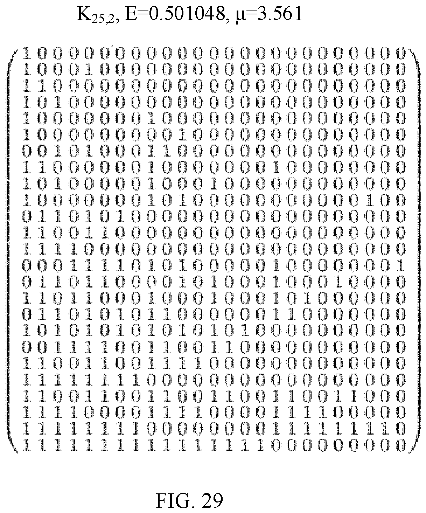

In still another example, a kernel matrix whose dimension is 25 may be shown in FIG. 28 and FIG. 29.

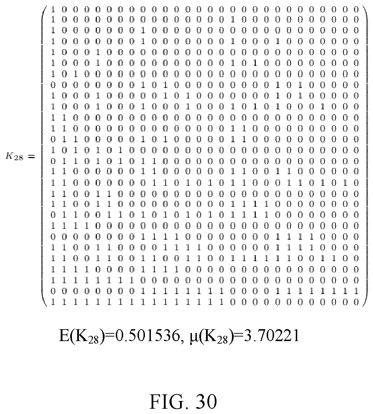

In still another example, a kernel matrix whose dimension is 28 may be shown in FIG. 30.

In still another example, a kernel matrix whose dimension is 32 may be shown in FIG. 10.

It should be understood that the kernel matrices listed in FIG. 20 to FIG. 30 are merely examples for description, and are not limited thereto.

Based on the encoding method provided in this embodiment of this application, when polar encoding is used, a plurality of kernel matrices may be first constructed, for example, the plurality of kernel matrices are constructed by using Solution 1 and/or Solution 2. Based on the constructed kernel matrices, an appropriate kernel matrix is selected for encoding based on an actual communication situation. In this manner, when the kernel matrix is constructed or selected, performance and decoding complexity are comprehensively considered, so that decoding complexity can be reduced by selecting the appropriate kernel matrix used during encoding.

Decoding Side

As described above, when decoding is performed based on trellis, a trellis diagram may be first split, and the decoding based on a complete trellis is split into decoding based on a sub-trellis (sub-trellis). Then, an optimal path can be selected by combining the intermediate results of decoding based on each small trellis diagram.

For example, a plurality of combinations are obtained after all possible paths in a trellis of a smaller level are spliced, and an optimal path and a path value of a trellis of a larger level are obtained by selecting a path with a largest score in these possible combinations.

For ease of understanding, the following shows a possible algorithm procedure. A possible algorithm procedure may include content in the following several aspects.

Aspect 1. Trellis splitting of a linear block code.

In this embodiment of this application, multi-level splitting is performed on a trellis diagram of each stage t during polar code decoding.

It is assumed that a linear code C (8, 4) is given, and a generator matrix of the linear code C is

$$G = \begin{pmatrix} 1 & 1 & 1 & 1 & 1 & 1 & 1 & 1 \\ 1 & 1 & 1 & 1 & 0 & 0 & 0 & 0 \\ 1 & 1 & 0 & 0 & 1 & 1 & 0 & 0 \\ 1 & 0 & 1 & 0 & 1 & 0 & 1 & 0 \end{pmatrix}$$

. Let $C_{h,h'}$ be a subcode of the linear code C, and non-zero bits appear only in a location $h \le i < h'$; let $p_{h,h'}(C)$ be a linear code obtained by performing a puncturing (puncturing) operation on the linear code C at a location except $h \le i < h'$; and let $s_{h,h'}(C) = p_{h,h'}(C_{h,h'})$ be a code obtained by performing a shortening (shortening) operation on the linear code C at a location except $h \le i < h'$. For example, when $0 \le i < 4$, that is, h=0 and h'=4, the following may be obtained:

$$p_{0,4}(C) : G_{0,4}^{(p)} = \begin{pmatrix} 1 & 1 & 1 & 1 \\ 1 & 1 & 0 & 0 \\ 1 & 0 & 1 & 0 \end{pmatrix}$$

$$s_{0,4}(C) : G_{0,4}^{(s)} = \begin{pmatrix} 1 & 1 & 1 & 1 \end{pmatrix}.$$

On the trellis diagram, the path from a moment *h* to a moment *h'* corresponds to the coset $p_{h,h'}(C)/s_{h,h'}(C)$.

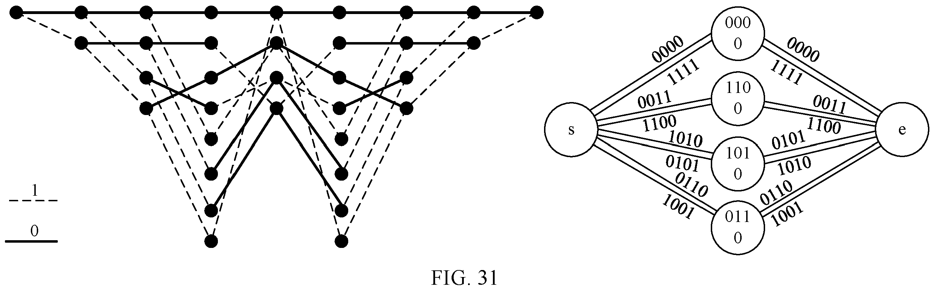

As shown in FIG. 31, the left figure shows a general trellis diagram of the (8, 4) code, and the right figure shows a splitting trellis diagram of the (8, 4) code. By calculating $p_{0,4}(C)/s_{0,4}(C)$ on the coset, four cosets may be obtained, which are respectively:

$$① \{(0000),(1111)\}$$

$$② \{(0011),(1100)\}$$

③ $\{(1010),(0101)\}$

④ $\{(0110),(1001)\}$

Based on a correspondence between the left half part of the left figure and the left half part of the right figure in FIG. 31, it can be learned that the left half part of the left figure and the left half part of the right figure each indicate a path from a moment 0 to a moment 4.

Aspect 2. Trellis decoding of linear block code

For each coset $D \in p_{h,h}(C)/s_{h,h}(C)$, the most likely entry $l(D)$ and its corresponding score need to found. For this, a composite branch table (composite branch table, CBT) may be defined to store the two values. It should be noted that a score corresponding to an entry may be represented by correlation discrepancy in the foregoing term explanation, for example, may be denoted as E(D). As an example, $CBT_{(x,y)}=(l(D),E(D))$. It should be noted that ML decoding is performed on an (n, k) code, that is, only one entry is included in $p_{0,n}(C)/s_{0,n}(C)$. Therefore, $CBT_{(0,n)}$ stores a corresponding path and a corresponding path value when the ML decoding is used.

It should be understood that the CBT is merely a name for ease of description, and the name does not limit the protection scope of embodiments of this application. In addition, that the CBT can include only two entries is not limited in this embodiment of this application. In actual communication, the CBT may further include another entry. This is not limited herein.

It should be further understood that the correlation discrepancy herein indicates a score corresponding to an entry (that is, the path $l(D)$), and another solution that may indicate a score (or a path value) corresponding to the entry is also applicable to this embodiment of this application.

Aspect 3. CBT construction.

It is assumed that $CBT_{x,y}$ is constructed, and y-x≥2. Then, for a specific z (x<z<y), $CBT_{x,z}$ and $CBT_{z,y}$ may be constructed. For $D_y \in p_{x,y}(C)/s_{x,y}(C)$, all cosets of $D' \in p_{x,z}(C)/s_{x,z}(C)$ and $D'' \in p_{z,y}(C)/s_{z,y}(C)$ may be enumerated.

$$E(D) = \max_{\substack{D',D'' \\ D'.D''=D_y}} \left( E(D') + E(D'') \right)$$

may be obtained.

It can be seen that a path [x, y] is truncated into two parts. In this case, for the construction of $CBT_{x,y}$, it may not be necessary to enumerate all $D_y \in p_{x,y}(C)/s_{x,y}(C)$, and the $CBT_{x,y}$ may be obtained by using the foregoing truncation processing manner. This can reduce complexity.

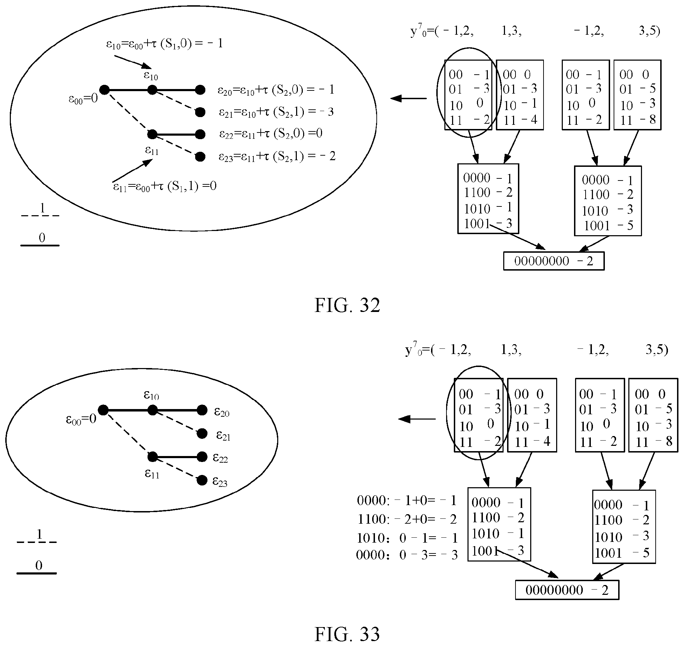

For ease of understanding, as an example, a process of decoding an (8, 4) Hamming code by using a trellis diagram splitting method is described in FIG. 32 to FIG. 34. It is assumed that for the Hamming code (8, 4), after channel transmission, a received signal at a receive end is $y_0^7 = (-1, 2, 1, 3, -1, 2, 3, 5)$. The trellis diagram corresponding to a code whose length is 8 is split. As shown in FIG. 32, the trellis diagram may be split into four subcodes whose lengths are 2, and the four subcodes whose lengths are 2 are respectively corresponding to one sub-trellis diagram.

FIG. 32 shows a corresponding path and a path value calculation process of an [0, 1] segment. As shown in FIG. 32, for the [0, 1], a corresponding path and the path value of the [0, 1] segment may be obtained through the following calculation:

For

$\varepsilon_{20}$, $\varepsilon_{20} = \varepsilon_{10} + \tau(S_2, 0) = -1$.

For

$$\varepsilon_{21}, \quad \varepsilon_{21} = \varepsilon_{10} + \tau\left(S_2, 1\right) = -3 \quad .$$

For

$$\varepsilon_{22}, \quad \varepsilon_{22} = \varepsilon_{11} + \tau\left(S_2, 0\right) = 0 \quad .$$

For

$$\varepsilon_{23}, \quad \varepsilon_{23} = \varepsilon_{11} + \tau\left(S_2, 1\right) = -2 \quad .$$

Similarly, [2, 3], [4, 5], [6, 7], and their corresponding sub-trellis diagrams may all be represented, and various possible paths, that is, path values, are calculated by using a similar method.

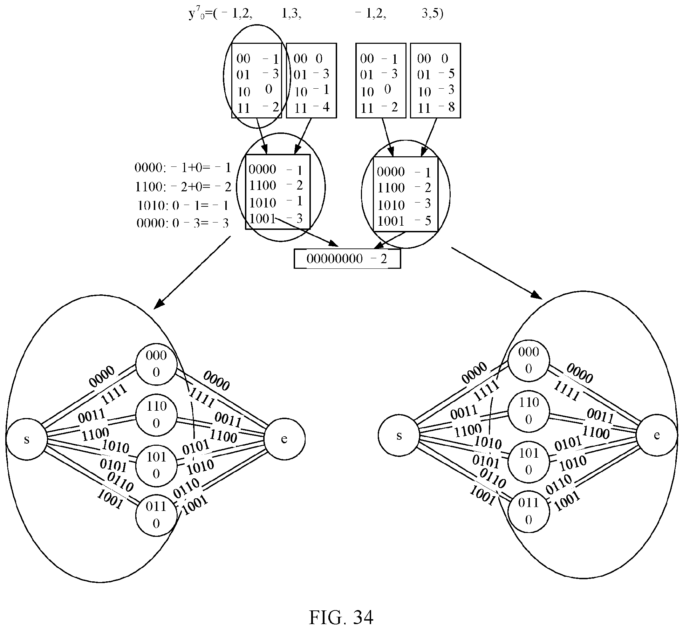

Next, an [0, 3] segment may be obtained by combining corresponding paths of the [0, 1] and the [2, 3]. For example, a path with the largest path score may be selected as a path of the [0, 3] segment, for example, a part enclosed by dashed lines in FIG. 33. Similarly, a right [4, 7] segment may also be obtained by using a same operation. Finally, an entire part of [0, 7] may be obtained by combining the [0, 3] and the [4, 7], for example, may be obtained by using a path whose path score is the largest in various possible combinations of the [0, 3] and the [4, 7], as shown in FIG. 34.

In this embodiment of this application, an appropriate location of the split point may be selected based on an actual situation. The location of the split point may affect decoding complexity. Take a kernel 24×24 as an example. For a selection of z (z: x<z<y):

For example, splitting is evenly performed. To be specific, z=(x + y)/2. In this case, 715 times of summations (summations) and 449 times of comparisons (comparison) may be required.

In still another example, splitting is performed according to an optimization algorithm. For example, [0, 24) is divided into [0, 16) and [16, 24), and is further evenly split. In this case, 250 times of summations and 124 times of comparisons may be required.

Therefore, in actual communication, a location of the split point may be selected based on the complexity, for example, some split points may be selected, so as to reduce decoding complexity.

Aspect 4. A nested code and a nested generator matrix

According to the foregoing definition, it may be learned that $s_{x,y}(C) \in p_{x,y}(C)$, and a generator matrix of $p_{x,y}(C)$ is represented as:

$$G_{x,y}^{(p)} = \begin{pmatrix} G_{x,z}^{(s)} & 0 \\ 0 & G_{z,y}^{(s)} \\ \hline G_{x,y}^{(00)} & G_{x,y}^{(01)} \\ G_{x,y}^{(10)} & G_{x,y}^{(11)} \end{pmatrix} .$$

A generator matrix of $s_{x,y}(C)$ is represented as:

$$G_{x,y}^{(s)} = \begin{pmatrix} G_{x,z}^{(s)} & 0 \\ 0 & G_{z,y}^{(s)} \\ G_{x,y}^{(00)} & G_{x,y}^{(01)} \end{pmatrix} .$$

Aspect 5. Recursive trellis decoding.

There is a one-to-one correspondence between a coset $D \in p_{x,y}(C)/s_{x,y}(C)$ and a vector $vG'_{x,y}$ .

$G'_{x,y} = \begin{pmatrix} G^{(10)}_{x,y} & G^{(11)}_{x,y} \end{pmatrix}$ is a matrix of $k'_{x,y} \times (y-x)$ . Let $CBT_{x,y}[v].l:=I(D)$, and $CBT_{x,y}[v].e:=E(D)$, and then:

$$CBT_{x,y}[v].e = \max_{w \in F_2^{k''_{x-y}}} \left( CBT_{x,z}[a].e + CBT_{z,y}[b].e \right),$$

and $v \in F_2^{k''_{x,y}}$ .

$a$ and $b$ respectively indicate sequence numbers (which may be represented in binary) of corresponding entries in coset $D' \in p_{x,z}(C)/s_{x,z}(C)$ and the coset $D'' \in p_{z,y}(C)/s_{z,y}(C)$. If w and v indicate a sequence number corresponding to a possible path [x,y] segment, then:

$$\left( w, v \right) \begin{pmatrix} G^{(00)}_{x,y} \\ G^{(10)}_{x,y} \end{pmatrix} \in D' \quad , \text{ and } \quad \left( w, v \right) \begin{pmatrix} G^{(01)}_{x,y} \\ G^{(11)}_{x,y} \end{pmatrix} \in D'' \quad .$$

In this case, $a$ and $b$ may be obtained by using the following mapping relationship:

$$\left( a', a \right) \begin{pmatrix} G^{(s)}_{x,z} \\ G'_{x,z} \end{pmatrix} = \left( w, v \right) \begin{pmatrix} G^{(00)}_{x,y} \\ G^{(10)}_{x,y} \end{pmatrix} \Rightarrow a = \begin{pmatrix} w & v \end{pmatrix} \widehat{G}_{x,y}$$

$$\left( b', b \right) \begin{pmatrix} G^{(s)}_{z,y} \\ G'_{z,y} \end{pmatrix} = \left( w, v \right) \begin{pmatrix} G^{(01)}_{x,y} \\ G^{(11)}_{x,y} \end{pmatrix} \Rightarrow b = \begin{pmatrix} w & v \end{pmatrix} \tilde{G}_{x,y} \quad .$$

a' and b' are unimportant parameters. According to the foregoing formula, the following may be obtained:

$$CBT_{x,y}[v].e = \max_{w \in F_2^{k''_{x-y}}} \left( CBT_{x,z}\left[ \begin{pmatrix} w & v \end{pmatrix} \widehat{G}_{x,y} \right].e + CBT_{z,y}\left[ \begin{pmatrix} w & v \end{pmatrix} \tilde{G}_{x,y} \right].e \right)$$

and $v \in F_2^{k''_{x,y}}$ .

Complexity of the foregoing calculation is approximately $O\left( 2^{k'_{x,y} + k''_{x,y}} \right)$ . Complexity of this method is related to a splitting policy, that is, how to select a split point z from x, y may affect decoding complexity.

Aspect 6. A kernel processing method based on a recursive trellis.

As an example, let $u_0^{t-1} = 0$ . It can be learned from the foregoing that $\varepsilon\left( c^{(0)}, y_0^{l-1} \right)$ , and $\varepsilon\left( c^{(1)}, y_0^{l-1} \right)$ are entries (entries) of $CBT_{0,l}(\overline{C}^{(t)})$, and may be obtained through recursion by using the following formula:

$$CBT_{x,y}[v].e = \max_{w \in F_2^{k''_{x-y}}} \left( CBT_{x,z}[a].e + CBT_{z,y}[b].e \right)$$

$$= \max_{w_0} \max_{w_1} \cdots \max_{w_{k''_{x-y}}} \left( CBT_{x,z}[a].e + CBT_{z,y}[b].e \right)$$

$$a = \begin{pmatrix} w & v \end{pmatrix} \hat{G}_{x,y}$$ , and $b = (w\ v)\tilde{G}x,y$. Sequence numbers of CBT entries are represented by $v$, $a$, and $b$. $k' = \dim p_{x,y}(C)$, and $k'' = \dim s_{x,y}(C)$.

Optionally, decoding complexity may be further simplified through processing in the decoding.

Manner 1. Reuse an intermediate decoding result.

In a possible design, whether an intermediate result obtained from decoding performed based on a trellis can be reused by decoding performed based on another trellis is determined based on a correlation between trellises.

In an example, when the correlation between the trellises is large, for example, when trellises are similar or the same, or when a specific condition is met, a decoding result obtained through decoding performed based on the trellis may be directly used during the decoding performed based on another trellis. For example, a combination CBT of all parts in the polar code decoding stage $t$ is the same as a CBT in $t+1$ stage. In this case, no calculation needs to be performed again in the stage $t+1$.

Optionally, whether a result of each decoding stage can be reused may be determined based on a code obtained by performing a shortening operation on the linear code C in different decoding stages and/or a code obtained by performing a puncturing operation on the linear code C in different decoding stages. In other words, a correlation between trellises may be determined based on a code obtained by performing a shortening operation on the linear code C in different decoding stages and/or a code obtained by performing a puncturing operation on the linear code C in different decoding stages, so as to determine whether a result of each decoding stage can be reused.

In a possible implementation, whether the intermediate decoding result can be reused may be determined by checking a relationship between $p_{x,y}(C^{(t+1)})$ and $p_{x,y}(C^{(t)})$ and/or a relationship between $s_{x,y}(C^{(t+1)})$ and $s_{x,y}(C^{(t)})$.

Case 1. When $s_{x,y}(C^{(t+1)})=s_{x,y}(C^{(t)})$ and $p_{x,y}(C^{(t+1)}) \subset p_{x,y}(C^{(t)})$, the intermediate decoding result may be reused. In other words, if $s_{x,y}(C^{(t+1)})=s_{x,y}(C^{(t)})$ and $p_{x,y}(C^{(t+1)}) \subset p_{x,y}(C^{(t)})$, the CBT in the stage $t+1$ may be a subset of the CBT in the stage $t$, and may be directly obtained without recalculation.

Case 2. When $s_{x,y}(C^{(t+1)}) \subset s_{x,y}(C^{(t)})$, the intermediate decoding result may be reused. For example, a maximization operation result in the intermediate process may be saved to reduce the calculation amount in the stage $t+1$.

Manner 1 may be used in each stage of polar code decoding. For example, in each stage of polar code decoding, whether the foregoing two cases are met may be determined.

Manner 2. Simplify calculation workload.

In a possible design, a same value may be subtracted from entries (entry) of all CBTs, while the processing does not affect a final result. For understanding, specific examples are listed in the following.

In an example, for $k' = 2$, $k'' = 1$, consider calculating:

$$CBT_{x,y}[0].e = \max \left( CBT_{x,z}[0].e + CBT_{z,y}[0].e, CBT_{x,z}[1].e + CBT_{z,y}[1].e \right)$$

$$CBT_{x,y}[1].e = \max \left( CBT_{x,z}[0].e + CBT_{z,y}[1].e, CBT_{x,z}[1].e + CBT_{z,y}[0].e \right)$$

$$\Delta = CBT_{x,y}[0].e - CBT_{x,y}[1].e = L_{x,z} \boxplus L_{z,y}$$

It can be seen that:

$$\Delta = CBT_{x,y}[0].e - CBT_{x,y}[1].e = L_{x,z} \boxplus L_{z,y}$$

$L_{p,q} = CBT_{p,q}[0].e - CBT_{p,q}[1].e$ and

$$a \boxplus b = \text{sgn}(a)\text{sgn}(b)\min(|a|, |b|)$$

For example, $CBT_{x,y}[0].e = \Delta$ and $CBT_{x,y}[1].e = 0$ may be set. In this case, only three operations are required. Compared with a direct method (the direct method requires six operations), a lot of calculation amounts can be reduced, and decoding duration can be reduced.

For another example, if $CBT_{p,q}[1].e = 0$, the calculation amount may be further reduced, for example, two subtractions may be eliminated.

In yet another example, for $k' = 1$, $k'' = 0$, consider calculating:

$$CBT_{x,y}[v].e = CBT_{x,z}[v].e + CBT_{z,y}[v].e, \quad v \in \{0,1\}$$

If it can be guaranteed that for any channel vector $CBT_{x,z}[1].e = CBT_{z,y}[v].e = 0$, $CBT_{x,z}[1].e = 0$ may be set. In this case, only one summation is required.

It should be understood that, in kernel processing, the manner of reducing the calculation amount through some calculation processing is applicable to this embodiment of this application.

When many different kernels are processed, in the foregoing Manner 2, the calculation amount can be greatly reduced, and the decoding duration can be reduced.

In the foregoing Aspect 6, $u_0^{t-1} = 0$ is mainly used as an example for description. When $u_0^{t-1} \neq 0$, the formula $CBT_{x,y}[v].e$ needs to be replaced with the following formula:

$$CBT_{x,y}[v].e = \max_{w \in F_2^{k''_{x-y}}} \left( CBT_{x,z}[a + \delta'].\varepsilon + CBT_{z,y}[b + \delta''].\varepsilon \right)$$

$\delta'$, and $\delta''$ indicate offsets, that is, $\delta'$ and $\delta''$ are offsets depending on $u_0^{t-1}$.

The foregoing describes the solutions in the decoder in detail with reference to Aspect 1 to the Aspect 6. For understanding, the following uses specific examples for description.

Example 1. A kernel processing on an Arikan matrix with two iterations.

Let

$$K = M(2)_{F_2}^{\otimes 2} = \begin{pmatrix} 1 & 0 & 0 & 0 \\ 1 & 0 & 1 & 0 \\ 1 & 1 & 0 & 0 \\ 1 & 1 & 1 & 1 \end{pmatrix}$$

$$K^{(0)} = \begin{pmatrix} 1 & 0 & 0 & 0 & 1 \\ 1 & 0 & 1 & 0 & 0 \\ 1 & 1 & 0 & 0 & 0 \\ 1 & 1 & 1 & 1 & 0 \end{pmatrix}$$

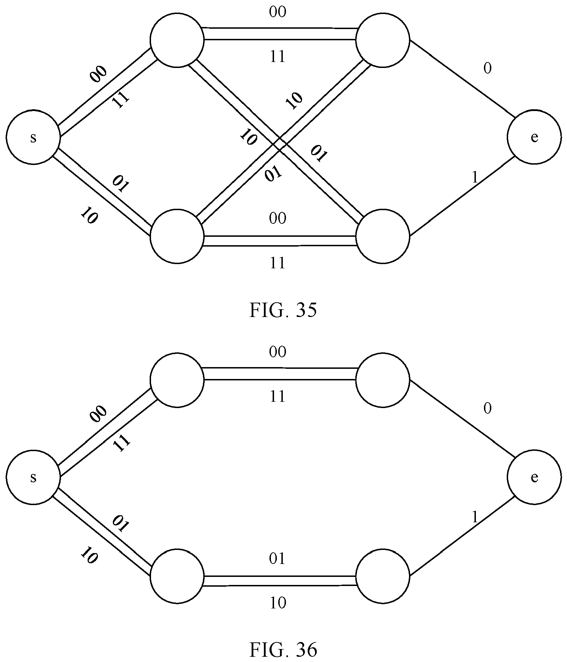

FIG. 35 is used as an example. For $C^{(0)}$,

It can be known that $p_{0,4}(C^{(0)})$ is a (4, 4) code and $s_{0,4}(C^{(0)})$ is a (4, 3) code. It may be obtained through calculation that leaders of a coset $p_{0,4}(C^{(0)})/s_{0,4}(C^{(0)})$ are (0,0,0,0) and (1,0,0,0).

$p_{0,2}(C^{(0)})$ and $p_{2,4}(C^{(0)})$ are (2, 2) codes, and $s_{0,2}(C^{(0)})$ and $s_{2,4}(C^{(0)})$ are (2, 1) codes. A state at a moment 2 is: $S_2 (0,0,0,0) = \{(0,0)\}$ and $S_2 (1,0,0,0) = \{(1,0)\}$. Therefore, the following formula may be obtained:

$$CBT_{0,2}^{(0)} = \left[ \max\left(e_{0,0} + e_{0,1},\, e_{1,0} + e_{1,1}\right),\, \max\left(e_{1,0} + e_{0,1},\, e_{0,0} + e_{1,1}\right)\right]$$

$$CBT_{2,4}^{(0)} = \left[ \max\left(e_{0,2} + e_{0,3},\, e_{1,2} + e_{1,3}\right),\, \max\left(e_{1,2} + e_{0,3},\, e_{0,2} + e_{1,3}\right)\right]$$

$$CBT_{0,4}^{(0)} = [\max\left(CBT_{0,2}^{(0)}[0] + CBT_{2,4}^{(0)}[0],\, CBT_{0,2}^{(0)}[1] + CBT_{2,4}^{(0)}[1]\right),$$
$$\max\left(CBT_{0,2}^{(0)}[0] + CBT_{2,4}^{(0)}[1],\, CBT_{0,2}^{(0)}[1] + CBT_{2,4}^{(0)}[0]\right)]$$

$$e_{i,j} = \tau\left(S\left(y_j\right), i\right)$$

$$K^{(1)} = \begin{pmatrix} 1 & 0 & 1 & 0 & 1 \\ 1 & 1 & 0 & 0 & 0 \\ 1 & 1 & 1 & 1 & 0 \end{pmatrix}$$

FIG. 36 is used as an example. For $C^{(1)}$,

It may be known that $p_{x,x+2}(C^{(1)}) = p_{x,x+2}(C^{(0)})$, $s_{x,x+2}(C^{(1)}) = s_{x,x+2}(C^{(0)})$, $x \in \{0,2\}$, $p_{0,4}(C^{(1)})$ is a (4, 3) code and $s_{0,4}(C^{(1)})$ is a (4, 2) code. Vectors (0,0,0,0) and (1,0,1,0) in the coset of the (4, 3) code and the (4, 2) code are considered. It is assumed that $u_0 = 0$, the following formula may be obtained:

$$CBT_{0,4}^{(0)} = \left[ \max\left(CBT_{0,2}^{(0)}[0] + CBT_{2,4}^{(0)}[0],\, CBT_{0,2}^{(0)}[1] + CBT_{2,4}^{(0)}[1]\right)\right]$$

$$K^{(2)} = \begin{pmatrix} 1 & 1 & 0 & 0 & 1 \\ 1 & 1 & 1 & 1 & 0 \end{pmatrix}$$

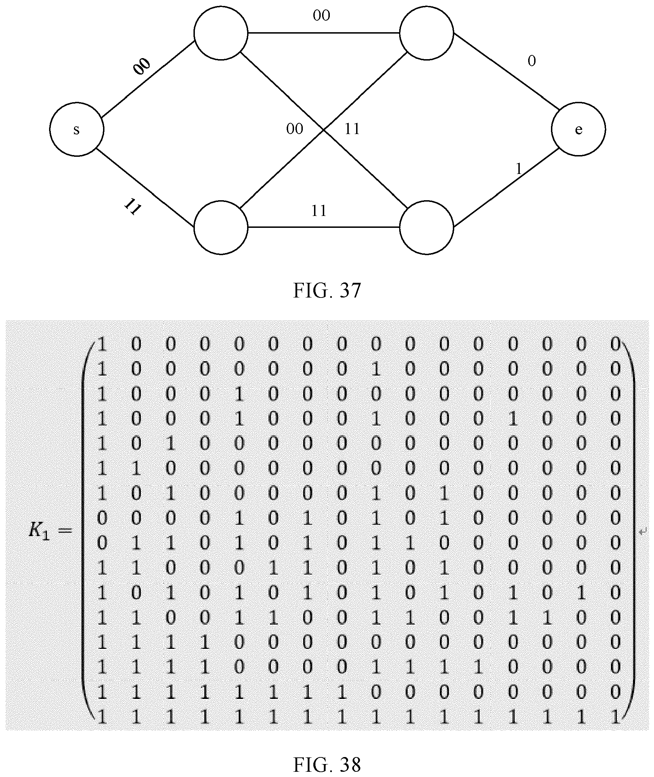

FIG. 37 is used as an example. For $C^{(2)}$,

It may be known that: $p_{0,2}(C^{(2)})$ and $p_{2,4}(C^{(2)})$ are (2, 1) codes; $s_{0,2}(C^{(2)})$ and $s_{2,4}(C^{(2)})$ are (2, 0) codes; $p_{0,4}((C^{(2)})$ is a (4, 2) code, and $s_{0,4}(C^{(2)})$ is a (4, 1) code. Vectors (0,0,0,0) and (1,1,0,0) in the coset are considered. Therefore, $S_2(0,0,0,0)=\{(0,0)\}$ and $S_2(1,1,0,0)=\{(1,1)\}$. Therefore, only the coset (0, 0) and (1, 1) of the (2, 0) code need to be considered. Assume $u_0 = u_1 = 0$, the following may be obtained:

$$CBT_{0,2}^{(0)} = \left[e_{0,0} + e_{0,1},\, e_{1,0} + e_{1,1}\right] \text{, and } CBT_{2,4}^{(0)} = \left[e_{0,2} + e_{0,3},\, e_{1,2} + e_{1,3}\right]$$

$$CBT_{0,4}^{(2)} = [\max\left(CBT_{0,2}^{(2)}[0] + CBT_{2,4}^{(2)}[0],\, CBT_{0,2}^{(2)}[1] + CBT_{2,4}^{(2)}[1]\right),$$
$$\max\left(CBT_{0,2}^{(2)}[0] + CBT_{2,4}^{(2)}[1],\, CBT_{0,2}^{(2)}[1] + CBT_{2,4}^{(2)}[0]\right)]$$

For $C^{(3)}$, $K^{(3)} = (1\ 1\ 1\ 1\ 1)$.

It may be known that: $p_{0,2}(C^{(3)}) = p_{0,2}(C^{(2)}) = p_{2,4}(C^{(2)}) = p_{2,4}(C^{(3)})$ is a (2, 1) code, $s_{0,2}(C^{(2)})$ and $s_{2,4}(C^{(2)})$ are (2, 0) codes, $p_{0,4}(C^{(3)})$ is a (4, 1) code, and $s_{0,4}(C^{(4)})$ is a (4, 0) code. The following may be obtained:

$$CBT_{0,4}^{(3)} = \left[ CBT_{0,2}^{(2)}[0] + CBT_{2,4}^{(2)}[0],\, CBT_{0,2}^{(2)}[1] + CBT_{2,4}^{(2)}[1]\right]$$

The kernel processing on an Arikan matrix with two iterations is described above as an example. The foregoing specific kernel processing is merely an example for description, and is not strictly limited thereto.

Example 2. A kernel processing on a high-dimensional kernel matrix.

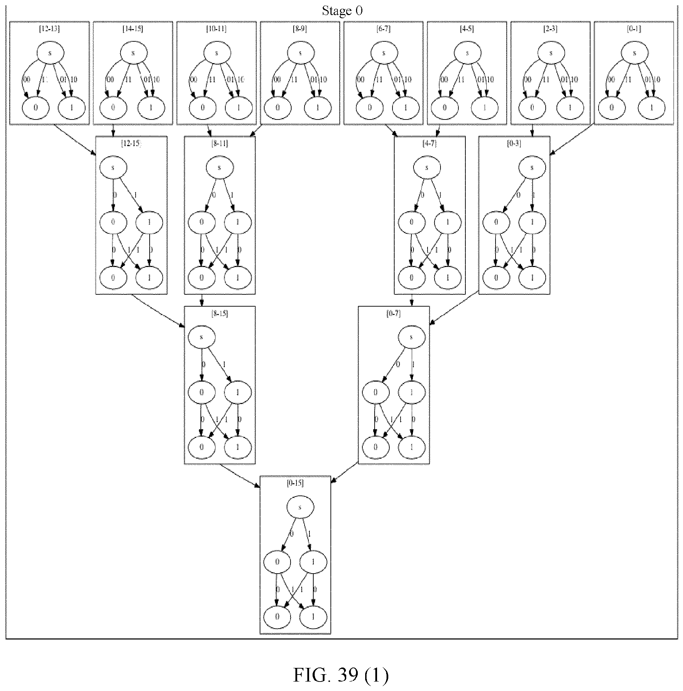

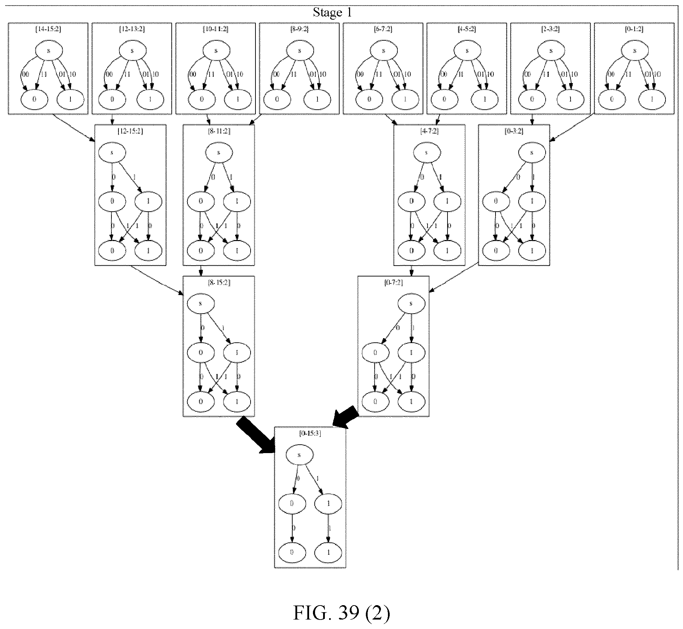

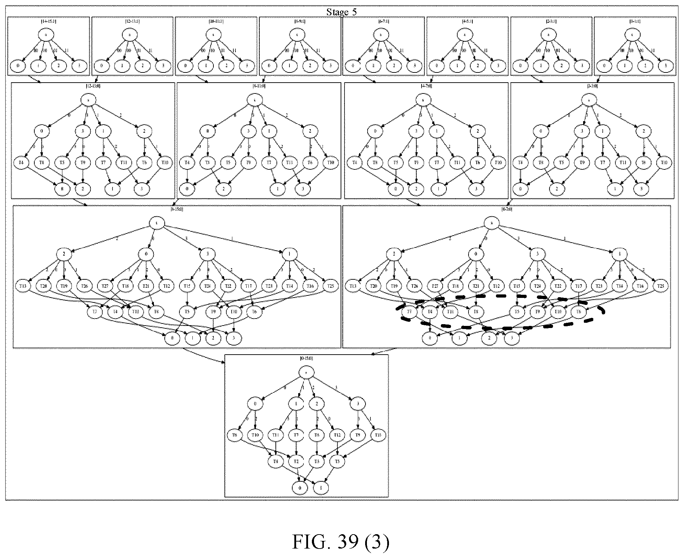

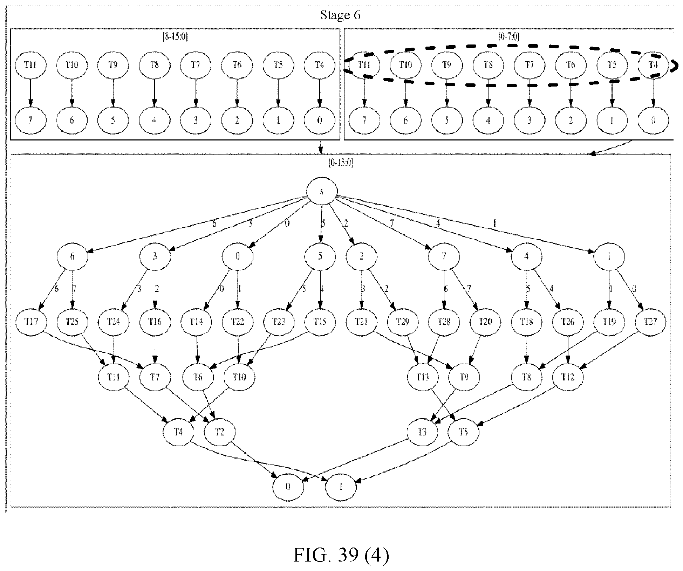

SC decoding is used as an example. The decoding method based on a recursive trellis may be applied to each stage of the SC decoding of the polar code. It is assumed that a kernel matrix $K_1$ is shown in FIG. 38. The polar code is decoded based on the decoding method provided in this embodiment of this application. FIG. 39 shows a partial recursive trellis diagram corresponding to the kernel.

In some cases, for example, $s_{x,y}(C^{(t+1)})=s_{x,y}(C^{(t)})$ and $p_{x,y}(C^{(t+1)}) \subset p_{x,y}(C^{(t)})$, the CBT in the stage t+1 may be a subset of the CBT in the stage t, and may be directly obtained without recalculation. It can be learned from FIG. 39 (1) and FIG. 39 (2) that, in a t=1 stage during decoding, except a part indicated by a bold arrow, trellises of other parts are completely the same as those in a t=0 stage. This indicates that when decoding is performed in the t=1 stage, a result in the t=0 stage can be reused as an intermediate result, and calculation may not be performed again. It can be learned that a large amount of calculation is reduced.

In some cases, for example, when $s_{x,y}(C^{(t+1)}) \subset s_{x,y}(C^{(t)})$, the intermediate result of decoding may be reused. For example, a maximization operation result in the intermediate process may be saved to reduce the calculation amount in the stage t+1. It can be learned from FIG. 39 (3) and FIG. 39 (4) that a comparison operation (the result of the maximization selection operation) in the middle of decoding in a t=5 stage may be reused in a t=6 stage, thereby reducing the calculation amount.

According to the decoding method provided in this embodiment of this application, in different stages of polar code decoding, if a step that is calculated in a previous stage reappears in a subsequent stage, a previous calculation result is directly reused. This can greatly reduce polar decoding complexity.

Table 1 shows complexity comparison between the decoding algorithm provided in this embodiment of this application and a Viterbi decoding algorithm when different kernel matrices are used on an encoding side.

**Table 1**

| Kernel (Kernel) | Viterbi Decoding Algorithm | | Decoding Algorithm in This Embodiment of This Application | |
|---|---|---|---|---|
| | summation | comparison | summation | comparison |
| $K_{20}$ | 1189 | 2392 | 497 | 309 |
| $K'_{20}$ | 3346 | 6714 | 1685 | 1279 |
| $K''_{20}$ | 7524 | 15054 | 4051 | 3341 |
| $K_{24}$ | 2102 | 4218 | 715 | 449 |
| $K'_{24}$ | 4705 | 9424 | 2039 | 1483 |
| $K''_{24}$ | 10043 | 20100 | 5523 | 4371 |
| $K_{28}$ | 2865 | 5776 | 1005 | 671 |
| $K_{32}$ | 4536 | 9072 | 341 | 191 |

It can be learned from Table 1 that complexity of the decoding algorithm provided in this embodiment of this application is greatly reduced compared with the existing algorithm.

Optionally, this embodiment of this application may be used not only in a binary domain, but also in a non-binary domain. Table 2 shows complexity comparison between the decoding algorithm provided in this embodiment of this application and the Viterbi decoding algorithm when different kernel matrices are used in the non-binary domain. Reed-Solomon indicates a Reed-Solomon code, and Hermitian indicates Hermitian.

**Table 2**

| Kernel (Kernel) | Viterbi Decoding Algorithm | | Decoding Algorithm in This Embodiment of This Application | |
|---|---|---|---|---|
| | summation | comparison | summation | comparison |
| 4x4 Reed-Solomon over GF ($2^2$) | 177 | 232 | 140 | 116 |
| 8x8 Reed-Solomon over GF ($2^3$) | 66017 | 75440 | 46264 | 45896 |

(continued)

| Kernel (Kernel) | Viterbi Decoding Algorithm | | Decoding Algorithm in This Embodiment of This Application | |
|---|---|---|---|---|
| | summation | comparison | summation | comparison |
| 8x8 Hermitian over GF ($2^2$) | 2484 | 3304 | 1256 | 1072 |

It can be learned from Table 2 that the complexity can still be greatly reduced in the non-binary domain by using the decoding algorithm provided in this embodiment of this application.

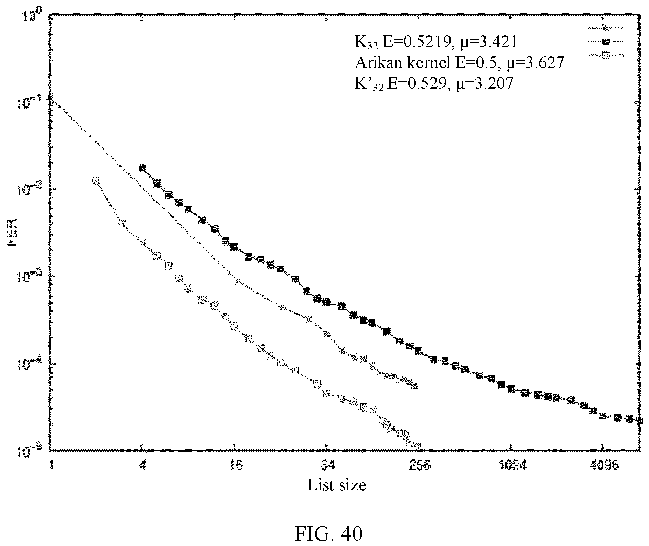

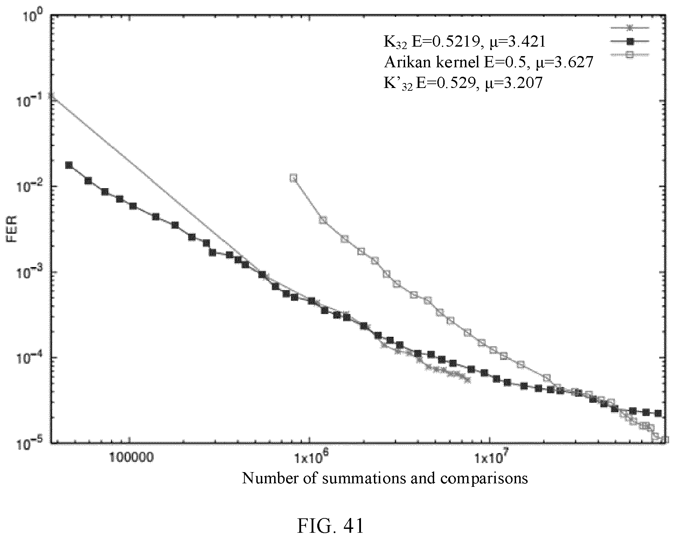

In addition, FIG. 40 and FIG. 41 show a comparison between performance and complexity of decoding on a decoding side when a kernel $K_{32}$, a kernel $K'_{32}$, and an Arikan kernel are used on an encoding side for a polar subcode (polar subcode) (1024, 512). In FIG. 40 and FIG. 41, a vertical coordinate FER indicates a frame error ratio (frame error ratio), a horizontal coordinate in FIG. 40 indicates list size (list size), and a horizontal coordinate in FIG. 41 indicates number of summations and comparisons (number of summations and comparisons). It can be learned from FIG. 40 that when the kernel $K_{32}$ and the kernel $K'_{32}$ are used when their list sizes are the same, performance can be improved by using the decoding algorithm provided in this embodiment of this application. In terms of complexity, it can be seen that a line indicating the Arikan kernel intersects with lines indicating the kernel $K_{32}$ and the kernel $K'_{32}$ at different FERs. Specifically, it can be learned that a curve corresponding to the kernel $K_{32}$ and a curve corresponding to the Arikan kernel are at an intersection of FER=$3\times10^{-4}$. A list size required the curve corresponding to the kernel $K_{32}$ is L=32, and a list size required by the curve corresponding to the Arikan kernel is L=200. When the kernel $K'_{32}$ is used, and the FER of it is the same as that of the Arikan kernel, the required list size is L=96. In this case, the list size required by the Arikan kernel is L=4096.

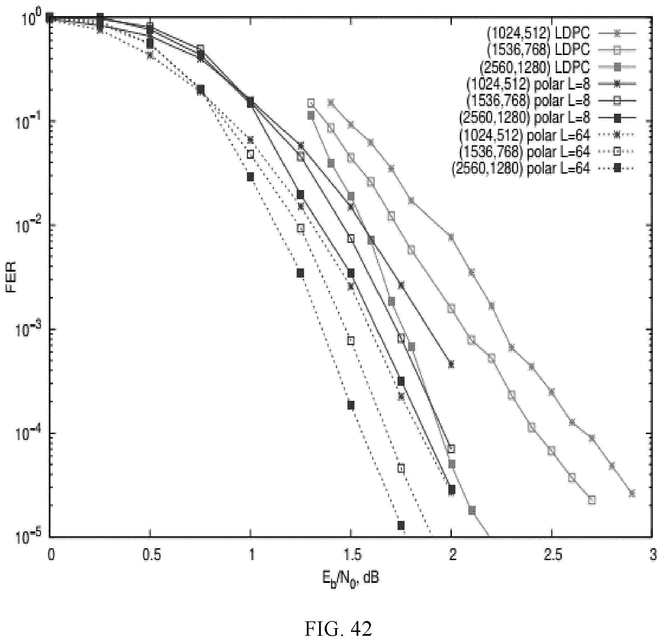

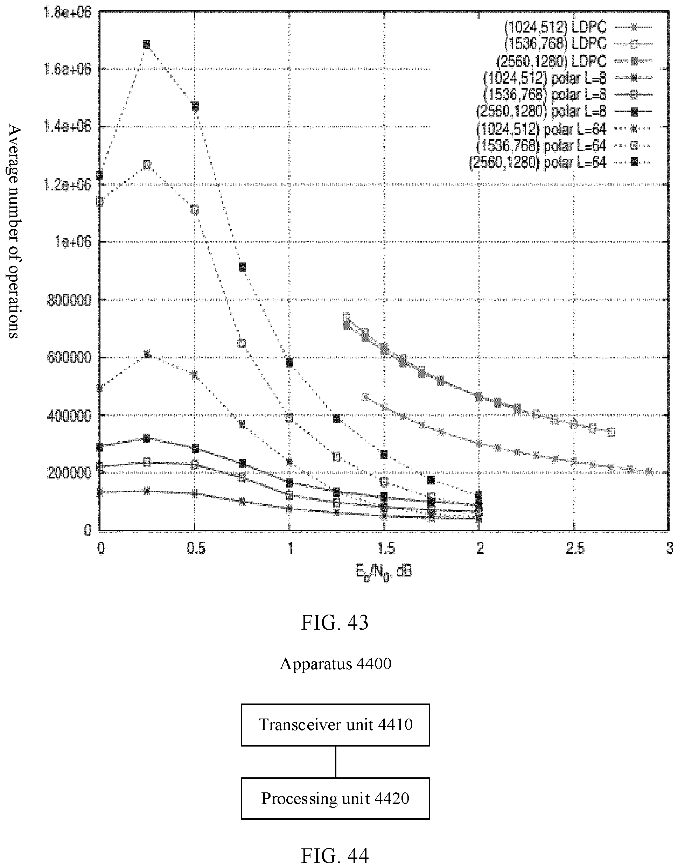

FIG. 42 and FIG. 43 show comparison results in terms of performance and complexity between a polar code and a Low-density Parity-check code (Low-density Parity-check, LDPC code). In FIG. 42 and FIG. 43, a horizontal coordinate $E_b/N_0$ indicates an errored bit ratio, $E_b$ indicates signal energy per bit (bit), $N_0$ indicates a power spectrum density of noise, a vertical coordinate FER in FIG. 42 indicates a frame error ratio (frame error ratio), and a vertical coordinate in FIG. 43 indicates an average number of operations (average number of operations). It can be learned from FIG. 42 and FIG. 43 that the polar code has more advantages in both performance and complexity.

It should be understood that the formulas in embodiments of this application are merely examples for description, and do not limit the protection scope of embodiments of this application. The formulas in the foregoing embodiments are mainly examples provided with reference to designs in the prior art, and definitions of the parameters may be definitions in a general sense. In a process of calculating the foregoing related parameters, calculation may also be performed according to the foregoing formulas, or calculation may be performed based on variations of the foregoing formulas, or calculation may be performed in another manner to meet a calculation result of the formulas.

It should be further understood that the solutions on the encoder and the decoder may be used separately, or may be used in combination. This is not limited herein. For example, encoding may be performed by using the encoding method provided in this embodiment of this application, and decoding may be performed by using an existing decoding method. For another example, encoding may be performed by using an existing encoding method, and decoding may be performed by using the decoding method provided in this embodiment of this application. For another example, encoding may be performed by using the encoding method provided in this embodiment of this application, and decoding may be performed by using the decoding method provided in this embodiment of this application. In an example, encoding (polar code encoding) is implemented by multiplying a data vector and Kronecker products of some matrices (kernel), and decoding is performed at a receive end by using a decoding method based on recursive trellis.

It should be further understood that in some of the foregoing examples, SC decoding is used as an example for description. This is not limited herein. For example, embodiments of this application may be further used in decoding methods such as SCL, sequence decoding (sequential decoding), and SC-Flip.

Based on the foregoing technical solution, in some embodiments, when the to-be-decoded sequence is decoded by using a decoding algorithm based on the trellis, the trellis may be first split, and the decoding based on a complete trellis is split into decoding based on a sub-trellis, thereby reducing decoding complexity. In other words, when calculation is performed on different sub-trellises, some calculation steps may be the same. Therefore, reusing may be performed for a plurality of times, so that decoding complexity is greatly reduced, and decoding speed is improved.

In addition, based on the foregoing technical solutions, in some embodiments, when the polar encoding is performed, a plurality of kernel matrices may first be constructed, and an appropriate kernel matrix is selected for encoding based on the constructed kernel matrices and an actual communication status. In this manner, when the kernel matrix is constructed or selected, performance and decoding complexity are comprehensively considered, so that decoding complexity can be reduced by selecting the appropriate kernel matrix used during encoding.

Embodiments described in this specification may be independent solutions, or may be combined based on internal logic. All these solutions fall within the protection scope of this application. For example, the solutions on the encoder and the decoder may be used separately, or may be used in combination.

It may be understood that, in the foregoing method embodiments, methods and operations implemented by a decoder device (for example, a network device or a terminal device) may also be implemented by a component (for example, a chip or a circuit) that can be used in the decoder device, and methods and operations implemented by an encoder device (for example, a network device or a terminal device) may also be implemented by a component (for example, a chip or a circuit) that can be used in the encoder device.

The foregoing describes in detail the method provided in embodiments of this application. The following describes in detail apparatuses provided in embodiments of this application with reference to FIG. 44 to FIG. 46. It should be understood that descriptions of apparatus embodiments are corresponding to the descriptions of the method embodiments. Therefore, for content that is not described in detail, refer to the foregoing method embodiments. For brevity, details are not described herein again.

In embodiments of this application, function module division may be performed on an encoder device or a decoder device based on the foregoing method example. For example, each function module may be obtained through division corresponding to each function, or two or more functions may be integrated in one processing module. The integrated module may be implemented in a form of hardware, or may be implemented in a form of a software functional module. It should be noted that, in embodiments of this application, division into the modules is an example and is merely logical function division, and may be other division in an actual implementation. An example in which each functional module is obtained through division based on each corresponding function is used below for description.

FIG. 44 is a schematic block diagram of an apparatus according to an embodiment of this application. An apparatus 4400 includes a transceiver unit 4410 and a processing unit 4420. The transceiver unit 4410 may implement a corresponding communication function, and the processing unit 4420 is configured to perform data processing. The transceiver unit 4410 may also be referred to as a communication interface or a communication unit.

Optionally, the apparatus 4400 may further include a storage unit. The storage unit may be configured to store instructions and/or data. The processing unit 4420 may read the instructions and/or data in the storage unit, to enable the apparatus to implement the foregoing method embodiments.

The apparatus 4400 may be configured to perform an action performed by the encoder device in the foregoing method embodiment. In this case, the apparatus 4400 may be the encoder device or the component that can be disposed in the encoder device. The transceiver unit 4410 is configured to perform operations related to receiving and sending on the encoder device in the foregoing method embodiment. The processing unit 4420 is configured to perform processing-related operations on the encoder device in the foregoing method embodiment.

Alternatively, the apparatus 4400 may be configured to perform an action performed by the decoder device in the foregoing method embodiment. In this case, the apparatus 4400 may be the decoder device or the component that can be disposed in the decoder device. The transceiver unit 4410 is configured to perform operations related to receiving and sending on the decoder device in the foregoing method embodiment. The processing unit 4420 is configured to perform processing-related operations on the decoder device in the foregoing method embodiment.

In another design, the apparatus 4400 is configured to perform an action performed by the encoder device in the embodiment shown in FIG. 14. The transceiver unit 4410 is configured to obtain information bits. The processing unit 4420 is configured to determine a target kernel matrix, where the target kernel matrix is obtained by adjusting an original kernel matrix. The processing unit 4420 is further configured to perform polar encoding on the information bits based on the target kernel matrix.

In an example, a dimension of the target kernel matrix is less than a dimension of the original kernel matrix.

In still another example, the target kernel matrix is obtained by adjusting a partial distance of the original kernel matrix.

As yet another example, the target kernel matrix is obtained by adjusting the partial distance of the original kernel matrix according to a depth-first search algorithm.

In still another example, when processing is performed according to the depth-first search algorithm, one or more of the following constraints are used for processing: a candidate line set M meets:

$$M[i] = \left\{ v_0^{l-1} \in F_2^l \mid wt\left(v_0^{l-1}\right) = D_i \right\}$$

; or when the $i^{\text{th}}$ line is selected from the bottom in the candidate line set M, a Hamming weight of a selected line v is greater than or equal to $D_i$; or selecting the line v from the candidate line set M and performing partial distance calculation on the line v and a constructed line, where if $c \in C_{\overline{K}}^{(\varphi+1)} \oplus \overline{K}[\varphi]$ and $wt(c) < D_\varphi$, the line v is directly discarded, and a new line from the candidate line set M is selected; or a line that belongs to a same coset is not selected again, where i indicates a line number, $i \in [0, l\text{-}1]$, $wt(v)$ and $wt(c)$ both indicate the Hamming weight, $\overline{K}$ indicates a currently constructed kernel matrix $\overline{K}$, $\overline{K}[\varphi]$ indicates the $\varphi_{\text{th}}$ line of the kernel matrix $\overline{K}$, $D_i$ and $D_\varphi$

both indicate the partial distance, $C_{\overline{K}}^{(\varphi+1)}$ indicates a code corresponding to the kernel matrix $\overline{K}$, and $\oplus$ indicates a logical operation.

In still another example, the original kernel matrix is a kernel matrix $K_{24}$ whose dimension is (24×24), and the $K_{24}$ is:

$$
\begin{array}{cccccccccccccccccccccccc}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 1 & 0 & 0 & 0 & 1 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 1 & 0 & 0 & 000 & 0 & 0 & 0 & 0 \\
\end{array}
$$

In still another example, the target kernel matrix is any one of the following:

$$K_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 1 & 0 & 0 & 0 & 1 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 0 & 1 & 0 & 0 & 0 & 0 & 0 & 1 & 0 & 1 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 1 & 1 & 0 & 0 & 0 & 0 & 0 & 0 \\
1 & 1 & 0 & 0 & 0 & 0 & 0 & 0 & 1 & 1 & 0 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 1 & 1 & 0 & 0 & 1 & 1 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 1 & 1 & 1 & 1 & 1 & 1 & 1 & 1
\end{pmatrix} ;$$

or

$$K_{20}' = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 1 & 0 & 0 & 0 & 1 & 0 & 0 & 0 & 1 & 0 & 0 & 0 & 1 & 0 & 0 & 0 \\
1 & 0 & 1 & 0 & 1 & 1 & 0 & 0 & 0 & 0 & 0 & 0 & 0 & 0 & 0 & 0 & 0 & 0 & 0 & 0 \\
0 & 0 & 0 & 0 & 1 & 1 & 0 & 0 & 1 & 0 & 1 & 0 & 1 & 0 & 1 & 0 & 0 & 0 & 0 & 0 \\
1 & 0 & 1 & 0 & 1 & 1 & 0 & 0 & 0 & 0 & 0 & 1 & 0 & 1 & 0 & 1 & 0 & 1 & 0 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix} ;$$

or

$$
K_{20}'' = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 1 & 0 & 0 & 0 & 0 & 0 & 1 & 0 & 0 & 0 & 0 & 0 & 0 & 0 & 0 \\
1 & 1 & 0 & 0 & 0 & 1 & 0 & 0 & 0 & 0 & 0 & 0 & 0 & 0 & 0 & 1 & 0 & 0 & 0 & 0 \\
0 & 0 & 0 & 1 & 0 & 1 & 1 & 1 & 0 & 0 & 0 & 0 & 0 & 0 & 0 & 0 & 0 & 0 & 0 & 0 \\
1 & 1 & 1 & 0 & 1 & 0 & 0 & 0 & 0 & 0 & 0 & 0 & 0 & 0 & 0 & 0 & 0 & 0 & 0 & 0 \\
1 & 0 & 1 & 1 & 1 & 0 & 0 & 1 & 0 & 0 & 1 & 0 & 0 & 0 & 0 & 0 & 0 & 0 & 0 & 0 \\
1 & 1 & 0 & 1 & 1 & 0 & 1 & 0 & 1 & 0 & 0 & 0 & 0 & 0 & 0 & 0 & 0 & 0 & 0 & 0 \\
1 & 0 & 1 & 1 & 0 & 1 & 0 & 0 & 1 & 0 & 0 & 0 & 1 & 0 & 0 & 0 & 1 & 0 & 1 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 \\
0 & 0 & 1 & 1 & 1 & 1 & 1 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 0 & 0 & 0 & 0 \\
1 & 1 & 1 & 0 & 0 & 0 & 0 & 1 & 1 & 1 & 1 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix}
$$

; or

$$
K_{21} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 \\
0 & 1 & 0 & 1 & 0 & 0 & 0 & 0 & 0 & 0 & 0 & 0 & 0 & 0 & 0 & 0 & 0 & 0 & 0 & 0 \\
1 & 1 & 1 & 0 & 1 & 0 & 0 & 0 & 0 & 0 & 0 & 0 & 0 & 0 & 0 & 0 & 0 & 0 & 0 & 0 \\
0 & 0 & 1 & 1 & 1 & 0 & 1 & 0 & 0 & 0 & 0 & 0 & 0 & 0 & 0 & 0 & 0 & 0 & 0 & 0 \\
0 & 1 & 0 & 0 & 1 & 0 & 0 & 1 & 0 & 1 & 0 & 0 & 0 & 0 & 0 & 0 & 0 & 0 & 0 & 0 \\
0 & 0 & 0 & 1 & 0 & 1 & 1 & 1 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 1 & 0 & 0 & 0 & 1 & 0 & 0 & 0 & 0 & 0 \\
1 & 1 & 1 & 0 & 0 & 0 & 0 & 0 & 1 & 1 & 0 & 0 & 0 & 1 & 0 & 0 & 0 & 0 & 0 & 0 \\
1 & 0 & 1 & 1 & 0 & 0 & 1 & 1 & 0 & 0 & 0 & 1 & 0 & 0 & 0 & 0 & 0 & 0 & 0 & 0 \\
1 & 0 & 0 & 1 & 0 & 0 & 0 & 0 & 1 & 1 & 0 & 1 & 1 & 0 & 0 & 0 & 0 & 0 & 0 & 0 \\
1 & 0 & 1 & 0 & 0 & 0 & 1 & 0 & 1 & 0 & 1 & 1 & 1 & 0 & 0 & 0 & 1 & 0 & 0 & 0 \\
1 & 0 & 1 & 0 & 1 & 0 & 0 & 1 & 0 & 1 & 0 & 1 & 0 & 1 & 0 & 1 & 0 & 0 & 0 & 0 \\
1 & 1 & 0 & 1 & 0 & 1 & 0 & 1 & 1 & 1 & 0 & 0 & 0 & 0 & 0 & 0 & 0 & 0 & 0 & 0 \\
1 & 1 & 1 & 0 & 0 & 1 & 1 & 0 & 0 & 1 & 1 & 0 & 0 & 1 & 1 & 0 & 0 & 0 & 1 & 0 \\
1 & 1 & 1 & 1 & 0 & 0 & 0 & 0 & 1 & 1 & 1 & 1 & 0 & 0 & 0 & 0 & 0 & 1 & 0 & 0 \\
1 & 1 & 1 & 1 & 1 & 1 & 1 & 1 & 1 & 0 & 0 & 0 & 0 & 0 & 0 & 0 & 0 & 1 & 1 & 1 \\
1 & 1 & 1 & 1 & 1 & 1 & 1 & 1 & 1 & 1 & 1 & 1 & 1 & 1 & 1 & 1 & 1 & 0 & 0 & 0
\end{pmatrix}
$$

;

or

$$K'_{21}=\begin{pmatrix}
1&0&0&0&0&0&0&0&0&0&0&0&0&0&0&0&0&0&0&0&0\\
1&0&0&0&1&0&0&0&0&0&0&0&0&0&0&0&0&0&0&0&0\\
1&0&0&1&0&0&0&0&0&0&0&0&0&0&0&0&0&0&0&0&0\\
1&0&0&0&1&0&0&0&0&0&0&0&0&0&0&0&0&0&0&0&0\\
1&0&1&0&0&0&0&0&0&0&0&0&0&0&0&0&0&0&0&0&0\\
1&1&0&0&0&0&0&0&0&0&0&0&0&0&0&0&0&0&0&0&0\\
1&0&0&1&1&0&0&1&0&0&0&0&0&0&0&0&0&0&0&0&0\\
0&0&1&1&1&0&0&0&1&0&0&0&0&0&0&0&0&0&0&0&0\\
0&0&1&0&0&1&1&1&0&0&0&0&0&0&0&0&0&0&0&0&0\\
0&1&1&0&1&0&1&1&0&0&0&0&0&1&0&0&0&0&0&0&0\\
1&0&0&0&0&0&0&1&1&1&0&0&0&0&0&0&0&0&0&0&0\\
0&1&1&1&0&1&1&0&0&0&0&1&0&0&0&0&0&0&0&0&0\\
0&1&0&0&0&1&1&1&0&1&0&0&0&1&0&0&0&0&0&0&0\\
1&0&1&1&0&1&0&1&0&0&1&0&0&0&0&0&0&0&0&0&0\\
1&1&0&0&1&1&0&0&1&0&0&0&1&0&1&0&1&0&0&0&0\\
1&0&1&1&0&1&0&0&1&0&1&0&1&1&0&0&1&0&1&0&0\\
0&0&0&0&1&1&0&1&1&0&0&1&1&1&1&0&0&0&0&0&0\\
1&1&0&0&0&1&1&0&1&1&1&1&0&0&0&0&0&0&0&0&0\\
1&1&1&1&1&0&0&0&1&1&0&0&0&0&0&0&0&0&0&0&1\\
1&1&1&1&1&1&1&1&0&0&0&0&0&0&0&0&0&0&1&1&0\\
1&1&1&1&1&1&1&1&1&1&1&1&1&1&1&1&1&0&0&0
\end{pmatrix};$$

or

$$K_{24}=\begin{pmatrix}
1&0&0&0&0&0&0&0&0&0&0&0&0&0&0&0&0&0&0&0&0&0&0&0\\
1&0&0&0&0&0&0&0&0&0&0&0&0&0&0&1&0&0&0&0&0&0&0&0\\
1&0&0&0&0&0&0&1&0&0&0&0&0&0&0&0&0&0&0&0&0&0&0&0\\
1&0&0&0&0&0&0&1&0&0&0&0&0&0&1&0&0&0&1&0&0&0&0&0\\
1&0&1&0&0&0&0&0&0&0&0&0&0&0&0&0&0&0&0&0&0&0&0&0\\
1&0&1&0&0&0&0&1&0&0&0&1&0&0&0&0&0&0&0&0&0&0&0&0\\
1&0&0&0&1&0&0&0&0&0&0&0&0&0&0&0&0&0&0&0&0&0&0&0\\
1&0&0&0&1&0&0&0&1&0&1&0&0&0&0&0&0&0&0&0&0&0&0&0\\
1&0&1&0&0&0&0&0&1&0&1&0&0&0&0&1&0&1&0&0&0&0&0&0\\
1&1&0&0&0&0&0&0&0&0&0&0&0&0&0&0&0&0&0&0&0&0&0&0\\
1&1&0&0&0&0&0&0&1&1&0&0&0&0&0&0&0&0&0&0&0&0&0&0\\
1&0&1&0&1&0&1&0&0&0&0&0&0&0&0&0&0&0&0&0&0&0&0&0\\
1&0&1&0&1&0&1&0&1&1&0&0&0&0&0&1&1&0&0&0&0&0&0&0\\
0&1&1&0&1&0&1&0&0&1&1&0&1&0&1&0&0&0&0&0&0&0&0&0\\
1&0&1&0&1&0&1&0&1&0&1&0&1&0&1&0&1&0&1&0&1&0&1&0\\
1&1&0&0&1&1&0&0&0&0&0&0&0&0&0&0&0&0&0&0&0&0&0&0\\
1&1&1&1&0&0&0&0&0&0&0&0&0&0&0&0&0&0&0&0&0&0&0&0\\
0&0&1&1&1&1&0&0&1&1&0&0&1&1&0&0&0&0&0&0&0&0&0&0\\
1&1&0&0&1&1&0&0&1&1&1&1&0&0&0&0&0&0&0&0&0&0&0&0\\
1&1&0&0&1&1&0&0&1&1&0&0&1&1&0&0&1&1&0&0&1&1&0&0\\
1&1&1&0&0&0&0&0&1&1&1&1&0&0&0&0&1&1&1&1&0&0&0&0\\
1&1&1&1&1&1&1&1&0&0&0&0&0&0&0&0&0&0&0&0&0&0&0&0\\
1&1&1&1&1&1&1&1&0&0&0&0&0&0&0&0&1&1&1&1&1&1&1&1\\
1&1&1&1&1&1&1&1&1&1&1&1&1&1&1&1&0&0&0&0&0&0&0&0
\end{pmatrix};$$

or

$$K'_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 1 & 1 & 0 & 0 & 0 & 0 & 0 & 0
\end{pmatrix};$$

or

$$K''_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
0 & 1 & 1 & 1 & 0 & 0 & 1 & 0 & 1 & 0 & 0 & 0 & 1 & 0 & 0 & 0 & 1 & 0 & 1 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 0 & 1 & 1 & 0 & 1 & 0 & 1 & 0 & 1 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 1 & 1 & 0 & 0 & 0 & 0 & 0 & 0
\end{pmatrix};$$

or

$$K_{25} = \begin{pmatrix}
1&0&0&0&0&0&0&0&0&0&0&0&0&0&0&0&0&0&0&0&0&0&0&0&0&0&0&0&0&0\\
1&0&0&0&0&0&1&0&0&0&0&0&0&0&0&0&0&0&0&0&0&0&0&0&0&0&0&0&0&0\\
1&0&0&1&0&0&0&0&0&0&0&0&0&0&0&0&0&0&0&0&0&0&0&0&0&0&0&0&0&0\\
1&1&0&0&0&0&0&0&0&0&0&0&0&0&0&0&0&0&0&0&0&0&0&0&0&0&0&0&0&0\\
0&1&0&0&1&0&0&0&0&0&0&0&0&0&0&0&0&0&0&0&0&0&0&0&0&0&0&0&0&0\\
0&1&1&0&0&0&0&0&0&0&0&0&0&0&0&0&0&0&0&0&0&0&0&0&0&0&0&0&0&0\\
0&0&1&0&1&0&0&1&0&0&0&0&1&0&0&0&0&0&0&0&0&0&0&0&0&0&0&0&0&0\\
1&0&1&0&1&0&0&0&0&0&1&0&0&0&0&0&0&0&0&0&0&0&0&0&0&0&0&0&0&0\\
0&0&0&1&1&0&0&0&0&0&0&1&1&0&0&0&0&0&0&0&0&0&0&0&0&0&0&0&0&0\\
1&1&0&0&0&1&1&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&1&0&1&0&0&1&0&0&0&0&1&0&0&1&1&0&0&0&0&0&0&0&0&0&0&0&0&0&0\\
0&0&0&0&0&1&1&1&0&0&0&1&0&1&0&0&1&0&0&0&0&0&0&0&0&0&0&0&0&0\\
1&0&0&0&1&1&1&1&0&1&0&0&0&0&0&0&0&0&0&0&0&0&0&0&0&0&0&0&0&0\\
1&1&1&0&1&0&0&1&1&0&0&0&0&0&0&0&0&0&0&0&0&0&0&0&0&0&0&0&0&0\\
0&1&0&1&0&0&1&1&0&1&0&1&0&0&0&0&0&1&0&0&0&0&1&0&0&0&0&0&0&0\\
0&0&1&0&1&1&0&1&1&1&0&0&1&0&1&0&0&0&0&0&0&0&0&0&0&0&0&0&0&0\\
1&1&1&1&1&1&1&0&0&0&1&0&0&0&0&0&0&0&0&0&0&0&0&0&0&0&0&0&0&0\\
1&1&0&0&1&0&1&0&1&1&0&1&0&1&1&0&0&0&0&1&0&0&0&0&0&0&0&0&0&0\\
1&0&1&1&0&1&1&1&1&0&1&0&0&0&0&0&1&0&0&0&0&0&0&0&0&0&0&0&0&0\\
1&1&0&1&0&1&0&1&0&1&0&1&0&1&0&0&0&1&0&1&0&1&0&0&0&0&0&0&0&0\\
1&1&1&0&0&1&1&0&0&1&1&0&0&1&1&0&0&0&1&0&0&1&1&0&0&0&0&0&0&0\\
1&1&1&1&0&0&0&0&1&1&1&0&0&0&0&0&1&1&1&0&0&0&0&0&0&0&0&0&0&0\\
1&1&1&1&1&1&1&1&1&0&0&0&0&0&0&0&0&1&1&1&1&1&1&0&0&0&0&0&0&0\\
1&1&1&1&1&1&1&1&1&1&1&1&1&1&1&1&1&1&0&0&0&0&0&0&0&0&0&0&0&0
\end{pmatrix} ;$$

or

$$K'_{25} = \begin{pmatrix}
1&0&0&0&0&0&0&0&0&0&0&0&0&0&0&0&0&0&0&0&0&0&0&0&0&0&0&0&0&0\\
1&0&0&1&0&0&0&0&0&0&0&0&0&0&0&0&0&0&0&0&0&0&0&0&0&0&0&0&0&0\\
1&1&0&0&0&0&0&0&0&0&0&0&0&0&0&0&0&0&0&0&0&0&0&0&0&0&0&0&0&0\\
1&0&1&0&0&0&0&0&0&0&0&0&0&0&0&0&0&0&0&0&0&0&0&0&0&0&0&0&0&0\\
1&0&0&0&0&0&1&0&0&0&0&0&0&0&0&0&0&0&0&0&0&0&0&0&0&0&0&0&0&0\\
1&0&0&0&0&0&0&0&0&1&0&0&0&0&0&0&0&0&0&0&0&0&0&0&0&0&0&0&0&0\\
0&0&1&0&1&0&0&1&1&0&0&0&0&0&0&0&0&0&0&0&0&0&0&0&0&0&0&0&0&0\\
1&1&0&0&0&0&0&1&0&0&0&0&0&0&1&0&0&0&0&0&0&0&0&0&0&0&0&0&0&0\\
1&0&1&0&0&0&0&1&0&0&1&0&0&0&0&0&0&0&0&0&0&0&0&0&0&0&0&0&0&0\\
1&0&0&0&0&0&0&1&0&1&0&0&0&0&0&0&0&0&0&0&1&0&0&0&0&0&0&0&0&0\\
0&1&1&0&1&0&1&0&0&0&0&0&0&0&0&0&0&0&0&0&0&0&0&0&0&0&0&0&0&0\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&0&1&1&1&0&1&0&1&0&0&0&0&0&1&0&0&0&0&0&0&0&0&1\\
0&1&1&0&0&0&1&0&0&0&1&0&0&0&1&0&0&1&0&0&0&0&0&0&0&0&0&0&0&0\\
1&1&0&1&1&0&0&0&1&0&0&1&0&0&0&1&0&1&0&0&0&0&0&0&0&0&0&0&0&0\\
0&1&1&0&1&0&1&0&1&1&0&0&0&0&0&0&1&1&0&0&0&0&0&0&0&0&0&0&0&0\\
1&0&1&0&1&0&1&0&1&0&1&0&1&0&1&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&0&0&0&0&0&0&0&0&0&0&0&0&0&0&0&0&0&0&0\\
1&1&1&1&1&1&1&0&0&0&0&0&0&0&0&0&0&0&0&0&0&0&0&0&0&0&0&0&0&0\\
1&1&0&0&1&1&0&0&1&1&0&0&1&1&0&0&1&1&0&0&1&1&0&0&0&0&0&0&0&0\\
1&1&1&1&0&0&0&0&1&1&1&0&0&0&0&0&1&1&1&0&0&0&0&0&0&0&0&0&0&0\\
1&1&1&1&0&0&0&0&1&1&1&0&0&0&0&0&0&1&1&1&1&1&1&1&0&0&0&0&0&0\\
1&1&1&1&1&1&1&1&1&1&1&1&1&1&1&1&0&0&0&0&0&0&0&0&0&0&0&0&0&0
\end{pmatrix} ;$$

or

$$K_{28} = \begin{pmatrix}
1&0&0&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&1&0&0&0&0&0&0&0&0&0&0&0&0&0&0&0\\
1&0&0&0&0&0&0&0&1&0&0&0&0&0&0&0&0&0&0&0&0&0&0&0&0&0&0&0&0&0&0&0\\
1&0&0&0&0&0&0&0&1&0&0&0&0&0&1&0&0&0&1&0&0&0&0&0&0&0&0&0&0&0&0&0\\
1&0&0&1&0&0&0&0&0&0&0&0&0&0&0&0&0&0&0&0&0&0&0&0&0&0&0&0&0&0&0&0\\
1&0&0&1&0&0&0&0&0&0&0&0&0&0&0&1&0&1&0&0&0&0&0&0&0&0&0&0&0&0&0&0\\
1&0&1&0&0&0&0&0&0&0&0&0&0&0&0&0&0&0&0&0&0&0&0&0&0&0&0&0&0&0&0&0\\
0&0&0&0&0&0&0&1&0&1&0&0&0&0&0&0&0&0&0&0&1&0&1&0&0&0&0&0&0&0&0&0\\
1&0&0&1&0&0&0&0&0&1&0&1&0&0&0&0&0&0&1&0&1&0&0&0&0&0&0&0&0&0&0&0\\
1&0&0&1&0&0&0&1&0&0&0&1&0&0&0&1&0&1&0&1&0&0&0&1&0&0&0&0&0&0&0&0\\
1&1&0&0&0&0&0&0&0&0&0&0&0&0&0&0&0&0&0&0&0&0&0&0&0&0&0&0&0&0&0&0\\
1&1&0&0&0&0&0&0&0&0&0&0&0&0&0&1&1&0&0&0&0&0&0&0&0&0&0&0&0&0&0&0\\
0&1&1&0&0&0&0&0&1&0&1&0&0&0&0&0&1&1&0&0&0&0&0&0&0&0&0&0&0&0&0&0\\
1&0&1&0&1&0&1&0&0&0&0&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0&0&0&0&0\\
1&1&0&0&0&0&0&1&1&0&0&0&0&0&0&1&1&0&0&1&1&0&0&0&0&0&0&0&0&0&0&0\\
1&1&0&0&0&0&0&0&1&1&0&1&0&1&0&1&1&0&0&0&1&1&0&1&0&1&0&0&0&0&0&0\\
1&1&0&0&1&1&0&0&0&0&0&0&0&0&0&0&0&0&0&0&0&0&0&0&0&0&0&0&0&0&0&0\\
1&1&0&0&1&1&0&0&0&0&0&0&0&0&1&1&1&1&0&0&0&0&0&0&0&0&0&0&0&0&0&0\\
0&1&1&0&0&1&1&0&1&0&1&0&1&0&1&0&1&1&1&1&0&0&0&0&0&0&0&0&0&0&0&0\\
1&1&1&1&0&0&0&0&0&0&0&0&0&0&0&0&0&0&0&0&0&0&0&0&0&0&0&0&0&0&0&0\\
0&0&0&0&0&0&0&1&1&1&1&0&0&0&0&0&0&0&1&1&1&1&0&0&0&0&0&0&0&0&0&0\\
1&1&0&0&1&1&0&0&0&0&1&1&1&1&0&0&0&0&0&0&1&1&1&1&0&0&0&0&0&0&0&0\\
1&1&0&0&1&1&0&0&1&1&0&0&1&1&0&0&1&1&1&1&1&1&0&0&1&1&0&0&0&0&0&0\\
1&1&1&1&0&0&0&0&1&1&1&1&0&0&0&0&0&0&0&0&0&0&0&0&0&0&0&0&0&0&0&0\\
1&1&1&1&1&1&1&1&0&0&0&0&0&0&0&0&0&0&0&0&0&0&0&0&0&0&0&0&0&0&0&0\\
0&0&0&0&0&0&0&0&1&1&1&1&1&1&1&1&0&0&0&0&1&1&1&1&1&1&1&1&0&0&0&0\\
1&1&1&1&1&1&1&1&1&1&1&1&1&1&1&1&0&0&0&0&0&0&0&0&0&0&0&0&0&0&0&0
\end{pmatrix};$$

or

$$K_{32} = \begin{pmatrix}
1&0&0&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&1&0&0&0&0&0&0&0&0&0&0&0&0&0&0&0\\
1&0&0&0&0&0&0&0&1&0&0&0&0&0&0&0&0&0&0&0&0&0&0&0&0&0&0&0&0&0&0&0\\
1&0&0&0&0&0&0&0&1&0&0&0&0&0&1&0&0&0&0&0&1&0&0&0&0&0&0&0&0&0&0&0\\
1&0&0&0&1&0&0&0&0&0&0&0&0&0&0&0&0&0&0&0&0&0&0&0&0&0&0&0&0&0&0&0\\
1&0&0&0&1&0&0&0&0&0&0&0&0&0&0&0&1&0&0&0&1&0&0&0&0&0&0&0&0&0&0&0\\
1&0&1&0&0&0&0&0&0&0&0&0&0&0&0&0&0&0&0&0&0&0&0&0&0&0&0&0&0&0&0&0\\
1&0&1&0&0&0&0&0&0&0&0&0&0&0&0&0&1&0&1&0&0&0&0&0&0&0&0&0&0&0&0&0\\
0&0&1&0&1&0&0&0&1&0&0&0&1&0&0&0&1&0&1&0&0&0&0&0&0&0&0&0&0&0&0&0\\
1&0&0&0&1&0&0&0&1&0&0&0&1&0&0&0&1&0&0&0&1&0&0&0&1&0&0&0&1&0&0&0\\
1&1&0&0&0&0&0&0&0&0&0&0&0&0&0&0&0&0&0&0&0&0&0&0&0&0&0&0&0&0&0&0\\
1&1&0&0&0&0&0&0&0&0&0&0&0&0&0&0&1&1&0&0&0&0&0&0&0&0&0&0&0&0&0&0\\
0&1&1&0&0&0&0&0&1&0&1&0&0&0&0&0&1&1&0&0&0&0&0&0&0&0&0&0&0&0&0&0\\
1&0&1&0&0&0&0&0&1&0&1&0&0&0&0&0&1&0&1&0&0&0&0&0&1&0&1&0&0&0&0&0\\
1&0&1&0&1&0&1&0&0&0&0&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0&0&0&0&0\\
1&1&0&0&0&0&0&0&1&1&0&0&0&0&0&0&1&1&0&0&0&0&0&0&1&1&0&0&0&0&0&0\\
0&1&1&0&1&0&1&0&1&1&0&0&0&0&0&0&1&1&0&1&0&1&0&1&1&1&0&0&0&0&0&0\\
1&1&0&0&1&1&0&0&0&0&0&0&0&0&0&0&0&0&0&0&0&0&0&0&0&0&0&0&0&0&0&0\\
1&1&0&0&1&1&0&0&0&0&0&0&0&0&0&0&1&1&0&0&1&1&0&0&0&0&0&0&0&0&0&0\\
0&1&1&0&0&1&1&0&1&0&1&0&1&0&1&0&1&1&0&0&1&1&0&0&0&0&0&0&0&0&0&0\\
1&0&1&0&1&0&1&0&1&0&1&0&1&0&1&0&1&0&1&0&1&0&1&0&1&0&1&0&1&0&1&0\\
1&1&1&1&0&0&0&0&0&0&0&0&0&0&0&0&0&0&0&0&0&0&0&0&0&0&0&0&0&0&0&0\\
1&1&1&1&0&0&0&0&0&0&0&0&0&0&0&0&1&1&1&1&0&0&0&0&0&0&0&0&0&0&0&0\\
0&0&1&1&1&1&0&0&1&1&0&0&1&1&0&0&1&1&1&1&0&0&0&0&0&0&0&0&0&0&0&0\\
1&1&0&0&1&1&0&0&1&1&0&0&1&1&0&0&1&1&0&0&1&1&0&0&1&1&0&0&1&1&0&0\\
1&1&1&1&0&0&0&0&1&1&1&1&0&0&0&0&0&0&0&0&0&0&0&0&0&0&0&0&0&0&0&0\\
1&1&1&1&0&0&0&0&1&1&1&1&0&0&0&0&1&1&1&1&0&0&0&0&1&1&1&1&0&0&0&0\\
1&1&1&1&1&1&1&1&0&0&0&0&0&0&0&0&0&0&0&0&0&0&0&0&0&0&0&0&0&0&0&0\\
1&1&1&1&1&1&1&1&0&0&0&0&0&0&0&0&1&1&1&1&1&1&1&1&0&0&0&0&0&0&0&0\\
1&1&1&1&1&1&1&1&1&1&1&1&1&1&1&1&0&0&0&0&0&0&0&0&0&0&0&0&0&0&0&0\\
1&1&1&1&1&1&1&1&1&1&1&1&1&1&1&1&1&1&1&1&1&1&1&1&1&1&1&1&1&1&1&1
\end{pmatrix}.$$

The apparatus 4400 may implement steps or procedures corresponding to the encoder device in the method embodiments of this application. The apparatus 4400 may include units configured to perform the methods performed by the encoder device in the method embodiments in FIG. 13 to FIG. 43. In addition, the units in the apparatus 4400 and the foregoing other operations and/or functions are separately used to implement corresponding procedures in the method embodiments in FIG. 13 to FIG. 43.

When the apparatus 4400 is configured to perform method 1300 in FIG. 13, the transceiver unit 4410 may be configured to perform Step 1310 in the method 1300, and the processing unit 4420 may be configured to perform Step 1320 and step 1330 in the method 1300.

It should be understood that a specific process in which the units perform the foregoing corresponding steps is described in detail in the foregoing method embodiments. For brevity, details are not described herein again.

In another design, the apparatus 4400 is configured to perform an action performed by the decoder device in the embodiment shown in FIG. 14, and the transceiver unit 4410 is configured to obtain a to-be-decoded sequence. The processing unit 4420 is configured to decode the to-be-decoded sequence based on a plurality of trellises, and reuse an intermediate result obtained from decoding performed based on a first trellis in the plurality of trellises when decoding is performed based on a second trellis in the plurality of trellises, where the first trellis is used for the $t^{th}$ stage of decoding the to-be-decoded sequence, the second trellis is used for the $(t+i)^{th}$ stage of decoding the to-be-decoded sequence, t is an integer greater than 0 or equal to 0, and i is an integer greater than 1 or equal to 1.

As an example, each of the plurality of trellises is split into a plurality of sub-trellises.

In still another example, locations of split points of the plurality of sub-trellises are related to decoding complexity.

In still another example, the processing unit 4420 is further configured to determine, based on a correlation between the first trellis and the second trellis, whether to reuse the intermediate result obtained through decoding performed based on the first trellis when decoding is performed based on the second trellis.

In still another example, the processing unit 4420 is specifically configured to determine, based on the following information, whether to reuse the intermediate result obtained through decoding performed based on the first trellis when decoding is performed based on the second trellis: a code obtained by performing a shortening operation on a linear code C in the $(t+i)^{th}$ stage of decoding and a code obtained by performing the shortening operation on the linear code C in the $t^{th}$ stage of decoding; and/or a code obtained by performing a puncturing operation on the linear code C in the $(t+i)^{th}$ stage of decoding and a code obtained by performing a puncturing operation on the linear code C in the $t^{th}$ stage of decoding.

In still another example, if $s_{x,y}(C^{(t+i)})=s_{x,y}(C^{(t)})$, and $p_{x,y}(C^{(t+i)}) \subset p_{x,y}(C^{(t)})$, reusing the intermediate result obtained through decoding performed based on the first trellis when decoding is performed based on the second trellis; or if $s_{x,y}(C^{(t+i)}) \subset s_{x,y}(C^{(t)})$, reusing the intermediate result obtained through decoding performed based on the first trellis when decoding is performed based on the second trellis, where $s_{x,y}(C^{(t+i)})$ indicates a code obtained by performing the shortening operation on the linear code C at a location except $x \le z < y$ in the $(t+i)^{th}$ stage of decoding, $s_{x,y}(C^{(t)})$ indicates a code obtained by performing the shortening operation on the linear code C at the location except $x \le z < y$ in the $t^{th}$ stage of decoding, $p_{x,y}(C^{(t+i)})$ indicates a code obtained by performing the puncturing operation on the linear code C at the location except $x \le z < y$ in the $(t+i)^{th}$ stage of decoding, and $p_{x,y}(C^{(t)})$ indicates a code obtained by performing the puncturing operation on the linear code C at the location except $x \le z < y$ in the $t^{th}$ stage of decoding.

In still another example, the processing unit 4420 is specifically configured to: directly use the intermediate result obtained through decoding performed based on the first trellis as an intermediate result obtained through decoding performed based on the second trellis when processing is performed based on the second trellis in the $(t+i)^{th}$ stage of decoding; or process based on a result of a maximization operation in a process of the first trellis when processing is performed based on the second trellis in the $(t+i)^{th}$ stage of decoding.

The apparatus 4400 may implement steps or procedures corresponding to the decoder device in the method embodiments of this application. The apparatus 4400 may include units configured to perform the methods performed by the decoder device in the method embodiments in FIG. 13 to FIG. 43. In addition, the units in the apparatus 4400 and the foregoing other operations and/or functions are separately used to implement corresponding procedures in the method embodiments in FIG. 13 to FIG. 43.

When the apparatus 4400 is configured to perform method 1400 in FIG. 14, the transceiver unit 4410 may be configured to perform Step 1410 in the method 1400, and the processing unit 4420 may be configured to perform Step 1420 in the method 1400.

The processing unit 4420 in the foregoing embodiment may be implemented by at least one processor or a processor-related circuit. The transceiver unit 4410 may be implemented by using a transceiver or a transceiver-related circuit. The transceiver unit 4410 may also be referred to as a communication unit or a communication interface. The storage unit may be implemented by at least one memory.

In a possible design, the foregoing functions of the apparatus 4400 may be implemented by hardware, or may be implemented by hardware executing corresponding software.

In an embodiment, the apparatus 4400 may include one or more processors. The one or more processors are configured to execute a computer program stored in the memory, so that the apparatus 4400 performs any method embodiment provided in this application.

Optionally, the memory configured to store the computer program is located outside the apparatus 4400, and the one or more processors are connected to the memory by using a circuit and/or a wire. There may be one or more memories.

Optionally, the apparatus 4400 further includes one or more memories.

Further, optionally, the apparatus 4400 further includes one or more communication interfaces.

In some examples, the one or more communication interfaces may be an input output interface or an input output circuit. This is not limited in this application.

In another embodiment, the apparatus 4400 may be further implemented by using hardware.

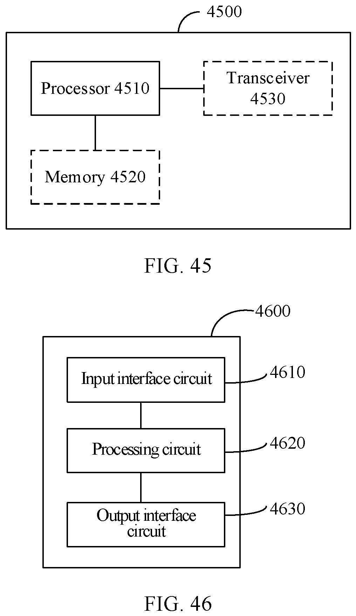

As shown in FIG. 45, an embodiment of this application further provides an apparatus 4500. The apparatus 4500 includes a processor 4510. The processor 4510 is coupled to a memory 4520. The memory 4520 is configured to store a computer program or instructions and/or data. The processor 4510 is configured to execute the computer program or the instructions and/or the data stored in the memory 4520, so that the methods in the foregoing method embodiments are performed.

Optionally, the apparatus 4500 includes one or more processors 4510.

Optionally, as shown in FIG. 45, the apparatus 4500 may further include the memory 4520.

Optionally, the apparatus 4500 may include one or more memories 4520.

Optionally, the memory 4520 and the processor 4510 may be integrated together, or may be disposed separately.

Optionally, as shown in FIG. 45, the apparatus 4500 may further include a transceiver 4530. The transceiver 4530 is configured to receive and/or send a signal. For example, the processor 4510 is configured to control the transceiver 4530 to receive and/or send a signal.

In a solution, the apparatus 4500 is configured to implement the operations performed by the encoder device in the foregoing method embodiments.

For example, the processor 4510 is configured to perform a processing-related operation performed by the encoder device in the foregoing method embodiment, and the transceiver 4530 is configured to perform operations related to receiving and sending performed by the encoder device in the foregoing method embodiment.

In another solution, the apparatus 4500 is configured to implement the operations performed by the decoder device in the foregoing method embodiments.

For example, the processor 4510 is configured to perform a processing-related operation performed by the decoder device in the foregoing method embodiment, and the transceiver 4530 is configured to perform operations related to receiving and sending performed by the decoder device in the foregoing method embodiment.

An embodiment of this application further provides an apparatus 4600. The apparatus 4600 may be configured to perform the operation performed by the encoder device in the foregoing method embodiment, or the apparatus 4600 may be configured to perform the operation performed by the decoder device in the foregoing method embodiment.

The apparatus 4600 may include an input interface circuit 4610, a logic circuit 4620, and an output interface circuit 4620.

In a solution, the apparatus 4600 may be configured to perform the operations performed by the decoder device in the foregoing method embodiments.

Optionally, the apparatus 4600 may also be a device or module that is in the decoder and that is configured to implement channel decoding. For example, it may be a channel decoder or a channel decoding circuit. Alternatively, the apparatus 4600 may be a chip disposed in a receive end.

In a possible implementation, the input interface circuit 4610 is configured to obtain a to-be-decoded sequence; the logic circuit 4620 is configured to decode the to-be-decoded sequence according to a decoding algorithm provided in this application; and the output interface circuit 4630 is configured to output a decoding result.

In still another possible implementation, the logic circuit 4620 is configured to obtain a to-be-decoded sequence, and decode the to-be-decoded sequence according to a decoding algorithm provided in this application. The output interface circuit 4630 outputs a decoding result.

In another solution, the apparatus 4600 may be configured to perform the operations performed by the encoder device in the foregoing method embodiments.

Optionally, the apparatus 4600 may also be a device or module configured to implement encoding in the encoder. For example, it may be an encoder or an encoding circuit. Alternatively, the apparatus 4600 may be a chip disposed at a transmit end.

In a possible implementation, the input interface circuit 4610 is configured to obtain information bits; the logic circuit 4620 is configured to encode the information bits according to an encoding algorithm provided in this application; and the output interface circuit 4630 is configured to output an encoded polar code.

In still another possible implementation, the logic circuit 4620 is configured to generate information bits, and encode the information bits according to the encoding algorithm provided in this application; and the output interface circuit 4630 outputs an encoded polar code.

Optionally, the apparatus 4600 may be a chip or an integrated circuit. For example, the chip may be a system on chip (system on chip, SOC), or may be a baseband chip.

Optionally, the foregoing mainly uses an example in which the input interface circuit 4610 and the output interface circuit 4620 are separate interface circuits for description. This is not limited. For example, the input interface circuit 4610 and the output interface circuit 4620 may be integrated into one interface.

An embodiment of this application further provides a computer-readable storage medium. The computer-readable storage medium stores computer instructions used to implement the method performed by the encoder device or the method performed by the decoder device in the foregoing method embodiments.

For example, when a computer program is executed by a computer, the computer can implement the method performed by the encoder device or the method performed by the decoder device in the foregoing method embodiments.

An embodiment of this application further provides a computer program product including instructions. When the instructions are executed by a computer, the computer is enabled to implement the method performed by the encoder device or the method performed by the decoder device in the foregoing method embodiments.

This application further provides a chip, including one or more memories and one or more processors. The one or more memories are configured to store a computer program, and the one or more processors are configured to invoke the computer program from the one or more memories and run the computer program, so that a device in which the chip is installed performs the method in this application.

This application further provides a communication device, including the apparatus 4500 or the apparatus 4600 described above.

An embodiment of this application further provides a communication system. The communication system includes the encoder device and the decoder device in the foregoing embodiments.

The decoder in this specification is a receive end of a signal and/or data. Correspondingly, a party that sends the signal and/or the data is a transmit end. Optionally, the decoder may be a network device (for example, a gNB in 5G) in the communication system, or may be a terminal device. This is not limited in the solutions of this application.

The encoder in this specification is a transmit end of a signal and/or data. Correspondingly, a party that receives the signal and/or the data is the receive end. Optionally, the encoder may be a network device (for example, a gNB in 5G) in the communication system, or may be a terminal device. This is not limited in the solutions of this application.

It may be clearly understood by a person skilled in the art that, for convenience and brief description, for explanations and beneficial effects of related content in any communication apparatus provided above, refer to the corresponding method embodiment provided above. Details are not described herein again.

In this embodiment of this application, the encoder device or the decoder device may include a hardware layer, an operating system layer running above the hardware layer, and an application layer running above the operating system layer. The hardware layer may include hardware such as a central processing unit (central processing unit, CPU), a memory management unit (memory management unit, MMU), and a memory (also referred to as a primary memory). An operating system at the operating system layer may be any one or more computer operating systems that implement service processing through a process (process), for example, a Linux operating system, a Unix operating system, an Android operating system, an iOS operating system, or a Windows operating system. The application layer may include applications such as a browser, an address book, word processing software, and instant messaging software.

A specific structure of an execution body of a method provided in embodiments of this application is not specifically limited in embodiments of this application, provided that a program that records code for the method provided in embodiments of this application can be run to perform communication according to the method provided in embodiments of this application. For example, the execution body of the method provided in embodiments of this application may be performed by an encoder device or a decoder device, or may be a function module that can invoke and execute a program in the encoder device or the decoder device.

Aspects or features of this application may be implemented as a method, an apparatus, or a product that uses standard programming and/or engineering technologies. The term "product" used in this specification may cover a computer program that can be accessed from any computer-readable component, carrier or medium.

The computer-readable storage medium may be any usable medium accessible by a computer, or a data storage device, such as a server or a data center, integrating one or more usable media. The usable medium (or the computer-readable medium) may include, for example, but is not limited to, various media that can store program code such as a magnetic medium or a magnetic storage device (for example, a floppy disk, a hard disk (for example, a removable hard disk), or a magnetic tape), an optical medium (for example, an optical disc, a compact disc (compact disc, CD), or a digital versatile disc (digital versatile disc, DVD)), a smart card, and a flash storage device (for example, an erasable programmable read-only memory (erasable programmable read-only memory, EPROM), a card, a stick, or a key drive), or a semiconductor medium (for example, a solid-state disk (solid-state disk, SSD), a USB flash drive, a read-only memory (read-only memory, ROM), or a random access memory (random access memory, RAM)).

Various storage media described in this specification may indicate one or more devices and/or other machine-readable media that are configured to store information. The term "machine-readable media" may include but is not limited to a radio channel and various other media that can store, include, and/or carry instructions and/or data.

It should be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It may be further understood that the memory mentioned in embodiments of this application may be a volatile memory or a nonvolatile memory, or may include a volatile memory and a nonvolatile memory. The nonvolatile memory may be a read-only memory (read-only memory, ROM), a programmable ROM (programmable ROM, PROM), an erasable programmable read-only memory (erasable PROM, EPROM), an electrically EPROM (electrically EPROM, EEPROM), or a flash memory. The volatile memory may be a random access memory (random access memory, RAM). For example, the RAM may be used as an external cache. As an example instead of a limitation, the RAM may include the following plurality of forms: a static RAM (static RAM, SRAM), a dynamic RAM (dynamic RAM, DRAM), a synchronous DRAM (synchronous DRAM, SDRAM), a double data rate SDRAM (double data rate SDRAM, DDR SDRAM), an enhanced SDRAM (enhanced SDRAM, ESDRAM), a synchlink DRAM (synchlink DRAM, SLDRAM), and a direct rambus RAM (direct rambus RAM, DR RAM).

It should be noted that when the processor is a general-purpose processor, a DSP, an ASIC, an FPGA, another programmable logic device, a discrete gate or a transistor logic device, or a discrete hardware component, the memory (storage module) may be integrated into the processor

It should further be noted that the memory described in this specification aims to include but is not limited to these memories and any memory of another proper type.

In the several embodiments provided in this application, it should be understood that the disclosed apparatuses and methods may be implemented in other manners. For example, the foregoing apparatus embodiments are only examples. For example, division into the foregoing units is only logical function division, and may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in an electronic form, a mechanical form, or another form.

The foregoing units described as separate parts may or may not be physically separate, and parts displayed as units may or may not be physical units, may be located in one position, or may be distributed on a plurality of network units. Some or all of the units may be selected based on actual requirements to implement the solutions provided in this application.

In addition, function units in embodiments of this application may be integrated into one unit, or each of the units may exist alone physically, or two or more units are integrated into one unit.

All or some of the foregoing embodiments may be implemented by using software, hardware, firmware, or any combination thereof.

When software is used to implement the embodiments, all or a part of the embodiments may be implemented in a form of a computer program product. The computer program product includes one or more computer instructions. When the computer program instructions are loaded and executed on a computer, the procedure or functions according to embodiments of this application are completely or partially generated. The computer may be a general-purpose computer, a dedicated computer, a computer network, or another programmable apparatus. For example, the computer may be a personal computer, a server, or a network device. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. For the computer-readable storage medium, refer to the foregoing descriptions.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims and this specification.

**Claims**

1. An encoding method, comprising:

   obtaining information bits;
   determining a target kernel matrix, wherein the target kernel matrix is obtained by adjusting an original kernel matrix; and
   performing polar encoding on the information bits based on the target kernel matrix.

2. The encoding method according to claim 1, wherein a dimension of the target kernel matrix is less than a dimension of the original kernel matrix.

3. The encoding method according to claim 1, wherein the target kernel matrix is obtained by adjusting a partial distance of the original kernel matrix.

4. The encoding method according to claim 3, wherein the target kernel matrix is obtained by adjusting the partial distance of the original kernel matrix according to a depth-first search algorithm.

5. The encoding method according to claim 4, wherein when processing is performed according to the depth-first search algorithm, one or more of the following constraints are used for processing:

   a candidate line set M meets: $M[i] = \left\{ v_0^{l-1} \in F_2^l \mid wt\left(v_0^{l-1}\right) = D_i \right\}$ ; or

   when the $i^{th}$ line is selected from the bottom in the candidate line set M, a Hamming weight of a selected line $v$ is greater than or equal to $D_i$; or selecting the line $v$ from the candidate line set M and performing partial distance calculation on the line $v$ and a constructed line, wherein if $c \in C_{\overline{K}}^{(\varphi+1)} \oplus \overline{K}[\varphi]$ , and $wt(c) < D_\varphi$, the line $v$ is directly discarded, and a new line from the candidate line set M is selected; or

   a line that belongs to a same coset is not selected again, wherein

   i indicates a line number, $i \in [0, l-1]$, $wt(v)$ and $wt(c)$ both indicate the Hamming weight, $\overline{K}$ indicates a currently constructed kernel matrix $K$, $\overline{K}[\varphi]$ indicates the $\varphi^{th}$ line of the kernel matrix $\overline{K}$, $D_i$ and $D_\varphi$ both indicate the partial distance, $C_{\overline{K}}^{(\varphi+1)}$ indicates a code corresponding to the kernel matrix $\overline{K}$, and $\oplus$ indicates a logical operation.

6. The encoding method according to any one of claims 1 to 5, wherein
   the original kernel matrix is a kernel matrix $K_{24}$ whose dimension is (24×24), and the $K_{24}$ is:

$$
\begin{array}{cccccccccccccccccccccccc}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 1 & 0 & 0 & 0 & 1 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{array}
$$

7. The encoding method according to any one of claims 1 to 6, wherein the target kernel matrix is any one of the following:

$$
K_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 1 & 0 & 0 & 0 & 1 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 0 & 1 & 0 & 0 & 0 & 0 & 0 & 1 & 0 & 1 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 1 & 1 & 0 & 0 & 0 & 0 & 0 & 0 \\
1 & 1 & 0 & 0 & 0 & 0 & 0 & 0 & 1 & 1 & 0 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 1 & 1 & 0 & 0 & 1 & 1 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 1 & 1 & 1 & 1 & 1 & 1 & 1 & 1
\end{pmatrix} ;
$$

or

$$K'_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 1 & 0 & 0 & 1 & 0 & 0 & 0 & 1 & 0 & 0 & 0 & 1 & 0 & 0 & 0 & 0 \\
1 & 0 & 1 & 0 & 1 & 1 & 0 & 0 & 0 & 0 & 0 & 0 & 0 & 0 & 0 & 0 & 0 & 0 & 0 & 0 \\
0 & 0 & 0 & 0 & 1 & 1 & 0 & 0 & 1 & 0 & 1 & 0 & 1 & 0 & 1 & 0 & 0 & 0 & 0 & 0 \\
1 & 0 & 1 & 0 & 1 & 1 & 0 & 0 & 0 & 0 & 0 & 0 & 1 & 0 & 1 & 0 & 1 & 0 & 1 & 0 \\
0 & 1 & 1 & 0 & 1 & 1 & 0 & 0 & 1 & 0 & 1 & 0 & 0 & 0 & 0 & 1 & 1 & 0 & 0 & 0 \\
1 & 0 & 1 & 0 & 1 & 0 & 1 & 0 & 1 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix} ;$$

or

$$K''_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 1 & 0 & 0 & 0 & 0 & 0 & 0 & 1 & 0 & 0 & 0 & 0 & 0 & 0 & 0 \\
1 & 1 & 0 & 0 & 0 & 1 & 0 & 0 & 0 & 0 & 0 & 0 & 0 & 0 & 0 & 0 & 1 & 0 & 0 & 0 \\
0 & 0 & 0 & 1 & 0 & 1 & 1 & 1 & 0 & 0 & 0 & 0 & 0 & 0 & 0 & 0 & 0 & 0 & 0 & 0 \\
1 & 1 & 1 & 0 & 1 & 0 & 0 & 0 & 0 & 0 & 0 & 0 & 0 & 0 & 0 & 0 & 0 & 0 & 0 & 0 \\
1 & 0 & 1 & 1 & 1 & 0 & 0 & 1 & 0 & 0 & 1 & 0 & 0 & 0 & 0 & 0 & 0 & 0 & 0 & 0 \\
1 & 1 & 0 & 1 & 1 & 0 & 1 & 0 & 1 & 0 & 0 & 0 & 0 & 0 & 0 & 0 & 0 & 0 & 0 & 0 \\
1 & 0 & 1 & 1 & 0 & 1 & 0 & 0 & 1 & 0 & 0 & 0 & 1 & 0 & 0 & 0 & 1 & 0 & 1 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 \\
0 & 0 & 1 & 1 & 1 & 1 & 1 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix} ;$$

or

$$K_{21}=\begin{pmatrix}
1&0&0&0&0&0&0&0&0&0&0&0&0&0&0&0&0&0&0&0\\
1&0&0&0&0&0&0&1&0&0&0&0&0&0&0&0&0&0&0&0\\
1&0&1&0&0&0&0&0&0&0&0&0&0&0&0&0&0&0&0&0\\
1&1&0&0&0&0&0&0&0&0&0&0&0&0&0&0&0&0&0&0\\
1&0&0&0&1&0&0&0&0&0&0&0&0&0&0&0&0&0&0&0\\
0&1&0&1&0&0&0&0&0&0&0&0&0&0&0&0&0&0&0&0\\
1&1&1&0&1&0&0&0&0&0&0&0&0&0&0&0&0&0&0&0\\
0&0&1&1&1&0&1&0&0&0&0&0&0&0&0&0&0&0&0&0\\
0&1&0&0&1&0&0&1&0&1&0&0&0&0&0&0&0&0&0&0\\
0&0&0&1&0&1&1&1&0&0&0&0&0&0&0&0&0&0&0&0\\
1&0&1&0&1&0&1&0&0&0&1&0&0&0&1&0&0&0&0&0\\
1&1&1&0&0&0&0&0&1&1&0&0&0&1&0&0&0&0&0&0\\
1&0&1&1&0&0&1&1&0&0&0&1&0&0&0&0&0&0&0&0\\
1&0&0&1&0&0&0&0&1&1&0&1&1&0&0&0&0&0&0&0\\
1&0&1&0&0&0&1&0&1&0&1&1&1&0&0&0&1&0&0&0\\
1&0&1&0&1&0&0&1&0&1&0&1&0&1&0&1&0&0&0&0\\
1&1&0&1&0&1&0&1&1&1&0&0&0&0&0&0&0&0&0&0\\
1&1&0&0&1&1&0&0&1&1&0&0&1&1&0&0&0&0&1&0\\
1&1&1&1&0&0&0&1&1&1&1&0&0&0&0&0&1&0&0\\
1&1&1&1&1&1&1&1&0&0&0&0&0&0&0&0&1&1&1\\
1&1&1&1&1&1&1&1&1&1&1&1&1&1&1&1&0&0&0
\end{pmatrix}\ ;$$

or

$$K'_{21}=\begin{pmatrix}
1&0&0&0&0&0&0&0&0&0&0&0&0&0&0&0&0&0&0&0\\
1&0&0&0&1&0&0&0&0&0&0&0&0&0&0&0&0&0&0&0\\
1&0&0&1&0&0&0&0&0&0&0&0&0&0&0&0&0&0&0&0\\
1&0&0&0&1&0&0&0&0&0&0&0&0&0&0&0&0&0&0&0\\
1&0&1&0&0&0&0&0&0&0&0&0&0&0&0&0&0&0&0&0\\
1&1&0&0&0&0&0&0&0&0&0&0&0&0&0&0&0&0&0&0\\
1&0&0&1&1&0&0&1&0&0&0&0&0&0&0&0&0&0&0&0\\
0&0&1&1&1&0&0&0&1&0&0&0&0&0&0&0&0&0&0&0\\
0&0&1&0&0&1&1&1&0&0&0&0&0&0&0&0&0&0&0&0\\
0&1&1&0&1&0&1&1&0&0&0&0&0&1&0&0&0&0&0&0\\
1&0&0&0&0&0&0&0&1&1&1&0&0&0&0&0&0&0&0&0\\
0&1&1&1&0&1&1&0&0&0&0&1&0&0&0&0&0&0&0&0\\
0&1&0&0&0&1&1&1&0&1&0&0&0&1&0&0&0&0&0&0\\
1&0&1&1&0&1&0&1&0&0&1&0&0&0&0&0&0&0&0&0\\
1&1&0&0&1&1&0&0&1&0&0&0&1&0&1&0&1&0&0&0\\
1&0&1&1&0&1&0&0&1&0&1&0&1&1&0&0&1&0&1&0&0\\
0&0&0&0&1&1&0&1&1&0&0&1&1&1&1&0&0&0&0&0\\
1&1&0&0&0&1&1&0&1&1&1&0&0&0&0&0&0&0&0&0\\
1&1&1&1&0&0&0&1&1&0&0&0&0&0&0&0&0&0&0&1\\
1&1&1&1&1&1&1&0&0&0&0&0&0&0&0&0&1&1&0\\
1&1&1&1&1&1&1&1&1&1&1&1&1&1&1&1&1&1&0&0&0
\end{pmatrix}\ ;$$

or

$$K_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 1 & 0 & 0 & 0 & 1 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 1 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 1 & 0 & 1 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix} ;$$

or

$$K'_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 1 & 0 & 1 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
1 & 0 & 1 & 0 & 1 & 0 & 1 & 0 & 1 & 1 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix} ;$$

or

$$K_{24}'' = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
0 & 1 & 1 & 1 & 0 & 0 & 1 & 0 & 1 & 0 & 0 & 0 & 1 & 0 & 0 & 0 & 1 & 0 & 1 & 0 & 0 & 0 & 0 & 0 \\
1 & 0 & 1 & 0 & 1 & 0 & 1 & 0 & 1 & 1 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix};$$

or

$$K_{25} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 1 & 0 & 0 & 0 & 1 & 0 & 0 & 0 & 0 & 0 & 0 & 0 & 0 & 0 & 0 & 0 & 0 \\
1 & 0 & 1 & 0 & 1 & 0 & 0 & 0 & 0 & 1 & 0 & 0 & 0 & 0 & 0 & 0 & 0 & 0 & 0 & 0 & 0 & 0 & 0 & 0 \\
0 & 0 & 0 & 1 & 1 & 0 & 0 & 0 & 0 & 0 & 0 & 1 & 1 & 0 & 0 & 0 & 0 & 0 & 0 & 0 & 0 & 0 & 0 & 0 \\
1 & 1 & 0 & 0 & 0 & 1 & 1 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 0 & 0 & 0 & 0 & 1 & 0 & 0 & 1 & 1 & 0 & 0 & 0 & 0 & 0 & 0 & 0 & 0 \\
0 & 0 & 0 & 0 & 0 & 1 & 1 & 1 & 0 & 0 & 0 & 1 & 0 & 1 & 0 & 0 & 1 & 0 & 0 & 0 & 0 & 0 & 0 & 0 \\
1 & 0 & 0 & 0 & 1 & 1 & 1 & 0 & 1 & 0 & 0 & 0 & 0 & 0 & 0 & 0 & 0 & 0 & 0 & 0 & 0 & 0 & 0 & 0 \\
1 & 1 & 1 & 0 & 1 & 0 & 0 & 1 & 1 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 1 & 0 & 1 & 0 & 1 & 0 & 0 & 0 & 0 & 1 & 0 & 0 & 0 & 0 & 1 & 0 & 0 \\
0 & 0 & 1 & 0 & 1 & 1 & 0 & 1 & 1 & 1 & 0 & 0 & 1 & 0 & 1 & 0 & 0 & 0 & 0 & 0 & 0 & 0 & 0 & 0 \\
1 & 1 & 1 & 1 & 1 & 1 & 0 & 0 & 0 & 1 & 0 & 0 & 0 & 0 & 0 & 0 & 0 & 0 & 0 & 0 & 0 & 0 & 0 & 0 \\
1 & 1 & 0 & 0 & 1 & 0 & 1 & 0 & 1 & 1 & 0 & 0 & 0 & 0 & 0 & 1 & 0 & 0 & 0 & 0 & 0 & 0 & 0 & 0 \\
1 & 0 & 1 & 1 & 0 & 1 & 1 & 1 & 0 & 1 & 0 & 0 & 0 & 0 & 0 & 1 & 0 & 0 & 0 & 0 & 0 & 0 & 0 & 0 \\
1 & 1 & 0 & 1 & 0 & 1 & 0 & 1 & 0 & 1 & 0 & 1 & 0 & 1 & 0 & 0 & 0 & 1 & 0 & 1 & 0 & 1 & 0 & 0 \\
1 & 1 & 1 & 0 & 0 & 1 & 1 & 0 & 0 & 1 & 1 & 0 & 0 & 1 & 1 & 0 & 0 & 0 & 1 & 0 & 0 & 1 & 1 & 0 \\
1 & 1 & 1 & 1 & 0 & 0 & 0 & 1 & 1 & 1 & 1 & 0 & 0 & 0 & 0 & 1 & 1 & 1 & 0 & 0 & 0 & 0 & 0 & 0 \\
1 & 1 & 1 & 1 & 1 & 1 & 1 & 1 & 0 & 0 & 0 & 0 & 0 & 0 & 0 & 1 & 1 & 1 & 1 & 1 & 1 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix}$$

or

$$K'_{25} = \begin{pmatrix}
1&0&0&0&0&0&0&0&0&0&0&0&0&0&0&0&0&0&0&0&0&0&0&0&0&0&0&0&0&0\\
1&0&0&1&0&0&0&0&0&0&0&0&0&0&0&0&0&0&0&0&0&0&0&0&0&0&0&0&0&0\\
1&1&0&0&0&0&0&0&0&0&0&0&0&0&0&0&0&0&0&0&0&0&0&0&0&0&0&0&0&0\\
1&0&1&0&0&0&0&0&0&0&0&0&0&0&0&0&0&0&0&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&0&1&0&0&0&0&0&0&0&0&0&0&0&0&0&0&0&0&0&0&0&0&0\\
0&0&1&0&1&0&0&0&1&1&0&0&0&0&0&0&0&0&0&0&0&0&0&0&0&0&0&0&0&0\\
1&1&0&0&0&0&0&1&0&0&0&0&0&0&0&1&0&0&0&0&0&0&0&0&0&0&0&0&0&0\\
1&0&1&0&0&0&0&1&0&0&1&0&0&0&0&0&0&0&0&0&0&0&0&0&0&0&0&0&0&0\\
1&0&0&0&0&0&0&1&0&1&0&0&0&0&0&0&0&0&0&0&1&0&0&0&0&0&0&0&0&0\\
0&1&1&0&1&0&1&0&0&0&0&0&0&0&0&0&0&0&0&0&0&0&0&0&0&0&0&0&0&0\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&0&1&1&1&0&1&0&1&0&0&0&0&0&0&0&1&0&0&0&0&0&0&0&0&0&0&0&1\\
0&1&1&0&1&1&0&0&0&0&1&0&1&0&0&0&1&0&0&0&1&0&0&0&0&0&0&0&0&0\\
1&1&0&1&1&0&0&0&1&0&0&0&1&0&0&0&1&0&1&0&0&0&0&0&0&0&0&0&0&0\\
0&1&1&0&1&0&1&0&1&1&0&0&0&0&0&0&1&1&0&0&0&0&0&0&0&0&0&0&0&0\\
1&0&1&0&1&0&1&0&1&0&1&0&1&0&0&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&1&0&0&0&0&0&0&0&0&0&0&0&0&0&0&0&0&0&0\\
1&1&1&1&1&1&1&0&0&0&0&0&0&0&0&0&0&0&0&0&0&0&0&0&0&0&0&0&0&0\\
1&1&0&0&1&1&0&0&1&1&0&0&1&1&0&0&1&1&0&0&1&1&0&0&1&1&0&0&0&0\\
1&1&1&0&0&0&0&1&1&1&0&0&0&0&0&1&1&1&1&0&0&0&0&0&0&0\\
1&1&1&1&1&1&1&0&0&0&0&0&0&0&0&1&1&1&1&1&1&1&0\\
1&1&1&1&1&1&1&1&1&1&1&1&1&1&1&1&0&0&0&0&0&0&0&0&0
\end{pmatrix} ;$$

or

$$K_{28} = \begin{pmatrix}
1&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&1&0&0&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&1&0&0&0&0&0&0&1&0&0&1&0&0&0&0&0&0&0&0&0&0&0&0\\
1&0&0&0&1&0&0&0&0&0&0&0&0&0&0&0&0&0&0&0&0&0&0&0&0&0&0&0&0&0\\
1&0&0&0&1&0&0&0&0&0&0&0&0&0&0&1&0&1&0&0&0&0&0&0&0&0&0&0&0&0\\
1&0&1&0&0&0&0&0&0&0&0&0&0&0&0&0&0&0&0&0&0&0&0&0&0&0&0&0&0&0\\
0&0&0&0&0&0&0&1&0&1&0&0&0&0&0&0&0&0&1&0&1&0&0&0&0&0&0&0\\
1&0&0&0&1&0&0&0&0&0&1&0&1&0&0&0&0&0&0&0&1&0&1&0&0&0&0&0&0&0\\
1&0&0&0&1&0&0&0&1&0&0&0&1&0&0&0&1&0&1&0&1&0&0&0&1&0&0&0\\
1&1&0&0&0&0&0&0&0&0&0&0&0&0&0&0&0&0&0&0&0&0&0&0&0&0&0&0&0&0\\
1&1&0&0&0&0&0&0&0&0&0&0&0&0&0&1&1&0&0&0&0&0&0&0&0&0&0&0&0&0\\
0&1&1&0&0&0&0&1&0&1&0&0&0&0&0&1&1&0&0&0&0&0&0&0&0&0&0&0&0&0\\
1&0&1&0&1&0&1&0&0&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0&0&0\\
1&1&0&0&0&0&0&1&1&0&0&0&0&0&1&1&0&0&1&1&0&0&0&0&0&0\\
1&1&0&0&0&0&0&0&1&1&0&1&0&1&0&1&1&0&0&0&1&1&0&1&0&1&0\\
1&1&0&0&1&1&0&0&0&0&0&0&0&0&0&0&0&0&0&0&0&0&0&0&0&0&0&0\\
1&1&0&0&1&1&0&0&0&0&0&0&0&0&1&1&1&0&0&0&0&0&0&0&0&0\\
0&1&1&0&0&1&1&0&1&0&1&0&1&0&1&0&1&1&1&0&0&0&0&0&0&0&0\\
1&1&1&1&0&0&0&0&0&0&0&0&0&0&0&0&0&0&0&0&0&0&0&0&0&0&0&0\\
0&0&0&0&0&0&0&1&1&1&0&0&0&0&0&0&1&1&1&0&0&0&0\\
1&1&0&0&1&1&0&0&0&1&1&1&0&0&0&0&1&1&1&0&0&0&0\\
1&1&0&0&1&1&0&0&1&1&0&0&1&1&0&0&1&1&1&1&1&1&0&0&1&1&0&0\\
1&1&1&1&0&0&0&0&1&1&1&0&0&0&0&0&0&0&0&0&0&0&0&0&0\\
1&1&1&1&1&1&1&0&0&0&0&0&0&0&0&0&0&0&0&0&0&0&0\\
0&0&0&0&0&0&0&1&1&1&1&1&1&1&0&0&0&0&1&1&1&1&1&1&1\\
1&1&1&1&1&1&1&1&1&1&1&1&1&1&1&1&0&0&0&0&0&0&0&0&0&0&0
\end{pmatrix} ;$$

or

$$K_{32} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 1 & 0 & 0 & 0 & 0 & 0 & 0 & 1 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 1 & 0 & 0 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 1 & 0 & 1 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 1 & 1 & 0 & 0 & 0 & 0 & 0 & 0 & 0 & 0 & 0 & 0 & 0 & 0 & 0 & 0 & 0 & 0 \\
0 & 1 & 1 & 0 & 0 & 0 & 0 & 1 & 0 & 1 & 0 & 0 & 0 & 0 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 1 & 0 & 1 & 0 & 0 & 0 & 0 & 1 & 0 & 1 & 0 & 0 & 0 & 0 & 1 & 0 & 1 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 1 & 1 & 0 & 0 & 0 & 0 & 0 & 1 & 1 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 1 & 1 & 0 & 1 & 0 & 1 & 0 & 1 & 1 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 1 & 1 & 0 & 0 & 1 & 1 & 0 & 0 & 0 & 0 & 0 & 0 & 0 & 0 & 0 & 0 & 0 & 0 \\
0 & 1 & 1 & 0 & 0 & 1 & 1 & 0 & 1 & 0 & 1 & 0 & 1 & 0 & 1 & 0 & 1 & 1 & 0 & 0 & 1 & 1 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 1 & 1 & 1 & 1 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1
\end{pmatrix}$$

.

8. A decoding method, comprising:

 obtaining a to-be-decoded sequence; and
 decoding the to-be-decoded sequence based on a plurality of trellises, and reusing an intermediate result obtained through decoding performed based on a first trellis in the plurality of trellises when decoding is performed based on a second trellis in the plurality of trellises, wherein
 the first trellis is used for a $t^{th}$ stage of decoding the to-be-decoded sequence, the second trellis is used for a $(t+i)^{th}$ stage of decoding the to-be-decoded sequence, t is an integer greater than 0 or equal to 0, and i is an integer greater than 1 or equal to 1.

9. The decoding method according to claim 8, wherein each of the plurality of trellises is split into a plurality of sub-trellises.

10. The decoding method according to claim 9, wherein locations of split points of the plurality of sub-trellises are related to decoding complexity.

11. The decoding method according to any one of claims 8 to 10, wherein the decoding method further comprises: determining, based on a correlation between the first trellis and the second trellis, whether to reuse the intermediate result obtained through decoding performed based on the first trellis when decoding is performed based on the second trellis.

12. The decoding method according to any one of claims 8 to 11, wherein the decoding method further comprises: determining, based on the following information, whether to reuse the intermediate result obtained through decoding performed based on the first trellis when decoding is performed based on the second trellis:

 a code obtained by performing a shortening operation on a linear code C in the $(t+i)^{th}$ stage of decoding and a code obtained by performing the shortening operation on the linear code C in the $t^{th}$ stage of decoding; and/or
 a code obtained by performing a puncturing operation on the linear code C in the $(t+i)^{th}$ stage of decoding and a code obtained by performing the puncturing operation on the linear code C in the $t^{th}$ stage of decoding.

13. The decoding method according to claim 12, comprising:

 if $s_{x,y}(C^{(t+i)})=s_{x,y}(C^{(t)})$, and $p_{x,y}(C^{(t+i)}) \subset p_{x,y}(C^{(t)})$, reusing the intermediate result obtained through decoding performed based on the first trellis when decoding is performed based on the second trellis; and

if $s_{x,y}(C^{(t+i)}) \subset s_{x,y}(C^{(t)})$, reusing the intermediate result obtained through decoding performed based on the first trellis when decoding is performed based on the second trellis, wherein

$s_{x,y}(C^{(t+i)})$ indicates a code obtained by performing the shortening operation on the linear code C at a location except $x \leq z < y$ in the $(t+i)^{th}$ stage of decoding, $s_{x,y}(C^{(t)})$ indicates a code obtained by performing the shortening operation on the linear code C at the location except $x \leq z < y$ in the $t^{th}$ stage of decoding, $p_{x,y}(C^{(t+i)})$ indicates a code obtained by performing the puncturing operation on the linear code C at the location except $x \leq z < y$ in the $(t+i)^{th}$ stage of decoding, and $p_{x,y}(C^{(t)})$ indicates a code obtained by performing the puncturing operation on the linear code C at the location except $x \leq z < y$ in the $t^{th}$ stage of decoding.

14. The decoding method according to any one of claims 8 to 13, wherein
the reusing the intermediate result obtained through decoding performed based on the first trellis when decoding is performed based on the second trellis comprises:

when processing is performed based on the second trellis in the $(t+i)^{th}$ stage of decoding, directly using the intermediate result obtained through decoding performed based on the first trellis as an intermediate result obtained through decoding performed based on the second trellis; or

when processing is performed based on the second trellis in the $(t+i)^{th}$ stage of decoding, performing processing based on a result of a maximization operation in a process of the first trellis.

15. An encoding apparatus, comprising a transceiver unit and a processing unit, wherein

the transceiver unit is configured to obtain information bits;
the processing unit is configured to determine a target kernel matrix, wherein the target kernel matrix is obtained by adjusting an original kernel matrix; and
the processing unit is further configured to perform polar encoding on the information bits based on the target kernel matrix.

16. The encoding apparatus according to claim 15, wherein
a dimension of the target kernel matrix is less than a dimension of the original kernel matrix.

17. The encoding apparatus according to claim 15, wherein
the target kernel matrix is obtained by adjusting a partial distance of the original kernel matrix.

18. The encoding apparatus according to claim 17, wherein the target kernel matrix is obtained by adjusting the partial distance of the original kernel matrix according to a depth-first search algorithm.

19. The encoding apparatus according to claim 18, wherein when processing is performed according to the depth-first search algorithm, the processing unit is further configured to process by using one or more of the following constraints:

a candidate line set M meets: $M[i] = \left\{ v_0^{l-1} \in F_2^l \mid wt\left(v_0^{l-1}\right) = D_i \right\}$ ; or

when the $i^{th}$ line is selected from the bottom in the candidate line set M, a Hamming weight of a selected line $v$ is greater than or equal to $D_i$; or selecting the line $v$ from the candidate line set M and performing partial distance calculation on the line v and a constructed line, wherein if $c \in C_{\overline{K}}^{(\varphi+1)} \oplus \overline{K}[\varphi]$ , and $wt(c) < D_\varphi$, the line $v$ is directly discarded, and a new line from the candidate line set M is selected; or

a line that belongs to a same coset is not selected again, wherein

i indicates a line number, $i \in [0, l-1]$, $wt(v)$ and $wt(c)$ both indicate the Hamming weight, $\overline{K}$ indicates a currently constructed kernel matrix $K$, $\overline{K}[\varphi]$ indicates the $\varphi^{th}$ line of the kernel matrix $\overline{K}$, $D_i$ and $D_\varphi$ both indicate the partial distance, $C_{\overline{K}}^{(\varphi+1)}$ ($C^{(2)}$) indicates a code corresponding to the kernel matrix $\overline{K}$, and $\oplus$ indicates a logical operation.

20. The encoding apparatus according to any one of claims 15 to 19, wherein the original kernel matrix is a kernel matrix $K_{24}$ whose dimension is (24×24), and the $K_{24}$ is:

$$
\begin{array}{cccccccccccccccccccccccc}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 1 & 0 & 0 & 0 & 1 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 1 & 0 & 0 & 000 & 0 & 0 & 0 & 0
\end{array}
$$

21. The encoding apparatus according to any one of claims 15 to 20, wherein the target kernel matrix is any one of the following:

$$
K_{20} =
\begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 1 & 0 & 0 & 0 & 1 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 0 & 1 & 0 & 0 & 0 & 0 & 0 & 1 & 0 & 1 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 1 & 1 & 0 & 0 & 0 & 0 & 0 & 0 \\
1 & 1 & 0 & 0 & 0 & 0 & 0 & 0 & 1 & 1 & 0 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 1 & 1 & 0 & 0 & 1 & 1 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 1 & 1 & 1 & 1 & 0 & 0 & 0 & 0 \\
1 & 1 & 1 & 1 & 1 & 1 & 1 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 1 & 1 & 1 & 1 & 1 & 1 & 1 & 1
\end{pmatrix}
$$

;

or

$$K'_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 1 & 0 & 0 & 0 & 1 & 0 & 0 & 0 & 1 & 0 & 0 & 0 & 1 & 0 & 0 & 0 \\
1 & 0 & 1 & 0 & 1 & 1 & 0 & 0 & 0 & 0 & 0 & 0 & 0 & 0 & 0 & 0 & 0 & 0 & 0 & 0 \\
0 & 0 & 0 & 0 & 1 & 1 & 0 & 0 & 1 & 0 & 1 & 0 & 1 & 0 & 1 & 0 & 0 & 0 & 0 & 0 \\
1 & 0 & 1 & 0 & 1 & 1 & 0 & 0 & 0 & 0 & 0 & 0 & 1 & 0 & 1 & 0 & 1 & 0 & 1 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix} ;$$

or

$$K''_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 1 & 0 & 0 & 0 & 0 & 0 & 0 & 1 & 0 & 0 & 0 & 0 & 0 & 0 & 0 \\
1 & 1 & 0 & 0 & 0 & 1 & 0 & 0 & 0 & 0 & 0 & 0 & 0 & 0 & 0 & 1 & 0 & 0 & 0 & 0 \\
0 & 0 & 0 & 1 & 0 & 1 & 1 & 1 & 0 & 0 & 0 & 0 & 0 & 0 & 0 & 0 & 0 & 0 & 0 & 0 \\
1 & 1 & 1 & 0 & 1 & 0 & 0 & 0 & 0 & 0 & 0 & 0 & 0 & 0 & 0 & 0 & 0 & 0 & 0 & 0 \\
1 & 0 & 1 & 1 & 1 & 0 & 0 & 1 & 0 & 0 & 1 & 0 & 0 & 0 & 0 & 0 & 0 & 0 & 0 & 0 \\
1 & 1 & 0 & 1 & 1 & 0 & 1 & 0 & 1 & 0 & 0 & 0 & 0 & 0 & 0 & 0 & 0 & 0 & 0 & 0 \\
1 & 0 & 1 & 1 & 0 & 1 & 0 & 0 & 1 & 0 & 0 & 0 & 1 & 0 & 0 & 0 & 1 & 0 & 1 & 0 \\
0 & 1 & 1 & 0 & 1 & 1 & 0 & 0 & 1 & 0 & 1 & 0 & 0 & 0 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 \\
0 & 0 & 1 & 1 & 1 & 1 & 1 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0
\end{pmatrix}$$

; or

$$K_{21}=\begin{pmatrix}
1&0&0&0&0&0&0&0&0&0&0&0&0&0&0&0&0&0&0&0&0&0\\
1&0&0&0&0&0&0&1&0&0&0&0&0&0&0&0&0&0&0&0&0&0\\
1&0&1&0&0&0&0&0&0&0&0&0&0&0&0&0&0&0&0&0&0&0\\
1&1&0&0&0&0&0&0&0&0&0&0&0&0&0&0&0&0&0&0&0&0\\
1&0&0&0&0&1&0&0&0&0&0&0&0&0&0&0&0&0&0&0&0&0\\
0&1&0&1&0&0&0&0&0&0&0&0&0&0&0&0&0&0&0&0&0&0\\
1&1&1&0&1&0&0&0&0&0&0&0&0&0&0&0&0&0&0&0&0&0\\
0&0&1&1&1&0&1&0&0&0&0&0&0&0&0&0&0&0&0&0&0&0\\
0&1&0&0&1&0&0&1&0&1&0&0&0&0&0&0&0&0&0&0&0&0\\
0&0&0&1&0&1&1&1&0&0&0&0&0&0&0&0&0&0&0&0&0&0\\
1&0&1&0&1&0&1&0&0&0&1&0&0&0&1&0&0&0&0&0&0&0\\
1&1&1&0&0&0&0&0&1&1&0&0&0&1&0&0&0&0&0&0&0&0\\
1&0&1&1&0&0&1&1&0&0&0&1&0&0&0&0&0&0&0&0&0&0\\
1&0&0&1&0&0&0&0&1&1&0&1&1&0&0&0&0&0&0&0&0&0\\
1&0&1&0&0&0&1&0&1&0&1&1&1&0&0&0&1&0&0&0&0&0\\
1&0&1&0&1&0&0&1&0&1&0&1&0&1&0&1&0&0&0&0&0&0\\
1&1&0&1&0&1&0&1&1&1&1&0&0&0&0&0&0&0&0&0&0&0\\
1&1&1&0&0&1&1&0&0&1&1&0&0&1&1&0&0&0&0&1&0\\
1&1&1&1&0&0&0&1&1&1&1&0&0&0&0&0&1&0&0\\
1&1&1&1&1&1&1&1&0&0&0&0&0&0&0&0&1&1&1\\
1&1&1&1&1&1&1&1&1&1&1&1&1&1&1&1&1&0&0&0
\end{pmatrix};$$

or

$$K'_{21}=\begin{pmatrix}
1&0&0&0&0&0&0&0&0&0&0&0&0&0&0&0&0&0&0&0&0\\
1&0&0&0&1&0&0&0&0&0&0&0&0&0&0&0&0&0&0&0&0\\
1&0&0&1&0&0&0&0&0&0&0&0&0&0&0&0&0&0&0&0&0\\
1&0&0&0&1&0&0&0&0&0&0&0&0&0&0&0&0&0&0&0&0\\
1&0&1&0&0&0&0&0&0&0&0&0&0&0&0&0&0&0&0&0&0\\
1&1&0&0&0&0&0&0&0&0&0&0&0&0&0&0&0&0&0&0&0\\
1&0&0&1&1&0&0&1&0&0&0&0&0&0&0&0&0&0&0&0&0\\
0&0&1&1&1&0&0&0&1&0&0&0&0&0&0&0&0&0&0&0&0\\
0&0&1&0&0&1&1&1&0&0&0&0&0&0&0&0&0&0&0&0&0\\
0&1&1&0&1&0&1&1&0&0&0&0&0&0&1&0&0&0&0&0&0\\
1&0&0&0&0&0&0&1&1&1&0&0&0&0&0&0&0&0&0&0&0\\
0&1&1&1&0&1&1&0&0&0&0&1&0&0&0&0&0&0&0&0&0\\
0&1&0&0&0&1&1&1&0&1&0&0&0&1&0&0&0&0&0&0&0\\
1&0&1&1&0&1&0&1&0&0&1&0&0&0&0&0&0&0&0&0&0\\
1&1&0&0&1&1&0&0&1&0&0&0&1&0&1&0&0&0&0&0&0\\
1&0&1&1&0&1&0&0&1&0&1&0&1&1&0&0&1&0&1&0&0\\
0&0&0&0&0&1&1&0&1&1&0&0&1&1&1&1&0&0&0&0&0\\
1&1&0&0&0&1&1&0&1&1&1&0&0&0&0&0&0&0&0\\
1&1&1&1&1&0&0&0&1&1&0&0&0&0&0&0&0&0&1\\
1&1&1&1&1&1&1&0&0&0&0&0&0&0&0&0&1&1&0\\
1&1&1&1&1&1&1&1&1&1&1&1&1&1&1&1&1&0&0&0
\end{pmatrix};$$

or

$$K_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 1 & 0 & 0 & 0 & 1 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix};$$

, or

$$K'_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 1 & 0 & 1 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix};$$

or

$$K_{24}'' = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
0 & 1 & 1 & 1 & 0 & 0 & 1 & 0 & 1 & 0 & 0 & 0 & 1 & 0 & 0 & 0 & 1 & 0 & 1 & 0 & 0 & 0 & 0 & 0 \\
1 & 0 & 1 & 0 & 1 & 0 & 1 & 0 & 1 & 1 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix};$$

or

$$K_{25} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 1 & 0 & 0 & 0 & 0 & 1 & 0 & 0 & 0 & 0 & 0 & 0 & 0 & 0 & 0 & 0 & 0 & 0 \\
1 & 0 & 1 & 0 & 1 & 0 & 0 & 0 & 0 & 0 & 1 & 0 & 0 & 0 & 0 & 0 & 0 & 0 & 0 & 0 & 0 & 0 & 0 & 0 & 0 \\
0 & 0 & 0 & 1 & 1 & 0 & 0 & 0 & 0 & 0 & 0 & 0 & 1 & 1 & 0 & 0 & 0 & 0 & 0 & 0 & 0 & 0 & 0 & 0 & 0 \\
1 & 1 & 0 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 0 & 0 & 0 & 0 & 0 & 1 & 0 & 0 & 1 & 1 & 0 & 0 & 0 & 0 & 0 & 0 & 0 & 0 \\
0 & 0 & 0 & 0 & 0 & 1 & 1 & 1 & 0 & 0 & 1 & 0 & 1 & 0 & 0 & 1 & 0 & 0 & 0 & 0 & 0 & 0 & 0 & 0 & 0 \\
1 & 0 & 0 & 0 & 1 & 1 & 1 & 1 & 0 & 1 & 0 & 0 & 0 & 0 & 0 & 0 & 0 & 0 & 0 & 0 & 0 & 0 & 0 & 0 & 0 \\
1 & 1 & 1 & 0 & 1 & 0 & 0 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 1 & 0 & 1 & 0 & 1 & 0 & 0 & 0 & 0 & 1 & 0 & 0 & 0 & 0 & 1 & 0 & 0 & 0 \\
0 & 0 & 1 & 0 & 1 & 1 & 0 & 1 & 1 & 1 & 0 & 0 & 1 & 0 & 1 & 0 & 0 & 0 & 0 & 0 & 0 & 0 & 0 & 0 & 0 \\
1 & 1 & 1 & 1 & 1 & 0 & 0 & 0 & 1 & 0 & 0 & 0 & 0 & 0 & 0 & 0 & 0 & 0 & 0 & 0 & 0 & 0 & 0 & 0 & 0 \\
1 & 1 & 0 & 0 & 1 & 0 & 1 & 0 & 1 & 1 & 0 & 1 & 1 & 0 & 0 & 0 & 0 & 1 & 0 & 0 & 0 & 0 & 0 & 0 & 0 \\
1 & 0 & 1 & 1 & 0 & 1 & 1 & 1 & 1 & 0 & 1 & 0 & 0 & 0 & 0 & 0 & 0 & 1 & 0 & 0 & 0 & 0 & 0 & 0 & 0 \\
1 & 1 & 0 & 1 & 0 & 1 & 0 & 1 & 0 & 1 & 0 & 1 & 0 & 1 & 0 & 1 & 0 & 0 & 0 & 1 & 0 & 1 & 0 & 1 & 0 \\
1 & 1 & 1 & 0 & 0 & 1 & 1 & 0 & 0 & 1 & 1 & 0 & 0 & 1 & 1 & 0 & 0 & 0 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 0 & 0 & 0 \\
1 & 1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix}$$

or

$$K'_{25} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 0 & 1 & 1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 0 & 0 & 0 & 0 & 0 & 0 & 0 & 1 & 0 & 0 & 0 & 0 & 0 & 0 & 0 & 0 & 0 \\
1 & 0 & 1 & 0 & 0 & 0 & 0 & 1 & 0 & 0 & 0 & 1 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 1 & 0 & 0 & 0 & 0 & 0 & 0 & 0 & 0 & 0 & 0 & 0 & 1 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 1 & 1 & 1 & 0 & 1 & 0 & 1 & 0 & 0 & 0 & 0 & 0 & 1 & 0 & 0 & 0 & 0 & 0 & 0 & 0 & 0 & 1 \\
0 & 1 & 1 & 0 & 1 & 1 & 0 & 0 & 0 & 1 & 0 & 1 & 0 & 0 & 0 & 1 & 0 & 0 & 0 & 1 & 0 & 0 & 0 & 0 & 0 \\
1 & 1 & 0 & 1 & 1 & 0 & 0 & 0 & 1 & 0 & 0 & 0 & 1 & 0 & 0 & 0 & 1 & 0 & 1 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 1 & 1 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 0 \\
1 & 1 & 1 & 1 & 1 & 1 & 1 & 1 & 0 & 0 & 0 & 0 & 0 & 0 & 0 & 1 & 1 & 1 & 1 & 1 & 1 & 1 & 0 & 0 & 0 \\
1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0
\end{pmatrix} ;$$

or

$$K_{28} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 1 & 0 & 0 & 0 & 1 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 1 & 0 & 1 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 0 & 1 & 0 & 0 & 0 & 0 & 0 & 0 & 0 & 0 & 1 & 0 & 1 & 0 & 0 & 0 & 0 & 0 & 0 & 0 \\
1 & 0 & 0 & 0 & 1 & 0 & 0 & 0 & 0 & 1 & 0 & 1 & 0 & 0 & 0 & 0 & 0 & 0 & 1 & 0 & 1 & 0 & 0 & 0 & 0 & 0 & 0 & 0 \\
1 & 0 & 0 & 1 & 0 & 0 & 0 & 1 & 0 & 0 & 1 & 0 & 0 & 0 & 1 & 0 & 1 & 0 & 1 & 0 & 0 & 0 & 1 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 1 & 1 & 0 & 0 & 0 & 0 & 0 & 0 & 0 & 0 & 0 & 0 & 0 & 0 \\
0 & 1 & 1 & 0 & 0 & 0 & 0 & 1 & 0 & 1 & 0 & 0 & 0 & 0 & 1 & 1 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 1 & 1 & 0 & 0 & 1 & 1 & 0 & 0 & 0 & 0 & 0 & 0 & 0 & 0 \\
1 & 1 & 0 & 0 & 0 & 0 & 0 & 0 & 1 & 1 & 0 & 1 & 0 & 1 & 0 & 1 & 1 & 0 & 0 & 0 & 1 & 1 & 0 & 1 & 0 & 1 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 1 & 1 & 1 & 1 & 0 & 0 & 0 & 0 & 0 & 0 & 0 & 0 & 0 \\
0 & 1 & 1 & 0 & 0 & 1 & 1 & 0 & 1 & 0 & 1 & 0 & 1 & 0 & 1 & 0 & 1 & 1 & 1 & 1 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 1 & 1 & 1 & 0 & 0 & 0 & 0 & 0 & 0 & 0 & 1 & 1 & 1 & 1 & 0 & 0 & 0 & 0 & 0 & 0 \\
1 & 1 & 0 & 0 & 1 & 1 & 0 & 0 & 0 & 1 & 1 & 1 & 0 & 0 & 0 & 0 & 0 & 0 & 1 & 1 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 1 & 1 & 1 & 1 & 1 & 1 & 1 & 0 & 0 & 0 & 0 & 1 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0 & 0
\end{pmatrix} ;$$

or

$$K_{32} = \begin{pmatrix}
1&0&0&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&1&0&0&0&0&0&0&0&0&0&0&0&0&0&0&0\\
1&0&0&0&0&0&0&1&0&0&0&0&0&0&0&0&0&0&0&0&0&0&0&0&0&0&0&0&0&0&0&0\\
1&0&0&0&0&0&0&1&0&0&0&0&0&0&1&0&0&0&0&0&0&1&0&0&0&0&0&0&0&0&0&0\\
1&0&0&1&0&0&0&0&0&0&0&0&0&0&0&0&0&0&0&0&0&0&0&0&0&0&0&0&0&0&0&0\\
1&0&0&0&1&0&0&0&0&0&0&0&0&0&1&0&0&0&1&0&0&0&0&0&0&0&0&0&0&0&0&0\\
1&0&1&0&0&0&0&0&0&0&0&0&0&0&0&0&0&0&0&0&0&0&0&0&0&0&0&0&0&0&0&0\\
1&0&1&0&0&0&0&0&0&0&0&1&0&1&0&0&0&0&0&0&0&0&0&0&0&0&0&0&0&0&0&0\\
0&0&1&0&1&0&0&0&1&0&0&0&1&0&0&0&1&0&1&0&0&0&0&0&0&0&0&0&0&0&0&0\\
1&0&0&0&1&0&0&0&1&0&0&0&1&0&0&0&1&0&0&0&1&0&0&0&1&0&0&0&1&0&0&0\\
1&1&0&0&0&0&0&0&0&0&0&0&0&0&0&0&0&0&0&0&0&0&0&0&0&0&0&0&0&0&0&0\\
1&1&0&0&0&0&0&0&0&0&0&0&0&0&1&1&0&0&0&0&0&0&0&0&0&0&0&0&0&0&0&0\\
0&1&1&0&0&0&0&0&1&0&1&0&0&0&0&0&1&1&0&0&0&0&0&0&0&0&0&0&0&0&0&0\\
1&0&1&0&0&0&0&0&1&0&1&0&0&0&0&0&1&0&1&0&0&0&0&0&1&0&1&0&0&0&0&0\\
1&0&1&0&1&0&1&0&0&0&0&0&0&0&0&0&0&0&0&0&0&0&0&0&0&0&0&0&0&0&0&0\\
0&1&1&0&1&0&1&0&1&1&0&0&0&0&0&0&0&0&0&0&0&0&0&0&0&0&0&0&0&0&0&0\\
1&1&0&0&0&0&0&1&1&0&0&0&0&0&0&0&1&1&0&0&0&0&0&0&1&1&0&0&0&0&0&0\\
0&1&1&0&1&0&1&0&1&1&0&0&0&0&0&0&1&1&0&1&0&1&0&1&1&0&0&0&0&0&0&0\\
1&1&0&0&1&1&0&0&0&0&0&0&0&0&0&0&0&0&0&0&0&0&0&0&0&0&0&0&0&0&0&0\\
1&1&0&0&1&1&0&0&0&0&0&0&0&0&1&1&0&0&1&1&0&0&0&0&0&0&0&0&0&0&0&0\\
0&1&1&0&0&1&1&0&1&0&1&0&1&0&1&0&1&1&0&0&1&1&0&0&0&0&0&0&0&0&0&0\\
1&0&1&0&1&0&1&0&1&0&1&0&1&0&1&0&1&0&1&0&1&0&1&0&1&0&1&0&1&0&1&0\\
1&1&1&1&0&0&0&0&0&0&0&0&0&0&0&0&0&0&0&0&0&0&0&0&0&0&0&0&0&0&0&0\\
1&1&1&1&0&0&0&0&0&0&0&0&0&0&1&1&1&1&0&0&0&0&0&0&0&0&0&0&0&0&0&0\\
0&0&1&1&1&1&0&0&1&1&0&0&1&1&0&0&1&1&1&1&0&0&0&0&0&0&0&0&0&0&0&0\\
1&1&0&0&1&1&0&0&1&1&0&0&1&1&0&0&1&1&0&0&1&1&0&0&1&1&0&0&1&1&0&0\\
1&1&1&1&0&0&0&0&1&1&1&1&0&0&0&0&0&0&0&0&0&0&0&0&0&0&0&0&0&0&0&0\\
1&1&1&1&0&0&0&0&1&1&1&1&0&0&0&0&1&1&1&1&0&0&0&0&1&1&1&1&0&0&0&0\\
1&1&1&1&1&1&1&1&0&0&0&0&0&0&0&0&0&0&0&0&0&0&0&0&0&0&0&0&0&0&0&0\\
1&1&1&1&1&1&1&1&0&0&0&0&0&0&0&0&1&1&1&1&1&1&1&1&0&0&0&0&0&0&0&0\\
1&1&1&1&1&1&1&1&1&1&1&1&1&1&1&1&0&0&0&0&0&0&0&0&0&0&0&0&0&0&0&0\\
1&1&1&1&1&1&1&1&1&1&1&1&1&1&1&1&1&1&1&1&1&1&1&1&1&1&1&1&1&1&1&1
\end{pmatrix}.$$

**22.** A decoding apparatus, comprising a transceiver unit and a processing unit, wherein

the transceiver unit is configured to obtain a to-be-decoded sequence;
the processing unit is configured to decode the to-be-decoded sequence based on a plurality of trellises, and reuse an intermediate result obtained from decoding performed based on a first trellis in the plurality of trellises when decoding is performed based on a second trellis in the plurality of trellises, wherein
the first trellis is used for a $t^{th}$ stage of decoding the to-be-decoded sequence, the second trellis is used for a $(t+i)^{th}$ stage of decoding the to-be-decoded sequence, t is an integer greater than 0 or equal to 0, and i is an integer greater than 1 or equal to 1.

**23.** The decoding apparatus according to claim 22, wherein each of the plurality of trellises is split into a plurality of sub-trellises.

**24.** The decoding apparatus according to claim 23, wherein locations of split points of the plurality of sub-trellises are related to decoding complexity.

**25.** The decoding apparatus according to any one of claims 22 to 24, wherein the processing unit is further configured to: determine, based on a correlation between the first trellis and the second trellis, whether to reuse the intermediate result obtained through decoding performed based on the first trellis when decoding is performed based on the second trellis.

**26.** The decoding apparatus according to any one of claims 22 to 25, wherein the processing unit is further configured to: determine, based on the following information, whether to reuse the intermediate result obtained through decoding performed based on the first trellis when decoding is performed based on the second trellis:

a code obtained by performing a shortening operation on a linear code C in the $(t+i)^{th}$ stage of decoding and a code obtained by performing the shortening operation on the linear code C in the $t^{th}$ stage of decoding; and/or
a code obtained by performing a puncturing operation on the linear code C in the $(t+i)^{th}$ stage of decoding and a code obtained by performing the puncturing operation on the linear code C in the $t^{th}$ stage of decoding.

**27.** The decoding apparatus according to claim 26, wherein

if $s_{x,y}(C^{(t+i)})=s_{x,y}(C^{(t)})$, and $p_{x,y}(C^{(t+i)}) \subset p_{x,y}(C^{(t)})$, reuse the intermediate result obtained through decoding performed based on the first trellis when decoding is performed based on the second trellis; and

if $s_{x,y}(C^{(t+i)}) \subset s_{x,y}(C^{(t)})$, reuse the intermediate result obtained through decoding performed based on the first trellis when decoding is performed based on the second trellis, wherein

$s_{x,y}(C^{(t+i)})$ indicates a code obtained by performing the shortening operation on the linear code C at a location except $x \leq z < y$ in the $(t+i)^{th}$ stage of decoding, $s_{x,y}(C^{(t)})$ indicates a code obtained by performing the shortening operation on the linear code C at the location except $x \leq z < y$ in the $t^{th}$ stage of decoding, $p_{x,y}(C^{(t+i)})$ indicates a code obtained by performing the puncturing operation on the linear code C at the location except $x \leq z < y$ in the $(t+i)^{th}$ stage of decoding, and $p_{x,y}(C^{(t)})$ indicates a code obtained by performing the puncturing operation on the linear code C at the location except $x \leq z < y$ in the $t^{th}$ stage of decoding.

28. The decoding apparatus according to any one of claims 22 to 27, wherein
the reusing the intermediate result obtained through decoding performed based on the first trellis when decoding is performed based on the second trellis comprises:

when processing is performed based on the second trellis in the $(t+i)^{th}$ stage of decoding, directly using the intermediate result obtained through decoding performed based on the first trellis as an intermediate result obtained through decoding performed based on the second trellis; or
when processing is performed based on the second trellis in the $(t+i)^{th}$ stage of decoding, performing processing based on a result of a maximization operation in a process of the first trellis.

29. A chip, comprising a logic circuit and a communication interface, wherein the communication interface is configured to receive to-be-processed data and/or information, and transmit the to-be-processed data and/or information to the logic circuit; the logic circuit is configured to perform encoding according to any one of claims 1 to 7; and the communication interface is further configured to output an encoded polar code.

30. A chip, comprising a logic circuit and a communication interface, wherein the communication interface is configured to receive to-be-processed data and/or information, and transmit the to-be-processed data and/or information to the logic circuit; the logic circuit is configured to perform decoding according to any one of claims 8 to 14; and the communication interface is further configured to output a decoding result.

31. An encoding apparatus, comprising at least one processor, wherein the at least one processor is coupled to at least one memory, and the at least one processor is configured to execute a computer program or instructions stored in the at least one memory, so that the communication apparatus performs the encoding method according to any one of claims 1 to 7.

32. The encoding apparatus according to claim 31, wherein the at least one processor is integrated with the at least one memory.

33. A decoding apparatus, comprising at least one processor, wherein the at least one processor is coupled to at least one memory, and the at least one processor is configured to execute a computer program or instructions stored in the at least one memory, so that the communication apparatus performs the decoding method according to any one of claims 8 to 14.

34. The decoding apparatus according to claim 33, wherein the at least one processor is integrated with the at least one memory.

35. A computer-readable storage medium, wherein the computer-readable storage medium stores computer instructions; and when the computer instructions are run on a computer, the encoding method according to any one of claims 1 to 7 is implemented.

36. A computer-readable storage medium, wherein the computer-readable storage medium stores computer instructions; and when the computer instructions are run on a computer, the decoding method according to any one of claims 8 to 14 is implemented.

FIG. 1

FIG. 2

FIG. 3

FIG. 4

FIG. 5

FIG. 6

$$K_{16} = \begin{pmatrix}
1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 \\
1 & 0 & 1 & 0 & 0 & 1 & 1 & 0 & 1 & 1 & 0 & 0 & 0 & 0 & 0 & 0 \\
0 & 1 & 1 & 0 & 1 & 1 & 0 & 0 & 1 & 0 & 1 & 0 & 0 & 0 & 0 & 0 \\
1 & 1 & 1 & 1 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 \\
1 & 1 & 0 & 0 & 1 & 1 & 0 & 0 & 1 & 1 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 \\
1 & 1 & 1 & 1 & 1 & 1 & 1 & 1 & 1 & 1 & 1 & 1 & 1 & 1 & 1 & 1
\end{pmatrix}$$

FIG. 7

$$K'_{16} = \begin{pmatrix}
1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 \\
1 & 0 & 1 & 0 & 0 & 1 & 1 & 0 & 1 & 1 & 0 & 0 & 0 & 0 & 0 & 0 \\
0 & 1 & 1 & 0 & 1 & 1 & 0 & 0 & 1 & 0 & 1 & 0 & 0 & 0 & 0 & 0 \\
1 & 1 & 1 & 1 & 1 & 1 & 1 & 1 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 \\
1 & 0 & 0 & 0 & 1 & 0 & 0 & 0 & 1 & 0 & 0 & 0 & 1 & 0 & 0 & 0 \\
1 & 1 & 0 & 0 & 1 & 1 & 0 & 0 & 1 & 1 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 \\
1 & 1 & 1 & 1 & 1 & 1 & 1 & 1 & 1 & 1 & 1 & 1 & 1 & 1 & 1 & 1
\end{pmatrix}$$

FIG. 8

FIG. 9

$$K_{32} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 1 & 0 & 0 & 0 & 1 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 1 & 0 & 1 & 0 & 0 & 0 & 0 & 0 & 0 & 0 & 0 & 0 & 0 & 0 & 0 & 0 \\
0 & 0 & 1 & 0 & 1 & 0 & 0 & 0 & 1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
0 & 1 & 1 & 0 & 0 & 0 & 0 & 0 & 1 & 0 & 1 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 0 & 1 & 1 & 0 & 0 & 0 & 0 & 0 & 1 & 1 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 1 & 1 & 0 & 1 & 0 & 1 & 0 & 1 & 1 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 1 & 1 & 0 & 0 & 1 & 1 & 0 & 0 & 0 & 0 & 0 & 0 & 0 & 0 & 0 & 0 \\
0 & 1 & 1 & 0 & 0 & 1 & 1 & 0 & 1 & 0 & 1 & 0 & 1 & 0 & 1 & 0 & 1 & 1 & 0 & 0 & 1 & 1 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 1 & 1 & 1 & 1 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1
\end{pmatrix}$$

$E(K_{32})=0.5219, \ \mu(K_{32})=3.421$

FIG. 10

$$K'_{32} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 1 & 1 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 0 & 0 & 0 & 0 & 1 & 0 & 1 & 0 & 0 & 0 & 0 & 0 & 1 & 1 & 0 & 0 & 0 & 0 & 0 & 0 & 0 & 0 & 0 & 0 & 0 & 0 & 0 & 0 \\
0 & 0 & 1 & 0 & 1 & 0 & 0 & 0 & 1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 1 & 1 & 1 & 1 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 1 & 0 & 0 & 0 & 1 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 1 & 1 & 0 & 0 & 1 & 1 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 1 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 1 & 1 & 0 & 0 & 0 & 0 & 0 & 0 & 1 & 1 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 & 1 & 0 & 1 & 0 & 0 & 0 & 0 & 0 \\
1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 & 1 & 0 & 0 & 0 \\
0 & 1 & 0 & 0 & 1 & 0 & 0 & 0 & 1 & 0 & 1 & 1 & 1 & 0 & 0 & 0 & 1 & 0 & 1 & 1 & 1 & 0 & 0 & 0 & 1 & 0 & 0 & 1 & 0 & 0 & 0 & 0 \\
1 & 0 & 1 & 0 & 1 & 1 & 1 & 1 & 1 & 0 & 1 & 0 & 0 & 0 & 0 & 0 & 0 & 1 & 0 & 1 & 0 & 0 & 0 & 0 & 1 & 0 & 1 & 0 & 0 & 0 & 0 & 0 \\
0 & 1 & 1 & 0 & 1 & 0 & 1 & 1 & 0 & 0 & 0 & 0 & 0 & 0 & 0 & 0 & 1 & 1 & 0 & 1 & 0 & 1 & 0 & 1 & 1 & 0 & 0 & 0 & 0 & 0 & 0 & 0 \\
0 & 1 & 1 & 0 & 0 & 1 & 1 & 0 & 1 & 0 & 1 & 0 & 1 & 0 & 1 & 0 & 1 & 1 & 0 & 0 & 1 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 0 & 0 & 0 & 0 & 0 & 0 & 0 & 0 & 1 & 1 & 1 & 1 & 1 & 1 & 1 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1 & 1
\end{pmatrix}$$

<p align="center">FIG. 11</p>

FIG. 12

1300

| Obtain information bits | 1310 |

| Determine a target kernel matrix, where the target kernel matrix is obtained by adjusting an original kernel matrix | 1320 |

| Perform polar encoding on the information bits based on the target kernel matrix | 1330 |

FIG. 13

1400

| Obtain a to-be-decoded sequence | 1410 |

| Decode the to-be-decoded sequence based on a plurality of trellises, and reuse an intermediate result obtained through decoding performed based on a first trellis in the plurality of trellises when decoding is performed based on a second trellis in the plurality of trellises, where the first trellis is used for a $t^{th}$ stage of decoding the to-be-decoded sequence, the second trellis is used for a $(t+i)^{th}$ stage of decoding the to-be-decoded sequence, t is an integer greater than 0 or equal to 0, and i is an integer greater than 1 or equal to 1 | 1420 |

FIG. 14

$$
K_{24} =
\begin{pmatrix}
1&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&0&1&0&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&1&0&0&0&0&0&0&0&0&1&0&0&1&0&0&0&0&0&0&0&0&0&0\\
1&0&1&0&0&0&0&0&0&0&0&0&0&0&0&0&0&0&0&0&0&0&0&0&0&0&0&0&0&0\\
1&0&1&0&0&0&0&1&0&0&0&1&0&0&0&0&0&0&0&0&0&0&0&0&0&0&0&0&0&0\\
1&0&0&0&1&0&0&0&0&0&0&0&0&0&0&0&0&0&0&0&0&0&0&0&0&0&0&0&0&0\\
1&0&0&0&1&0&0&0&1&0&1&0&0&0&0&0&0&0&0&0&0&0&0&0&0&0&0&0&0&0\\
1&0&1&0&0&0&0&0&1&0&1&0&0&0&0&0&1&0&1&0&0&0&0&0&0&0&0&0&0&0\\
1&1&0&0&0&0&0&0&0&0&0&0&0&0&0&0&0&0&0&0&0&0&0&0&0&0&0&0&0&0\\
1&1&0&0&0&0&0&0&1&1&0&0&0&0&0&0&0&0&0&0&0&0&0&0&0&0&0&0&0&0\\
1&0&1&0&1&0&1&0&0&0&0&0&0&0&0&0&0&0&0&0&0&0&0&0&0&0&0&0&0&0\\
1&0&1&0&1&0&1&0&1&1&0&0&0&0&0&0&1&1&0&0&0&0&0&0&0&0&0&0&0&0\\
0&1&1&0&1&0&1&0&0&1&1&0&1&0&1&0&0&0&0&0&0&0&0&0&0&0&0&0&0&0\\
1&0&1&0&1&0&1&0&1&0&1&0&1&0&1&0&1&0&1&0&1&0&1&0&1&0&1&0&1&0\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&1&0&0&0&0&0&0&0&0&0&0&0&0&0&0&0&0&0&0\\
1&1&0&0&1&1&0&0&1&1&0&0&1&1&0&0&1&1&0&0&1&1&0&0&1&1&0&0&0&0\\
1&1&1&1&0&0&0&0&1&1&1&1&0&0&0&0&1&1&1&1&0&0&0&0&0&0&0&0&0&0\\
1&1&1&1&1&1&1&1&0&0&0&0&0&0&0&0&0&0&0&0&0&0&0&0&0&0&0&0&0&0\\
1&1&1&1&1&1&1&1&0&0&0&0&0&0&0&0&0&0&1&1&1&1&1&1&1&1&0&0&0&0\\
1&1&1&1&1&1&1&1&1&1&1&1&1&1&1&1&1&1&0&0&0&0&0&0&0&0&0&0&0&0
\end{pmatrix}
\;\rightarrow\;
\begin{pmatrix}
1&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&0&1&0&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&1&0&0&0&0&0&0&0&0&1&0&0&1&0&0&0&0&0&0&0&0&0&0\\
1&0&1&0&0&0&0&0&0&0&0&0&0&0&0&0&0&0&0&0&0&0&0&0&0&0&0&0&0&0\\
1&0&1&0&0&0&0&1&0&0&0&1&0&0&0&0&0&0&0&0&0&0&0&0&0&0&0&0&0&0\\
1&0&0&0&1&0&0&0&0&0&0&0&0&0&0&0&0&0&0&0&0&0&0&0&0&0&0&0&0&0\\
1&0&0&0&1&0&0&0&1&0&1&0&0&0&0&0&0&0&0&0&0&0&0&0&0&0&0&0&0&0\\
1&0&1&0&0&0&0&0&1&0&1&0&0&0&0&0&1&0&1&0&0&0&0&0&0&0&0&0&0&0\\
1&1&0&0&0&0&0&0&0&0&0&0&0&0&0&0&0&0&0&0&0&0&0&0&0&0&0&0&0&0\\
1&1&0&0&0&0&0&0&1&1&0&0&0&0&0&0&0&0&0&0&0&0&0&0&0&0&0&0&0&0\\
1&0&1&0&1&0&1&0&0&0&0&0&0&0&0&0&0&0&0&0&0&0&0&0&0&0&0&0&0&0\\
1&0&1&0&1&0&1&0&1&1&0&0&0&0&0&0&1&1&0&0&0&0&0&0&0&0&0&0&0&0\\
0&1&1&0&1&0&1&0&0&1&1&0&1&0&1&0&0&0&0&0&0&0&0&0&0&0&0&0&0&0\\
1&0&1&0&1&0&1&0&1&0&1&0&1&0&1&0&1&0&1&0&1&0&1&0&1&0&1&0&1&0\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&1&0&0&0&0&0&0&0&0&0&0&0&0&0&0&0&0&0&0\\
1&1&0&0&1&1&0&0&1&1&0&0&1&1&0&0&1&1&0&0&1&1&0&0&1&1&0&0&0&0\\
1&1&1&1&0&0&0&0&1&1&1&1&0&0&0&0&1&1&1&1&0&0&0&0&0&0&0&0&0&0\\
1&1&1&1&1&1&1&1&0&0&0&0&0&0&0&0&0&0&0&0&0&0&0&0&0&0&0&0&0&0\\
1&1&1&1&1&1&1&1&0&0&0&0&0&0&0&0&0&0&1&1&1&1&1&1&1&1&0&0&0&0\\
1&1&1&1&1&1&1&1&1&1&1&1&1&1&1&1&1&1&0&0&0&0&0&0&0&0&0&0&0&0
\end{pmatrix}
$$

FIG. 15

$$
K_{23} =
\begin{pmatrix}
1&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&0&1&0&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&1&0&0&0&0&0&0&0&0&1&0&0&1&0&0&0&0&0&0&0&0&0&0\\
1&0&1&0&0&0&0&0&0&0&0&0&0&0&0&0&0&0&0&0&0&0&0&0&0&0&0&0&0&0\\
1&0&1&0&0&0&0&1&0&0&0&1&0&0&0&0&0&0&0&0&0&0&0&0&0&0&0&0&0&0\\
1&0&0&0&1&0&0&0&0&0&0&0&0&0&0&0&0&0&0&0&0&0&0&0&0&0&0&0&0&0\\
1&0&0&0&1&0&0&0&1&0&1&0&0&0&0&0&0&0&0&0&0&0&0&0&0&0&0&0&0&0\\
1&0&1&0&0&0&0&0&1&0&1&0&0&0&0&0&1&0&1&0&0&0&0&0&0&0&0&0&0&0\\
1&1&0&0&0&0&0&0&0&0&0&0&0&0&0&0&0&0&0&0&0&0&0&0&0&0&0&0&0&0\\
1&1&0&0&0&0&0&0&1&1&0&0&0&0&0&0&0&0&0&0&0&0&0&0&0&0&0&0&0&0\\
1&0&1&0&1&0&1&0&0&0&0&0&0&0&0&0&0&0&0&0&0&0&0&0&0&0&0&0&0&0\\
1&0&1&0&1&0&1&0&1&1&0&0&0&0&0&0&1&1&0&0&0&0&0&0&0&0&0&0&0&0\\
0&1&1&0&1&0&1&0&0&1&1&0&1&0&1&0&0&0&0&0&0&0&0&0&0&0&0&0&0&0\\
1&0&1&0&1&0&1&0&1&0&1&0&1&0&1&1&0&1&0&1&0&1&0&1&0&1&0&1&0&1\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&1&0&0&0&0&0&0&0&0&0&0&0&0&0&0&0&0&0&0\\
1&1&0&0&1&1&0&0&1&1&0&0&1&1&0&0&1&1&0&0&1&1&0&0&1&1&0&0&0&0\\
1&1&1&1&0&0&0&0&1&1&1&1&0&0&0&0&1&1&1&1&0&0&0&0&0&0&0&0&0&0\\
1&1&1&1&1&1&1&1&0&0&0&0&0&0&0&0&0&0&0&0&0&0&0&0&0&0&0&0&0&0\\
1&1&1&1&1&1&1&1&0&0&0&0&0&0&0&0&0&0&1&1&1&1&1&1&1&1&0&0&0&0
\end{pmatrix}
\;\rightarrow\;
\begin{pmatrix}
1&0&0&0&0&0&0&0&0&0&0&0&0&0&0&0&0&0&0&0&0&0&0&0&0&0&0&0&0&0\\
1&0&0&0&0&0&0&0&0&0&0&0&0&0&0&0&0&1&1&0&0&0&0&0&0&0&0&0&0&0\\
1&0&0&0&0&0&0&1&0&0&0&0&0&0&0&0&0&0&0&0&0&0&0&0&0&0&0&0&0&0\\
1&0&0&0&0&0&0&1&0&0&0&0&0&0&0&0&1&0&0&1&0&0&0&0&0&0&0&0&0&0\\
1&0&1&0&0&0&0&0&0&0&0&0&0&0&0&0&0&0&0&0&0&0&0&0&0&0&0&0&0&0\\
1&0&1&0&0&0&0&1&0&0&0&1&0&0&0&0&0&0&0&0&0&0&0&0&0&0&0&0&0&0\\
1&0&0&0&1&0&0&0&0&0&0&0&0&0&0&0&0&0&0&0&0&0&0&0&0&0&0&0&0&0\\
1&0&0&0&1&0&0&0&1&0&1&0&0&0&0&0&0&0&0&0&0&0&0&0&0&0&0&0&0&0\\
1&0&1&0&0&0&0&0&1&0&1&0&0&0&0&0&1&0&1&0&0&0&0&0&0&0&0&0&0&0\\
1&1&0&0&0&0&0&0&0&0&0&0&0&0&0&0&0&0&0&0&0&0&0&0&0&0&0&0&0&0\\
1&1&0&0&0&0&0&0&1&1&0&0&0&0&0&0&0&0&0&0&0&0&0&0&0&0&0&0&0&0\\
1&0&1&0&1&0&1&0&0&0&0&0&0&0&0&0&0&0&0&0&0&0&0&0&0&0&0&0&0&0\\
1&0&1&0&1&0&1&0&1&1&0&0&0&0&0&0&1&1&0&0&0&0&0&0&0&0&0&0&0&0\\
1&1&0&0&0&0&0&0&1&1&0&0&0&0&0&0&1&0&1&0&1&0&1&0\\
1&0&1&0&1&0&1&0&1&0&1&0&1&0&1&1&0&1&0&1&0&1&0&1&0&1&0&1&0&1\\
1&1&0&0&1&1&0&0&0&0&0&0&0&0&0&0&0&0&0&0&0&0&0&0&0&0&0&0&0&0\\
1&1&1&1&0&0&0&0&0&0&0&0&0&0&0&0&0&0&0&0&0&0&0&0&0&0&0&0&0&0\\
0&0&1&1&1&1&0&0&1&1&0&0&1&1&0&0&0&0&0&0&0&0&0&0&0&0&0&0&0&0\\
1&1&0&0&1&1&0&0&1&1&1&1&0&0&0&0&0&0&0&0&0&0&0&0&0&0&0&0&0&0\\
1&1&0&0&1&1&0&0&1&1&0&0&1&1&0&0&1&1&0&0&1&1&0&0&1&1&0&0&0&0\\
1&1&1&1&0&0&0&0&1&1&1&1&0&0&0&0&1&1&1&1&0&0&0&0&0&0&0&0&0&0\\
1&1&1&1&1&1&1&1&0&0&0&0&0&0&0&0&0&0&0&0&0&0&0&0&0&0&0&0&0&0\\
1&1&1&1&1&1&1&1&0&0&0&0&0&0&0&0&0&0&1&1&1&1&1&1&1&1&0&0&0&0
\end{pmatrix}
$$

FIG. 16

$$
K_{22} = \begin{pmatrix}
1&0&0&0&0&0&0&0&0&0&0&0&0&0&0&0&0&0&0&0&0&0\\
1&0&0&0&0&0&0&0&0&0&0&0&1&0&0&0&0&0&0&0&0&0\\
1&0&0&0&0&0&0&1&0&0&0&0&0&0&0&0&0&0&0&0&0&0\\
1&0&0&0&0&0&0&1&0&0&0&0&0&1&0&0&0&1&0&0&0&0\\
1&0&1&0&0&0&0&0&0&0&0&0&0&0&0&0&0&0&0&0&0&0\\
1&0&1&0&0&0&0&1&0&0&0&1&0&0&0&0&0&0&0&0&0&0\\
1&0&0&0&1&0&0&0&0&0&0&0&0&0&0&0&0&0&0&0&0&0\\
1&0&0&0&1&0&0&0&1&0&1&0&0&0&0&0&0&0&0&0&0&0\\
1&0&1&0&0&0&0&0&1&0&1&0&0&0&1&0&1&0&0&0&0&0\\
1&1&0&0&0&0&0&0&0&0&0&0&0&0&0&0&0&0&0&0&0&0\\
1&1&0&0&0&0&0&0&1&1&0&0&0&0&0&0&0&0&0&0&0&0\\
1&0&1&0&1&0&1&0&0&0&0&0&0&0&0&0&0&0&0&0&0&0\\
1&0&1&0&1&0&1&0&1&1&0&0&0&0&1&1&0&0&0&0&0&0\\
1&1&0&0&0&0&0&0&1&1&0&0&0&0&1&0&1&0&1&0&1&0\\
1&1&0&0&1&1&0&0&0&0&0&0&0&0&0&0&0&0&0&0&0&0\\
1&1&1&1&0&0&0&0&0&0&0&0&0&0&0&0&0&0&0&0&0&0\\
0&0&1&1&1&1&0&0&1&1&0&0&1&1&0&0&0&0&0&0&0&0\\
1&1&0&0&1&1&0&0&1&1&1&1&0&0&0&0&0&0&0&0&0&0\\
1&1&0&0&1&1&0&0&1&1&0&0&1&1&1&0&0&1&1&0&0&0\\
1&1&1&1&0&0&0&0&1&1&1&1&0&0&1&1&1&1&0&0&0&0\\
1&1&1&1&1&1&1&1&0&0&0&0&0&0&0&0&0&0&0&0&0&0\\
1&1&1&1&1&1&1&1&0&0&0&0&0&0&1&1&1&1&1&1&1&1
\end{pmatrix}
\;\rightarrow\;
\begin{pmatrix}
1&0&0&0&0&0&0&0&0&0&0&0&0&0&0&0&0&0&0&0&0&0\\
1&0&0&0&0&0&0&0&0&0&0&0&0&1&0&0&0&0&0&0&0&0\\
1&0&0&0&0&0&0&0&1&0&0&0&0&0&0&0&0&0&0&0&0&0\\
1&0&0&0&0&0&0&0&1&0&0&0&0&0&1&0&0&0&1&0&0&0\\
1&0&1&0&0&0&0&0&0&0&0&0&0&0&0&0&0&0&0&0&0&0\\
1&0&1&0&0&0&0&0&1&0&0&0&1&0&0&0&0&0&0&0&0&0\\
1&0&0&0&1&0&0&0&0&0&0&0&0&0&0&0&0&0&0&0&0&0\\
1&0&0&0&1&0&0&0&1&0&1&0&0&0&0&0&0&0&0&0&0&0\\
1&0&1&0&0&0&0&0&1&0&1&0&0&0&1&0&1&0&0&0&0&0\\
1&1&0&0&0&0&0&0&0&0&0&0&0&0&0&0&0&0&0&0&0&0\\
1&1&0&0&0&0&0&0&1&1&0&0&0&0&0&0&0&0&0&0&0&0\\
1&0&1&0&1&0&1&0&0&0&0&0&0&0&0&0&0&0&0&0&0&0\\
1&0&1&0&1&0&1&0&1&1&0&0&0&0&1&1&0&0&0&0&0&0\\
1&1&0&0&0&0&0&0&1&1&0&0&0&0&1&0&1&0&1&0&1&0\\
1&1&0&0&1&1&0&0&0&0&0&0&0&0&0&0&0&0&0&0&0&0\\
1&1&1&1&0&0&0&0&0&0&0&0&0&0&0&0&0&0&0&0&0&0\\
1&1&1&1&0&0&0&0&0&0&0&0&0&1&1&0&0&1&1&0&0&0\\
1&1&0&0&1&1&0&0&1&1&0&0&1&1&1&1&0&0&1&1&0&0\\
1&1&1&1&0&0&0&0&1&1&1&1&0&0&1&1&1&1&0&0&0&0\\
1&1&1&1&1&1&1&1&0&0&0&0&0&0&0&0&0&0&0&0&0&0\\
1&1&1&1&1&1&1&1&0&0&0&0&0&0&1&1&1&1&1&1&1&1
\end{pmatrix}
$$

FIG. 17

$$
K_{21} = \begin{pmatrix}
1&0&0&0&0&0&0&0&0&0&0&0&0&0&0&0&0&0&0&0&0&0\\
1&0&0&0&0&0&0&0&0&0&0&0&1&0&0&0&0&0&0&0&0&0\\
1&0&0&0&0&0&0&1&0&0&0&0&0&0&0&0&0&0&0&0&0&0\\
1&0&0&0&0&0&0&1&0&0&0&0&0&1&0&0&0&1&0&0&0&0\\
1&0&1&0&0&0&0&0&0&0&0&0&0&0&0&0&0&0&0&0&0&0\\
1&0&1&0&0&0&0&1&0&0&0&1&0&0&0&0&0&0&0&0&0&0\\
1&0&0&0&1&0&0&0&0&0&0&0&0&0&0&0&0&0&0&0&0&0\\
1&0&0&0&1&0&0&0&1&0&1&0&0&0&0&0&0&0&0&0&0&0\\
1&0&1&0&0&0&0&0&1&0&1&0&0&0&1&0&1&0&0&0&0&0\\
1&1&0&0&0&0&0&0&0&0&0&0&0&0&0&0&0&0&0&0&0&0\\
1&1&0&0&0&0&0&0&1&1&0&0&0&0&0&0&0&0&0&0&0&0\\
1&0&1&0&1&0&1&0&0&0&0&0&0&0&0&0&0&0&0&0&0&0\\
1&0&1&0&1&0&1&0&1&1&0&0&0&0&1&1&0&0&0&0&0&0\\
1&1&0&0&0&0&0&0&1&1&0&0&0&0&1&0&1&0&1&0&1&0\\
1&1&0&0&1&1&0&0&0&0&0&0&0&0&0&0&0&0&0&0&0&0\\
1&1&1&1&0&0&0&0&0&0&0&0&0&0&0&0&0&0&0&0&0&0\\
1&1&1&1&0&0&0&0&0&0&0&0&1&1&0&0&1&1&0&0&0&0\\
1&1&0&0&1&1&0&0&1&1&1&1&0&0&0&0&0&0&0&0&0&0\\
1&1&1&1&0&0&0&0&1&1&1&1&0&0&1&1&1&1&0&0&0&0\\
1&1&1&1&1&1&1&1&0&0&0&0&0&0&0&0&0&0&0&0&0&0\\
1&1&1&1&1&1&1&1&0&0&0&0&0&0&1&1&1&1&1&1&1&1
\end{pmatrix}
\;\rightarrow\;
\begin{pmatrix}
1&0&0&0&0&0&0&0&0&0&0&0&0&0&0&0&0&0&0&0&0&0\\
1&0&0&0&0&0&0&0&0&0&0&0&0&1&0&0&0&0&0&0&0&0\\
1&0&0&0&0&0&0&0&1&0&0&0&0&0&0&0&0&0&0&0&0&0\\
1&0&0&0&0&0&0&0&1&0&0&0&0&0&1&0&0&0&1&0&0&0\\
1&0&1&0&0&0&0&0&0&0&0&0&0&0&0&0&0&0&0&0&0&0\\
1&0&1&0&0&0&0&0&1&0&0&0&1&0&0&0&0&0&0&0&0&0\\
1&0&0&0&1&0&0&0&0&0&0&0&0&0&0&0&0&0&0&0&0&0\\
1&0&0&0&1&0&0&0&1&0&1&0&0&0&0&0&0&0&0&0&0&0\\
1&0&1&0&0&0&0&0&1&0&1&0&0&0&1&0&1&0&0&0&0&0\\
1&1&0&0&0&0&0&0&0&0&0&0&0&0&0&0&0&0&0&0&0&0\\
1&1&0&0&0&0&0&0&1&1&0&0&0&0&0&0&0&0&0&0&0&0\\
1&0&1&0&1&0&1&0&0&0&0&0&0&0&0&0&0&0&0&0&0&0\\
1&0&1&0&1&0&1&0&1&1&0&0&0&0&1&1&0&0&0&0&0&0\\
1&1&0&0&0&0&0&0&1&1&0&0&0&0&1&0&1&0&1&0&1&0\\
1&1&0&0&1&1&0&0&0&0&0&0&0&0&0&0&0&0&0&0&0&0\\
1&1&1&1&0&0&0&0&0&0&0&0&0&0&0&0&0&0&0&0&0&0\\
1&1&1&1&0&0&0&0&0&0&0&0&0&1&1&0&0&1&1&0&0&0\\
1&1&0&0&1&1&0&0&1&1&1&1&0&0&0&0&0&0&0&0&0&0\\
1&1&1&1&0&0&0&0&1&1&1&1&0&0&1&1&1&1&0&0&0&0\\
1&1&1&1&1&1&1&1&0&0&0&0&0&0&0&0&0&0&0&0&0&0\\
1&1&1&1&1&1&1&1&0&0&0&0&0&0&1&1&1&1&1&1&1&1
\end{pmatrix}
$$

FIG. 18

$$K_{20} = \begin{pmatrix} 1 & 0 & 0 & 0 & 0 & 0 & 0 & 0 & 0 & 0 & 0 & 0 & 0 & 0 & 0 & 0 & 0 & 0 & 0 & 0 \\ 1 & 0 & 0 & 0 & 0 & 0 & 0 & 0 & 0 & 0 & 0 & 0 & 1 & 0 & 0 & 0 & 0 & 0 & 0 & 0 \\ 1 & 0 & 0 & 0 & 0 & 0 & 0 & 1 & 0 & 0 & 0 & 0 & 0 & 0 & 0 & 0 & 0 & 0 & 0 & 0 \\ 1 & 0 & 0 & 0 & 0 & 0 & 0 & 1 & 0 & 0 & 0 & 1 & 0 & 0 & 0 & 1 & 0 & 0 & 0 & 0 \\ 1 & 0 & 1 & 0 & 0 & 0 & 0 & 0 & 0 & 0 & 0 & 0 & 0 & 0 & 0 & 0 & 0 & 0 & 0 & 0 \\ 1 & 0 & 0 & 0 & 1 & 0 & 0 & 0 & 0 & 0 & 0 & 0 & 0 & 0 & 0 & 0 & 0 & 0 & 0 & 0 \\ 1 & 0 & 0 & 0 & 1 & 0 & 0 & 0 & 1 & 0 & 1 & 0 & 0 & 0 & 0 & 0 & 0 & 0 & 0 & 0 \\ 1 & 0 & 1 & 0 & 0 & 0 & 0 & 0 & 1 & 0 & 1 & 0 & 1 & 0 & 1 & 0 & 0 & 0 & 0 & 0 \\ 1 & 1 & 0 & 0 & 0 & 0 & 0 & 0 & 0 & 0 & 0 & 0 & 0 & 0 & 0 & 0 & 0 & 0 & 0 & 0 \\ 1 & 1 & 0 & 0 & 0 & 0 & 0 & 0 & 1 & 1 & 0 & 0 & 0 & 0 & 0 & 0 & 0 & 0 & 0 & 0 \\ 1 & 0 & 1 & 0 & 1 & 0 & 1 & 0 & 0 & 0 & 0 & 0 & 0 & 0 & 0 & 0 & 0 & 0 & 0 & 0 \\ 1 & 0 & 1 & 0 & 1 & 0 & 1 & 0 & 1 & 1 & 0 & 0 & 1 & 1 & 0 & 0 & 0 & 0 & 0 & 0 \\ 1 & 1 & 0 & 0 & 0 & 0 & 0 & 0 & 1 & 1 & 0 & 0 & 1 & 0 & 1 & 0 & 1 & 0 & 1 & 0 \\ 1 & 1 & 0 & 0 & 1 & 1 & 0 & 0 & 0 & 0 & 0 & 0 & 0 & 0 & 0 & 0 & 0 & 0 & 0 & 0 \\ 1 & 1 & 1 & 1 & 0 & 0 & 0 & 0 & 0 & 0 & 0 & 0 & 0 & 0 & 0 & 0 & 0 & 0 & 0 & 0 \\ 1 & 1 & 1 & 1 & 0 & 0 & 0 & 0 & 0 & 0 & 0 & 0 & 1 & 1 & 0 & 0 & 1 & 1 & 0 & 0 \\ 1 & 1 & 0 & 0 & 1 & 1 & 0 & 0 & 1 & 1 & 1 & 1 & 0 & 0 & 0 & 0 & 0 & 0 & 0 & 0 \\ 1 & 1 & 1 & 1 & 0 & 0 & 0 & 0 & 1 & 1 & 1 & 1 & 1 & 1 & 1 & 1 & 0 & 0 & 0 & 0 \\ 1 & 1 & 1 & 1 & 1 & 1 & 1 & 1 & 0 & 0 & 0 & 0 & 0 & 0 & 0 & 0 & 0 & 0 & 0 & 0 \\ 1 & 1 & 1 & 1 & 1 & 1 & 1 & 1 & 0 & 0 & 0 & 0 & 1 & 1 & 1 & 1 & 1 & 1 & 1 & 1 \end{pmatrix}$$

FIG. 19

$$K_{20} = \begin{pmatrix} 1 & 0 & 0 & 0 & 0 & 0 & 0 & 0 & 0 & 0 & 0 & 0 & 0 & 0 & 0 & 0 & 0 & 0 & 0 & 0 \\ 1 & 0 & 0 & 0 & 0 & 0 & 0 & 0 & 0 & 0 & 0 & 0 & 1 & 0 & 0 & 0 & 0 & 0 & 0 & 0 \\ 1 & 0 & 0 & 0 & 0 & 0 & 0 & 1 & 0 & 0 & 0 & 0 & 0 & 0 & 0 & 0 & 0 & 0 & 0 & 0 \\ 1 & 0 & 0 & 0 & 0 & 0 & 0 & 1 & 0 & 0 & 0 & 1 & 0 & 0 & 0 & 1 & 0 & 0 & 0 & 0 \\ 1 & 0 & 1 & 0 & 0 & 0 & 0 & 0 & 0 & 0 & 0 & 0 & 0 & 0 & 0 & 0 & 0 & 0 & 0 & 0 \\ 1 & 0 & 0 & 0 & 1 & 0 & 0 & 0 & 0 & 0 & 0 & 0 & 0 & 0 & 0 & 0 & 0 & 0 & 0 & 0 \\ 1 & 0 & 0 & 0 & 1 & 0 & 0 & 0 & 1 & 0 & 1 & 0 & 0 & 0 & 0 & 0 & 0 & 0 & 0 & 0 \\ 1 & 0 & 1 & 0 & 0 & 0 & 0 & 0 & 1 & 0 & 1 & 0 & 1 & 0 & 1 & 0 & 0 & 0 & 0 & 0 \\ 1 & 1 & 0 & 0 & 0 & 0 & 0 & 0 & 0 & 0 & 0 & 0 & 0 & 0 & 0 & 0 & 0 & 0 & 0 & 0 \\ 1 & 1 & 0 & 0 & 0 & 0 & 0 & 0 & 1 & 1 & 0 & 0 & 0 & 0 & 0 & 0 & 0 & 0 & 0 & 0 \\ 1 & 0 & 1 & 0 & 1 & 0 & 1 & 0 & 0 & 0 & 0 & 0 & 0 & 0 & 0 & 0 & 0 & 0 & 0 & 0 \\ 1 & 0 & 1 & 0 & 1 & 0 & 1 & 0 & 1 & 1 & 0 & 0 & 1 & 1 & 0 & 0 & 0 & 0 & 0 & 0 \\ 1 & 1 & 0 & 0 & 0 & 0 & 0 & 0 & 1 & 1 & 0 & 0 & 1 & 0 & 1 & 0 & 1 & 0 & 1 & 0 \\ 1 & 1 & 0 & 0 & 1 & 1 & 0 & 0 & 0 & 0 & 0 & 0 & 0 & 0 & 0 & 0 & 0 & 0 & 0 & 0 \\ 1 & 1 & 1 & 1 & 0 & 0 & 0 & 0 & 0 & 0 & 0 & 0 & 0 & 0 & 0 & 0 & 0 & 0 & 0 & 0 \\ 1 & 1 & 1 & 1 & 0 & 0 & 0 & 0 & 0 & 0 & 0 & 0 & 1 & 1 & 0 & 0 & 1 & 1 & 0 & 0 \\ 1 & 1 & 0 & 0 & 1 & 1 & 0 & 0 & 1 & 1 & 1 & 1 & 0 & 0 & 0 & 0 & 0 & 0 & 0 & 0 \\ 1 & 1 & 1 & 1 & 0 & 0 & 0 & 0 & 1 & 1 & 1 & 1 & 1 & 1 & 1 & 1 & 0 & 0 & 0 & 0 \\ 1 & 1 & 1 & 1 & 1 & 1 & 1 & 1 & 0 & 0 & 0 & 0 & 0 & 0 & 0 & 0 & 0 & 0 & 0 & 0 \\ 1 & 1 & 1 & 1 & 1 & 1 & 1 & 1 & 0 & 0 & 0 & 0 & 1 & 1 & 1 & 1 & 1 & 1 & 1 & 1 \end{pmatrix}$$

$E(K_{20})=0.48786$, $\mu(K_{20})=3.77148$

FIG. 20

$$K'_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 1 & 1 & 0 & 0 & 1 & 0 & 0 & 0 & 1 & 0 & 0 & 0 & 1 & 0 & 0 & 0 & 0 & 0 & 0 & 0 & 0 \\
1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 1 & 1 & 0 & 0 & 1 & 0 & 1 & 0 & 1 & 0 & 1 & 0 & 0 & 0 & 0 & 0 & 0 & 0 & 0 & 0 \\
1 & 0 & 1 & 0 & 1 & 1 & 0 & 0 & 0 & 0 & 0 & 0 & 1 & 0 & 1 & 0 & 1 & 0 & 1 & 0 & 0 & 0 & 0 & 0 \\
0 & 1 & 1 & 0 & 1 & 1 & 0 & 0 & 1 & 0 & 1 & 0 & 0 & 0 & 0 & 0 & 1 & 1 & 0 & 0 & 0 & 0 & 0 & 0 \\
1 & 0 & 1 & 0 & 1 & 0 & 1 & 0 & 1 & 1 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 & 0 & 0 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1 & 1 & 1 & 0 & 0 & 0 & 0 & 0 & 0
\end{pmatrix}$$

$$E(K'_{20}) = 0.501395, \quad \mu(K'_{20}) = 3.54847$$

FIG. 21

$$K''_{20} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 1 & 0 & 0 & 0 & 0 & 0 & 0 & 1 & 0 & 0 & 0 & 0 & 0 & 0 & 0 & 0 & 0 & 0 & 0 \\
1 & 1 & 0 & 0 & 0 & 1 & 0 & 0 & 0 & 0 & 0 & 0 & 0 & 0 & 0 & 0 & 1 & 0 & 0 & 0 & 0 & 0 & 0 & 0 \\
0 & 0 & 0 & 1 & 0 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 1 & 1 & 0 & 0 & 1 & 0 & 0 & 1 & 0 & 0 & 0 & 0 & 0 & 0 & 0 & 0 & 0 & 0 & 0 & 0 & 0 \\
1 & 1 & 0 & 1 & 1 & 0 & 1 & 0 & 1 & 0 & 0 & 0 & 0 & 0 & 0 & 0 & 0 & 0 & 0 & 0 & 0 & 0 & 0 & 0 \\
1 & 0 & 1 & 1 & 0 & 1 & 0 & 0 & 1 & 0 & 0 & 0 & 1 & 0 & 0 & 0 & 1 & 0 & 1 & 0 & 0 & 0 & 0 & 0 \\
0 & 1 & 1 & 0 & 1 & 1 & 0 & 0 & 1 & 0 & 1 & 0 & 0 & 0 & 0 & 0 & 1 & 1 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 & 0 & 0 & 0 & 0 \\
0 & 0 & 1 & 1 & 1 & 1 & 1 & 1 & 1 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 1 & 1 & 1 & 1 & 0 & 0 & 0 \\
1 & 1 & 1 & 1 & 1 & 1 & 1 & 1 & 1 & 1 & 1 & 1 & 1 & 1 & 1 & 1 & 1 & 0 & 0 & 0 & 0 & 0 & 0 & 0
\end{pmatrix}$$

$$E(K''_{20}) = 0.506169, \quad \mu(K''_{20}) = 3.43827$$

FIG. 22

$K_{21,1}$, E=0.506714, μ=3.367

FIG. 23

$K_{21,2}$, E=0.500372, μ=3.472

$$
\begin{pmatrix}
1&0&0&0&0&0&0&0&0&0&0&0&0&0&0&0&0&0&0&0&0 \\
1&0&0&0&1&0&0&0&0&0&0&0&0&0&0&0&0&0&0&0&0 \\
1&0&0&1&0&0&0&0&0&0&0&0&0&0&0&0&0&0&0&0&0 \\
1&0&0&0&1&0&0&0&0&0&0&0&0&0&0&0&0&0&0&0&0 \\
1&0&1&0&0&0&0&0&0&0&0&0&0&0&0&0&0&0&0&0&0 \\
1&1&0&0&0&0&0&0&0&0&0&0&0&0&0&0&0&0&0&0&0 \\
1&0&0&1&1&0&0&1&0&0&0&0&0&0&0&0&0&0&0&0&0 \\
0&0&1&1&1&0&0&0&1&0&0&0&0&0&0&0&0&0&0&0&0 \\
0&0&1&0&0&1&1&1&0&0&0&0&0&0&0&0&0&0&0&0&0 \\
0&1&1&0&1&0&1&1&0&0&0&0&0&1&0&0&0&0&0&0&0 \\
1&0&0&0&0&0&0&0&1&1&1&0&0&0&0&0&0&0&0&0&0 \\
0&1&1&1&0&1&1&0&0&0&0&0&1&0&0&0&0&0&0&0&0 \\
0&1&0&0&0&1&1&1&0&1&0&0&0&1&0&0&0&0&0&0&0 \\
1&0&1&1&0&1&0&1&0&0&1&0&0&0&0&0&0&0&0&0&0 \\
1&1&0&0&1&1&0&0&1&0&0&0&1&0&1&0&1&0&0&0&0 \\
1&0&1&1&0&1&0&0&1&0&1&0&1&1&0&0&1&0&1&0&0 \\
0&0&0&0&0&1&1&0&1&1&0&0&1&1&1&1&0&0&0&0&0 \\
1&1&0&0&0&1&1&0&1&1&1&1&0&0&0&0&0&0&0&0&0 \\
1&1&1&1&1&0&0&0&1&1&0&0&0&0&0&0&0&0&0&0&1 \\
1&1&1&1&1&1&1&1&0&0&0&0&0&0&0&0&0&0&1&1&0 \\
1&1&1&1&1&1&1&1&1&1&1&1&1&1&1&1&1&1&0&0&0 \\
\end{pmatrix}
$$

FIG. 24

$$K_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 1 & 0 & 0 & 0 & 1 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 1 & 0 & 0 & 0 & 1 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 1 & 0 & 1 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 1 & 1 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 1 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 1 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix}$$

$E(K_{24}) = 0.502911$, $\mu(K_{24}) = 3.61903$

FIG. 25

$$K'_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 1 & 0 & 0 & 0 & 0 & 0 & 1 & 0 & 1 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix}$$

$E(K'_{24})=0.511998$, $\mu(K'_{24})=3.43361$

FIG. 26

$$K''_{24} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 1 & 1 & 0 & 1 & 1 & 1 & 0 & 1 & 0 & 0 & 0 & 1 & 0 & 0 & 0 & 1 & 0 & 0 & 0 \\
0 & 1 & 1 & 1 & 0 & 0 & 1 & 0 & 1 & 0 & 0 & 0 & 1 & 0 & 0 & 0 & 1 & 0 & 1 & 0 & 0 & 0 & 0 & 0 \\
1 & 0 & 1 & 0 & 1 & 0 & 1 & 0 & 1 & 1 & 0 & 0 & 0 & 0 & 0 & 0 & 1 & 1 & 0 & 0 & 0 & 0 & 0 & 0 \\
0 & 1 & 1 & 0 & 1 & 0 & 1 & 0 & 0 & 1 & 1 & 0 & 1 & 0 & 1 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0
\end{pmatrix}$$

$E(K''_{24})=0.51577, \mu(K''_{24})=3.304$

FIG. 27

$K_{25,1}$, E=0.516024, µ=3.287

$$\begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 1 & 0 & 0 & 0 & 0 & 1 & 0 & 0 & 0 & 0 & 0 & 0 & 0 & 0 & 0 & 0 & 0 & 0 \\
1 & 0 & 1 & 0 & 1 & 0 & 0 & 0 & 0 & 0 & 0 & 1 & 0 & 0 & 0 & 0 & 0 & 0 & 0 & 0 & 0 & 0 & 0 & 0 & 0 \\
0 & 0 & 0 & 1 & 1 & 0 & 0 & 0 & 0 & 0 & 0 & 1 & 1 & 0 & 0 & 0 & 0 & 0 & 0 & 0 & 0 & 0 & 0 & 0 & 0 \\
1 & 1 & 0 & 0 & 0 & 1 & 1 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 0 & 0 & 0 & 0 & 1 & 0 & 0 & 1 & 1 & 0 & 0 & 0 & 0 & 0 & 0 & 0 & 0 & 0 \\
0 & 0 & 0 & 0 & 0 & 1 & 1 & 1 & 0 & 0 & 0 & 1 & 0 & 1 & 0 & 0 & 1 & 0 & 0 & 0 & 0 & 0 & 0 & 0 & 0 \\
1 & 0 & 0 & 0 & 1 & 1 & 1 & 1 & 0 & 1 & 0 & 0 & 0 & 0 & 0 & 0 & 0 & 0 & 0 & 0 & 0 & 0 & 0 & 0 & 0 \\
1 & 1 & 1 & 0 & 1 & 0 & 0 & 1 & 1 & 0 & 0 & 0 & 0 & 0 & 0 & 0 & 0 & 0 & 0 & 0 & 0 & 0 & 0 & 0 & 0 \\
0 & 1 & 0 & 1 & 0 & 0 & 1 & 1 & 0 & 1 & 0 & 1 & 0 & 0 & 0 & 0 & 1 & 0 & 0 & 0 & 0 & 1 & 0 & 0 & 0 \\
0 & 0 & 1 & 0 & 1 & 1 & 0 & 1 & 1 & 1 & 0 & 0 & 1 & 0 & 1 & 0 & 0 & 0 & 0 & 0 & 0 & 0 & 0 & 0 & 0 \\
1 & 1 & 1 & 1 & 1 & 1 & 0 & 0 & 0 & 1 & 0 & 0 & 0 & 0 & 0 & 0 & 0 & 0 & 0 & 0 & 0 & 0 & 0 & 0 & 0 \\
1 & 1 & 0 & 0 & 1 & 0 & 1 & 0 & 1 & 1 & 0 & 1 & 0 & 1 & 1 & 0 & 0 & 0 & 0 & 1 & 0 & 0 & 0 & 0 & 0 \\
1 & 0 & 1 & 1 & 0 & 1 & 1 & 1 & 1 & 0 & 1 & 0 & 0 & 0 & 0 & 0 & 0 & 1 & 0 & 0 & 0 & 0 & 0 & 0 & 0 \\
1 & 1 & 0 & 1 & 0 & 1 & 0 & 1 & 0 & 1 & 0 & 1 & 0 & 1 & 0 & 1 & 0 & 0 & 0 & 1 & 0 & 1 & 0 & 1 & 0 \\
1 & 1 & 1 & 0 & 0 & 1 & 1 & 0 & 0 & 1 & 1 & 0 & 0 & 1 & 1 & 0 & 0 & 0 & 1 & 0 & 0 & 1 & 1 & 0 & 0 \\
1 & 1 & 1 & 1 & 0 & 0 & 0 & 0 & 1 & 1 & 1 & 1 & 0 & 0 & 0 & 0 & 0 & 1 & 1 & 1 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 & 1 \\
1 & 1 & 1 & 1 & 1 & 1 & 1 & 1 & 1 & 1 & 1 & 1 & 1 & 1 & 1 & 1 & 1 & 1 & 1 & 0 & 0 & 0 & 0 & 0 & 0 & 0
\end{pmatrix}$$

FIG. 28

$K_{25,2}$, E=0.501048, μ=3.561

$$\begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 0 & 1 & 1 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 0 \\
1 & 0 & 1 & 0 & 0 & 0 & 0 & 0 & 1 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 1 & 0 & 0 & 0 & 0 & 0 & 0 & 0 & 0 & 0 & 0 & 0 & 1 & 0 & 0 \\
0 & 1 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 1 & 1 & 1 & 0 & 1 & 0 & 1 & 0 & 0 & 0 & 0 & 1 & 0 & 0 & 0 & 0 & 0 & 0 & 0 & 0 & 0 & 1 \\
0 & 1 & 1 & 0 & 1 & 1 & 0 & 0 & 0 & 0 & 1 & 0 & 1 & 0 & 0 & 0 & 1 & 0 & 0 & 0 & 1 & 0 & 0 & 0 & 0 \\
1 & 1 & 0 & 1 & 1 & 0 & 0 & 0 & 1 & 0 & 0 & 0 & 1 & 0 & 0 & 0 & 1 & 0 & 1 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 1 & 1 & 0 & 0 & 0 & 0 & 0 & 0 & 0 \\
1 & 0 & 1 & 0 & 1 & 0 & 1 & 0 & 1 & 0 & 1 & 0 & 1 & 0 & 1 & 0 & 0 & 0 & 0 & 0 & 0 & 0 & 0 & 0 & 0 \\
0 & 0 & 1 & 1 & 1 & 1 & 0 & 0 & 1 & 1 & 0 & 0 & 1 & 1 & 0 & 0 & 0 & 0 & 0 & 0 & 0 & 0 & 0 & 0 & 0 \\
1 & 1 & 0 & 0 & 1 & 1 & 0 & 0 & 1 & 1 & 1 & 1 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 0 \\
1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 0 \\
1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 0 & 0 \\
1 & 1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 \\
\end{pmatrix}$$

FIG. 29

$$K_{28} = \begin{pmatrix}
1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 1 & 0 & 0 & 0 & 1 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 1 & 0 & 1 & 0 & 0 & 0 & 0 & 0 & 0 & 0 & 0 & 0 & 0 & 0 \\
1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 0 & 1 & 0 & 0 & 0 & 0 & 0 & 0 & 0 & 1 & 0 & 1 & 0 & 0 & 0 & 0 & 0 & 0 & 0 & 0 & 0 \\
1 & 0 & 0 & 0 & 1 & 0 & 0 & 0 & 0 & 1 & 0 & 1 & 0 & 0 & 0 & 0 & 0 & 0 & 1 & 0 & 1 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 & 1 & 0 & 1 & 0 & 1 & 0 & 0 & 0 & 1 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 1 & 1 & 0 & 0 & 0 & 0 & 0 & 0 & 0 & 0 & 0 & 0 & 0 & 0 & 0 \\
0 & 1 & 1 & 0 & 0 & 0 & 0 & 1 & 0 & 1 & 0 & 0 & 0 & 0 & 0 & 1 & 1 & 0 & 0 & 0 & 0 & 0 & 0 & 0 & 0 & 0 & 0 & 0 & 0 \\
1 & 0 & 1 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 1 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 0 & 0 & 0 & 0 & 1 & 1 & 0 & 0 & 0 & 0 & 0 & 1 & 1 & 0 & 0 & 1 & 1 & 0 & 0 & 0 & 0 & 0 & 0 & 0 & 0 \\
1 & 1 & 0 & 0 & 0 & 0 & 0 & 0 & 0 & 1 & 1 & 0 & 1 & 0 & 1 & 0 & 1 & 1 & 0 & 0 & 0 & 1 & 1 & 0 & 1 & 0 & 1 & 0 & 0 \\
1 & 1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 1 & 0 & 0 & 0 & 0 & 0 & 0 & 0 & 0 & 1 & 1 & 1 & 1 & 0 & 0 & 0 & 0 & 0 & 0 & 0 & 0 & 0 & 0 & 0 \\
0 & 1 & 1 & 0 & 0 & 1 & 1 & 0 & 1 & 0 & 1 & 0 & 1 & 0 & 1 & 0 & 1 & 1 & 1 & 1 & 0 & 0 & 0 & 0 & 0 & 0 & 0 & 0 & 0 \\
1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 1 & 1 & 1 & 0 & 0 & 0 & 0 & 0 & 0 & 0 & 1 & 1 & 1 & 0 & 0 & 0 & 0 & 0 & 0 & 0 & 0 \\
1 & 1 & 0 & 0 & 1 & 1 & 0 & 0 & 0 & 0 & 1 & 1 & 1 & 0 & 0 & 0 & 0 & 0 & 0 & 1 & 1 & 1 & 1 & 0 & 0 & 0 & 0 & 0 & 0 \\
1 & 1 & 0 & 0 & 1 & 1 & 0 & 0 & 1 & 1 & 0 & 0 & 1 & 1 & 0 & 0 & 1 & 1 & 1 & 1 & 1 & 1 & 0 & 0 & 1 & 1 & 0 & 0 & 0 \\
1 & 1 & 1 & 1 & 0 & 0 & 0 & 0 & 1 & 1 & 1 & 1 & 0 & 0 & 0 & 0 & 0 & 0 & 0 & 0 & 0 & 0 & 0 & 0 & 0 & 0 & 0 & 0 & 0 \\
1 & 1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 0 & 0 & 0 & 0 & 0 & 1 & 1 & 1 & 1 & 1 & 1 & 1 & 0 & 0 & 0 & 0 & 1 & 1 & 1 & 1 & 1 & 1 & 1 & 1 & & & \\
1 & 1 & 1 & 1 & 1 & 1 & 1 & 1 & 1 & 1 & 1 & 1 & 1 & 1 & 1 & 0 & 0 & 0 & 0 & 0 & 0 & 0 & 0 & 0 & 0 & 0 & 0 & 0 & 0 \\
\end{pmatrix}$$

E(K$_{28}$)=0.501536, μ(K$_{28}$)=3.70221

FIG. 30

FIG. 31

FIG. 32

$\varepsilon_{10} = \varepsilon_{00} + \tau(S_1, 0) = -1$

$\varepsilon_{10}$

$\varepsilon_{00} = 0$

$\varepsilon_{20} = \varepsilon_{10} + \tau(S_2, 0) = -1$

$\varepsilon_{21} = \varepsilon_{10} + \tau(S_2, 1) = -3$

$\varepsilon_{22} = \varepsilon_{11} + \tau(S_2, 0) = 0$

$\varepsilon_{23} = \varepsilon_{11} + \tau(S_2, 1) = -2$

$\varepsilon_{11}$

$\varepsilon_{11} = \varepsilon_{00} + \tau(S_1, 1) = 0$

___1___

___0___

$y^7_0 = (-1, 2, \quad 1, 3, \quad -1, 2, \quad 3, 5)$

| 00 | −1 |
| 01 | −3 |
| 10 | 0 |
| 11 | −2 |

| 00 | 0 |
| 01 | −3 |
| 10 | −1 |
| 11 | −4 |

| 00 | −1 |
| 01 | −3 |
| 10 | 0 |
| 11 | −2 |

| 00 | 0 |
| 01 | −5 |
| 10 | −3 |
| 11 | −8 |

| 0000 | −1 |
| 1100 | −2 |
| 1010 | −1 |
| 1001 | −3 |

| 0000 | −1 |
| 1100 | −2 |
| 1010 | −3 |
| 1001 | −5 |

| 00000000 | −2 |

FIG. 32

$\varepsilon_{10}$

$\varepsilon_{00} = 0$

$\varepsilon_{20}$

$\varepsilon_{21}$

$\varepsilon_{22}$

$\varepsilon_{11}$

$\varepsilon_{23}$

___1___

___0___

$y^7_0 = (-1, 2, \quad 1, 3, \quad -1, 2, \quad 3, 5)$

| 00 | −1 |
| 01 | −3 |
| 10 | 0 |
| 11 | −2 |

| 00 | 0 |
| 01 | −3 |
| 10 | −1 |
| 11 | −4 |

| 00 | −1 |
| 01 | −3 |
| 10 | 0 |
| 11 | −2 |

| 00 | 0 |
| 01 | −5 |
| 10 | −3 |
| 11 | −8 |

0000: −1+0= −1
1100: −2+0= −2
1010: 0−1= −1
0000: 0−3= −3

| 0000 | −1 |
| 1100 | −2 |
| 1010 | −1 |
| 1001 | −3 |

| 0000 | −1 |
| 1100 | −2 |
| 1010 | −3 |
| 1001 | −5 |

| 00000000 | −2 |

FIG. 33

$y^7_0 = (-1,2, \quad 1,3, \quad -1,2, \quad 3,5)$

| 00 | $-1$ |
|----|------|
| 01 | $-3$ |
| 10 | $0$ |
| 11 | $-2$ |

| 00 | $0$ |
|----|------|
| 01 | $-3$ |
| 10 | $-1$ |
| 11 | $-4$ |

| 00 | $-1$ |
|----|------|
| 01 | $-3$ |
| 10 | $0$ |
| 11 | $-2$ |

| 00 | $0$ |
|----|------|
| 01 | $-5$ |
| 10 | $-3$ |
| 11 | $-8$ |

$0000: -1+0= -1$
$1100: -2+0= -2$
$1010: 0-1= -1$
$0000: 0-3= -3$

| 0000 | $-1$ |
|------|------|
| 1100 | $-2$ |
| 1010 | $-1$ |
| 1001 | $-3$ |

| 0000 | $-1$ |
|------|------|
| 1100 | $-2$ |
| 1010 | $-3$ |
| 1001 | $-5$ |

| 00000000 | $-2$ |

FIG. 34

FIG. 35

FIG. 36

FIG. 37

$$K_1 = \begin{pmatrix}
1 & 0 & 0 & 0 & 0 & 0 & 0 & 0 & 0 & 0 & 0 & 0 & 0 & 0 & 0 & 0 \\
1 & 0 & 0 & 0 & 0 & 0 & 0 & 0 & 1 & 0 & 0 & 0 & 0 & 0 & 0 & 0 \\
1 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 1 & 0 & 0 & 0 & 1 & 0 & 0 & 0 \\
1 & 0 & 1 & 0 & 0 & 0 & 0 & 0 & 0 & 0 & 0 & 0 & 0 & 0 & 0 & 0 \\
1 & 1 & 0 & 0 & 0 & 0 & 0 & 0 & 0 & 0 & 0 & 0 & 0 & 0 & 0 & 0 \\
1 & 0 & 1 & 0 & 0 & 0 & 0 & 0 & 1 & 0 & 1 & 0 & 0 & 0 & 0 & 0 \\
0 & 0 & 0 & 0 & 1 & 0 & 1 & 0 & 1 & 0 & 1 & 0 & 0 & 0 & 0 & 0 \\
0 & 1 & 1 & 0 & 1 & 0 & 1 & 0 & 1 & 1 & 0 & 0 & 0 & 0 & 0 & 0 \\
1 & 1 & 0 & 0 & 0 & 1 & 1 & 0 & 1 & 0 & 1 & 0 & 0 & 0 & 0 & 0 \\
1 & 0 & 1 & 0 & 1 & 0 & 1 & 0 & 1 & 0 & 1 & 0 & 1 & 0 & 1 & 0 \\
1 & 1 & 0 & 0 & 1 & 1 & 0 & 0 & 1 & 1 & 0 & 0 & 1 & 1 & 0 & 0 \\
1 & 1 & 1 & 1 & 0 & 0 & 0 & 0 & 0 & 0 & 0 & 0 & 0 & 0 & 0 & 0 \\
1 & 1 & 1 & 1 & 0 & 0 & 0 & 0 & 1 & 1 & 1 & 1 & 0 & 0 & 0 & 0 \\
1 & 1 & 1 & 1 & 1 & 1 & 1 & 1 & 0 & 0 & 0 & 0 & 0 & 0 & 0 & 0 \\
1 & 1 & 1 & 1 & 1 & 1 & 1 & 1 & 1 & 1 & 1 & 1 & 1 & 1 & 1 & 1
\end{pmatrix}$$

FIG. 38

Stage 0

FIG. 39 (1)

FIG. 39 (2)

FIG. 39 (3)

FIG. 39 (4)

FIG. 40

FIG. 41

FIG. 42

FIG. 43

Apparatus 4400

Transceiver unit 4410

Processing unit 4420

FIG. 44

FIG. 45

FIG. 46

## INTERNATIONAL SEARCH REPORT

| International application No. |
| --- |
| **PCT/CN2021/115206** |

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

H04L; H04W

Documentation searched other than minimum documentation to the extent that such documents are included in the fields searched

Electronic data base consulted during the international search (name of data base and, where practicable, search terms used)

CNABS; CNTXT; CNKI; VEN; EPTXT; USTXT; WOTXT; 3GPP: 原始, 目标, 极化码, 调整, 内核, 矩阵, 距离, 深度优先, 搜索, 序列, 编码, 解码, 译码, 复用, 网格, original, target, polar, code, adjustment, kernel, matrix, partial, distance, depth, search, sequence, encoding, decoding, multiplexing, grid

### C. DOCUMENTS CONSIDERED TO BE RELEVANT

| Category* | Citation of document, with indication, where appropriate, of the relevant passages | Relevant to claim No. |
| --- | --- | --- |
| A | WO 2019161770 A1 (HUAWEI TECHNOLOGIES CO., LTD.) 29 August 2019 (2019-08-29) entire document | 1-36 |
| A | US 2018013868 A1 (QUALCOMM INCORPORATED) 11 January 2018 (2018-01-11) entire document | 1-36 |
| A | CN 111034057 A (HUAWEI TECHNOLOGIES CO., LTD.) 17 April 2020 (2020-04-17) entire document | 1-36 |
| A | US 2016241258 A1 (HUAWEI TECHNOLOGIES CO., LTD.) 18 August 2016 (2016-08-18) entire document | 1-36 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **11 November 2021** | **19 November 2021** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2021/115206**

**Box No. III    Observations where unity of invention is lacking (Continuation of item 3 of first sheet)**

This International Searching Authority found multiple inventions in this international application, as follows:

[1]    Claims 1-7, 15-21, 29, 31 and 32 relate to a coding solution, and claims 8-14, 22-28, 30, 33 and 34 relates to a decoding solution. The two groups of claims do not share a same or corresponding technical feature, and thus do not share a same or corresponding special technical feature. Therefore, these inventions are not so linked as to form a single general inventive concept, and therefore do not comply with PCT Rule 13.1.

1. ☐    As all required additional search fees were timely paid by the applicant, this international search report covers all searchable claims.

2. ☑    As all searchable claims could be searched without effort justifying additional fees, this Authority did not invite payment of additional fees.

3. ☐    As only some of the required additional search fees were timely paid by the applicant, this international search report covers only those claims for which fees were paid, specifically claims Nos.:

4. ☐    No required additional search fees were timely paid by the applicant. Consequently, this international search report is restricted to the invention first mentioned in the claims; it is covered by claims Nos.:

**Remark on Protest**    ☐    The additional search fees were accompanied by the applicant's protest and, where applicable, the payment of a protest fee.

☐    The additional search fees were accompanied by the applicant's protest but the applicable protest fee was not paid within the time limit specified in the invitation.

☐    No protest accompanied the payment of additional search fees.

Form PCT/ISA/210 (continuation of first sheet) (January 2015)

**INTERNATIONAL SEARCH REPORT**
Information on patent family members

International application No.

**PCT/CN2021/115206**

| Patent document cited in search report | | | Publication date (day/month/year) | Patent family member(s) | | | Publication date (day/month/year) |
|---|---|---|---|---|---|---|---|
| WO | 2019161770 | A1 | 29 August 2019 | CN | 111801897 | A | 20 October 2020 |
| | | | | US | 2019268094 | A1 | 29 August 2019 |
| US | 2018013868 | A1 | 11 January 2018 | WO | 2018013268 | A1 | 18 January 2018 |
| | | | | US | 10476998 | B2 | 12 November 2019 |
| CN | 111034057 | A | 17 April 2020 | EP | 3656058 | A1 | 27 May 2020 |
| | | | | WO | 2019037841 | A1 | 28 February 2019 |
| | | | | US | 2020195279 | A1 | 18 June 2020 |
| US | 2016241258 | A1 | 18 August 2016 | CN | 105340183 | A | 17 February 2016 |
| | | | | US | 10348331 | B2 | 09 July 2019 |
| | | | | WO | 2015058416 | A1 | 30 April 2015 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2020130551